# EUROPEAN PATENT APPLICATION

(11) **EP 4 614 229 A1**
(43) Date of publication of application: **10.09.2025**
(21) Application number: 23885823.7
(22) Date of filing: 01.11.2023
(51) Int. Cl.: G03F 7/11, C08G 12/00, C08G 14/00, G03F 7/26, G03F 7/42

(54) **RESIST UNDERLAYER FILM-FORMING COMPOSITION**

(30) Priority: 02.11.2022 JP 2022176577; 17.04.2023 JP 2023067397
(71) Applicant: Nissan Chemical Corporation, Tokyo 103-6119 (JP)
(72) Inventor: MITSUTAKE, Yuki, Toyama-shi, Toyama 939-2792 (JP); TOKUNAGA, Hikaru, Toyama-shi, Toyama 939-2792 (JP)
(74) Representative: Hoffmann Eitle
(86) International application number: PCT/JP2023/039458
(87) International publication number: WO 2024/096069

(57) **Abstract**

[Problem] The purpose of the present invention is to provide a resist underlayer film-forming composition in which properties of a resist underlayer film, such as curing properties, heat resistance, etching resistance, planarization properties and embedding properties are further improved.

[Solution] A resist underlayer film-forming composition comprising a novolac resin and a solvent, wherein the novolac resin includes a unit structure A having at least two amino groups, the unit structure A being a divalent group derived from a compound having a fused ring structure, and further includes a monovalent organic group C1 or organic group C2 that caps at least one end of the novolac resin.

## Description

### TECHNICAL FIELD

The present invention relates to a resist underlayer film-forming composition suitable for lithography in semiconductor substrate processing, a resist underlayer film obtained from the resist underlayer film-forming composition, a method of forming a resist pattern using the resist underlayer film-forming composition, and a method of producing a semiconductor device using the composition.

### BACKGROUND ART

In recent years, semiconductor producing processes have rapidly advanced and this has led to a strong demand for higher quality and improved properties of resist underlayer films.

For example, Patent Document 1 reports that a polymer containing, as a structural unit, a divalent group of a specific heteroaromatic ring that contains an indole framework as a part of its structure, and an aryl-substituted divalent group such as an aryl-substituted methylene group can be used as a material that has both a film density and etching resistance. Although planarization properties are mentioned, they are not demonstrated.

In addition, Patent Document 2 reports that a polymer obtained by reacting an indole derivative with a mixture of a plurality of specific aromatic aldehyde compounds can simultaneously ensure solubility (applicability) of the polymer as well as etching resistance and heat resistance of a hard mask layer using the polymer.

In addition, Patent Document 3 reports that it is possible to provide an organic film having high etching resistance and excellent solvent resistance and heat resistance using a hard mask-forming composition containing a resin having a specific diarylaminobenzyl alcohol derivative as a partial structure.

In addition, Patent Document 4 reports that a resist underlayer film-forming composition containing a polymer having a 2-arylindole derivative/analogue structure and an aryl-substituted methylene group as a unit structure allows a favorable resist pattern shape to be formed without causing intermixing between the upper layer of a resist underlayer film and the layer coated thereon.

In addition, Patent Document 5 reports that a resist underlayer film-forming composition containing a compound having a specific bis(polycyclic aryl)fluorene derivative/analogue structure as a structural unit provides a resist underlayer film material having high etching resistance, high heat resistance, and high solubility (applicability).

### Prior Art Documents

### Patent Documents

Patent Document 1: JP 2016-151024 A
Patent Document 2: JP 2020-105513 A
Patent Document 3: JP 2021-81686 A
Patent Document 4: WO2013-146670
Patent Document 5: WO2018-198960

### SUMMARY OF THE INVENTION

### Problem to be Solved by the Invention

However, with rapid advances in semiconductor producing processes, there is a strong demand for higher quality and improved properties of resist underlayer films. Particularly, etching resistance is an important property of an organic film, and heat resistance is also required because vapor deposition is performed on the resist underlayer film in some processes. In addition, in order to improve the quality and properties of the resist underlayer film, for example, various other properties such as curing properties and pattern embedding properties are required, in addition to etching resistance and heat resistance, and considering these properties, there is still room for improvement.

### Means for Solving the Problem

The present invention solves the above problems. Specifically, the present invention includes the following aspects.

A first aspect of the present invention relates to a resist underlayer film-forming composition comprising a novolac resin and a solvent, wherein the novolac resin includes a unit structure A having at least two amino groups, the unit structure A being a divalent group derived from a compound having a fused ring structure, and further includes a monovalent organic group C1 or organic group C2 that caps at least one end of the novolac resin, the organic group C1 is the following Formula (1): 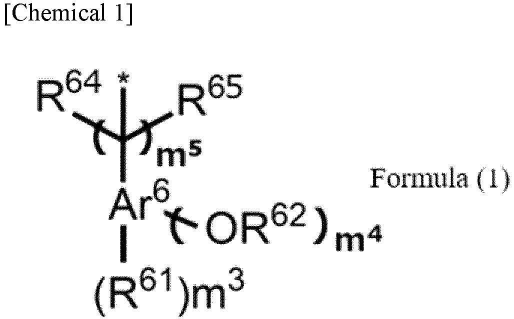 (in Formula (1), * indicates a bond by which the organic group C1 is bonded to at least one end of the novolac resin,
Ar⁶ is a C₆₋₄₀ aryl group, R⁶¹ is a linear, branched, or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they are able to be bonded, Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z, R⁶² is a hydrogen atom, a C₁₋₁₀ alkyl group, a C₂₋₁₀ alkenyl group or a C₂₋₁₀ alkynyl group, R⁶⁴ and R⁶⁵ are each independently a hydrogen atom, a phenyl group substitutable with a hydroxy group, or a naphthyl group substitutable with a hydroxy group, and when R⁶⁴ and R⁶⁵ are a phenyl group or a naphthyl group, R⁶⁴ or R⁶⁵ and the aryl group Ar⁶ are able to form a new ring via a single bond or a methylene group,
m⁴ is 0 or 1, m³ is an integer of 0 to (3+2n) when m⁴ is 0, m³ is an integer of 0 to (2+2n) when m⁴ is 1, n is a condensation degree of the benzene ring of the aryl group Ar⁶ and m⁵ is 0 or 1), and
the organic group C2 is the following Formula (2): 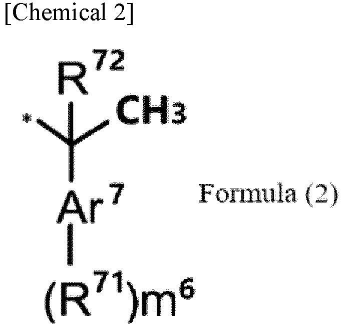 (in Formula (2), * indicates a bond by which the organic group C2 is bonded to at least one end of the novolac resin,
Ar⁷ is a C₆₋₄₀ aryl group, R⁷¹ is a linear, branched, or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they are able to be bonded, Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z, R⁷² is a hydrogen atom, a methyl group, or a phenyl group, m⁶ is an integer of 0 to (3+2n), and n is a condensation degree of an aromatic ring constituting the aryl group Ar⁷).
A second aspect of the present invention relates to the resist underlayer film-forming composition according to the first aspect,
wherein the unit structure A is a unit structure A1 or a unit structure A2, and
the unit structure A1 is the following Formula (3): 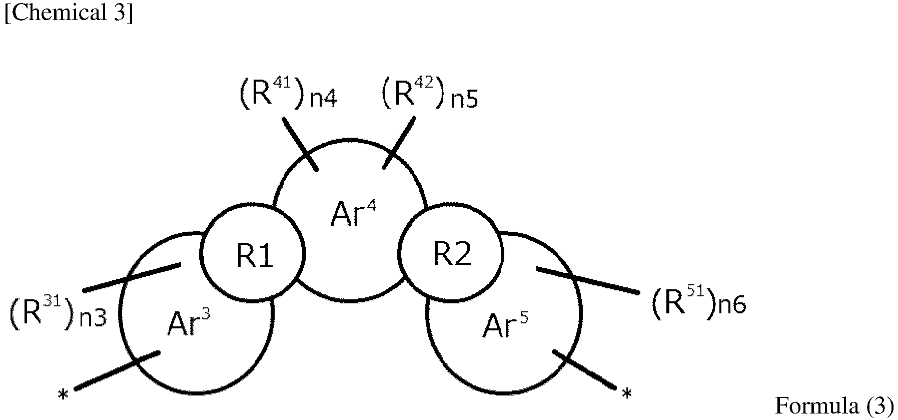 (in Formula (3), * indicates a bond,
Ar⁴ is a benzene ring, Ar³ and Ar⁵ are each independently a benzene ring or a fused ring composed of two or three benzene rings, R1 and R2 are each a 5-membered ring containing one nitrogen atom, Ar³ and R1, R1 and Ar⁴, Ar⁴ and R2, and R2 and Ar⁵ are condensed to each other, and Ar³, R1, Ar⁴, R2 and Ar⁵ form a condensed polycyclic ring together,
R⁴¹ and R⁴² are the same or different substituents on Ar⁴, the substituents can be bonded via a single bond or condensed, R³¹ and R⁵¹ are the same or different substituents on Ar³ and Ar⁵, respectively, R³¹, R⁴¹, R⁴² and R⁵¹ are each a linear, branched, or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they are able to be bonded. Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z. n3 and n6 are the number of substituents for R³¹ and R⁵¹ and are each independently an integer of 0 to 4, n4 and n5 are the number of substituents for R⁴¹ and R⁴², and are each independently an integer of 0 to 2, and n4+n5 is an integer of 0 to 4), and
the unit structure A2 includes a bis(azaaryl fused ring) structural unit of the following Formula (4) or Formula (4-2): 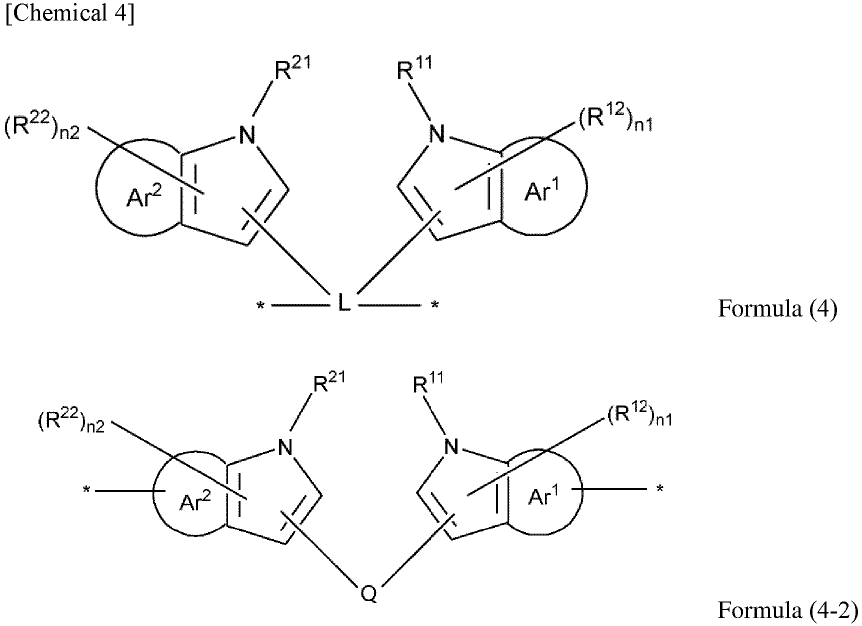 (in Formula (4) and Formula (4-2), * indicates a bond,
L is a linking group which bonds to a carbon atom constituting a nitrogen-containing ring of an azaaryl fused ring and additionally bonds to another structure of the novolac resin, and is selected from the group consisting of -(CR⁴R⁵)m¹-, -R⁶-, -(Ar)m²-, -CH₂-(Ar)m²-CH₂- and -(cyclo-R)-, R⁴ and R⁵ are the same as or different from each other, and are each independently a hydrogen atom, a C₁₋₅ hydrocarbon group, or a C₆₋₃₀ aryl group, m¹ is an integer of 1 to 10, R⁶ is a C₃₋₆ cycloalkylene group, Ar is a C₆₋₃₀ arylene group which is arbitrarily bonded to each other via a single bond, m² is an integer of 1 to 3, cyclo-R is a divalent alicyclic hydrocarbon group having a 5- to 8-membered ring which arbitrarily forms a fused ring with one or two benzene rings or naphthalene rings,
Q is a linking group bonded to a carbon atom constituting a nitrogen-containing ring of an azaaryl fused ring, and is selected from the group consisting of -O-, -S-, -SO₂-, -CO-, -CONH-, -COO-, -NH-, -(CR⁴R⁵)ₘ¹-, -R⁶-, -(Ar)m²-, -CH₂-(Ar)m²-CH₂- and -(cyclo-R)-, R⁴ and R⁵ are the same as or different from each other, and are each independently a hydrogen atom, a C₁₋₅ hydrocarbon group, or a C₆₋₃₀ aryl group, m¹ is an integer of 1 to 10, R⁶ is a C₃₋₆ cycloalkylene group, Ar is a C₆₋₃₀ arylene group which is arbitrarily bonded to each other via a single bond, m² is an integer of 1 to 3, and cyclo-R is a divalent alicyclic hydrocarbon group having a 5- to 8-membered ring which arbitrarily forms a fused ring with one or two benzene rings or naphthalene rings,
R¹¹ and R²¹ are the same as or different from each other, and are each independently,
   (i) a hydrogen atom or a methylol group,
   (ii) a C₆₋₃₀ aryl group, or
   (iii) a linear, branched, or cyclic alkoxymethyl group having a carbon atom number of 2 to 20; a linear, branched, or cyclic alkyl group having a carbon atom number of 1 to 20; a C₂₋₁₀ alkenyl group; or a C₂₋₁₀ alkynyl group,
      R¹² and R²² are substituents on carbon atoms constituting an azaaryl fused ring, are the same as or different from each other, and are each independently,
   (iv) a hydroxy group, a nitro group, a cyano group, a carboxyl group, a trifluoromethyl group, or a halogen atom,
   (v) a C₆₋₁₅ aryloxy group, a C₈₋₁₅ arylalkoxycarbonyl group, a C₇₋₁₅ aryloxycarbonyl group, or a C₆₋₃₀ aryl group, or
   (vi) a C₁₋₁₅ acyl group, a C₁₋₁₅ alkoxy group, a C₇₋₁₅ arylalkoxy group, a C₁₋₁₅ alkoxycarbonyl group, a linear, branched, or cyclic alkyl group having a carbon atom number of 1 to 10, a C₂₋₂₀ alkenyl group, or a C₂₋₁₀ alkynyl group,
n1 and n2 are the same as or different from each other, and are each independently the number of substituents for R¹² and R²², and are arbitrarily 0, and
Ar¹ and Ar² are the same as or different from each other, and are each independently a benzene ring or a fused ring composed of two or three benzene rings).
A third aspect of the present invention relates to the resist underlayer film-forming composition according to the first aspect,
wherein the organic group C1 of Formula (1) is a monovalent group derived from a hydroxy-containing aromatic methylol compound of the following Formula (5): 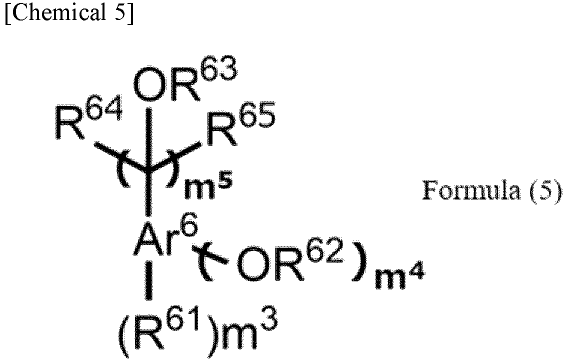 (in Formula (5), Ar⁶, R⁶¹, R⁶², R⁶⁴, R⁶⁵, m³, m⁴ and m⁵ are the same as defined in Formula (1), and R⁶³ is a hydrogen atom or a methyl group).

A fourth aspect of the present invention relates to the resist underlayer film-forming composition according to the first aspect,
wherein the organic group C1 of Formula (1) is a monovalent group derived from 2-hydroxybenzyl alcohol, 3-hydroxybenzyl alcohol, 4-hydroxybenzyl alcohol, or 2,6-di-tert-butyl-4-hydroxymethylphenol.

A fifth aspect of the present invention relates to the resist underlayer film-forming composition according to the first aspect,
wherein the organic group C2 of Formula (2) is a monovalent group derived from an aromatic vinyl compound of the following Formula (6): 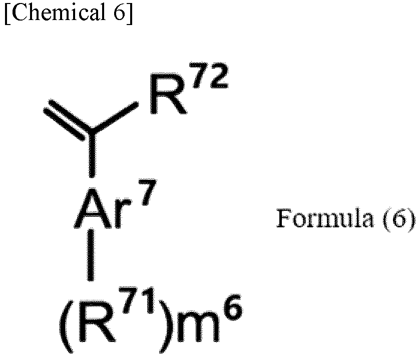 (in Formula (6), Ar⁷, R⁷¹, R⁷² and m⁶ are the same as defined in Formula (2)).

A sixth aspect of the present invention relates to the resist underlayer film-forming composition according to the first aspect,
wherein the organic group C2 of Formula (2) is a monovalent group derived from styrene, 2-vinylnaphthalene, 4-tert-butylstyrene or 4-tert-butoxystyrene.

A seventh aspect of the present invention relates to the resist underlayer film-forming composition according to the second aspect,
wherein the unit structure A1 of Formula (3) is a divalent group derived from a compound having an indolocarbazole structure.

An eighth aspect of the present invention relates to the resist underlayer film-forming composition according to the seventh aspect,
wherein an aromatic group that substitutes a hydrogen atom on the fused ring of the compound having the indolocarbazole structure is a phenyl group.

A ninth aspect of the present invention relates to the resist underlayer film-forming composition according to the second aspect,
wherein all or some of hydrogen atoms of the hydroxy group, amino group or alkylamino group in the novolac resin are substituted with a C₂₋₁₀ alkynyl group.

A tenth aspect of the present invention relates to the resist underlayer film-forming composition according to the second aspect,
wherein the novolac resin further includes another unit structure,
the other unit structure is a divalent group derived from monomers of the following Formula (10-1) to Formula (10-36) and/or a divalent group derived from monomers of the following Formula (10-37) to Formula (10-69), and one end of the unit structure is arbitrarily bonded to a bond of the organic group C1 or the organic group C2: 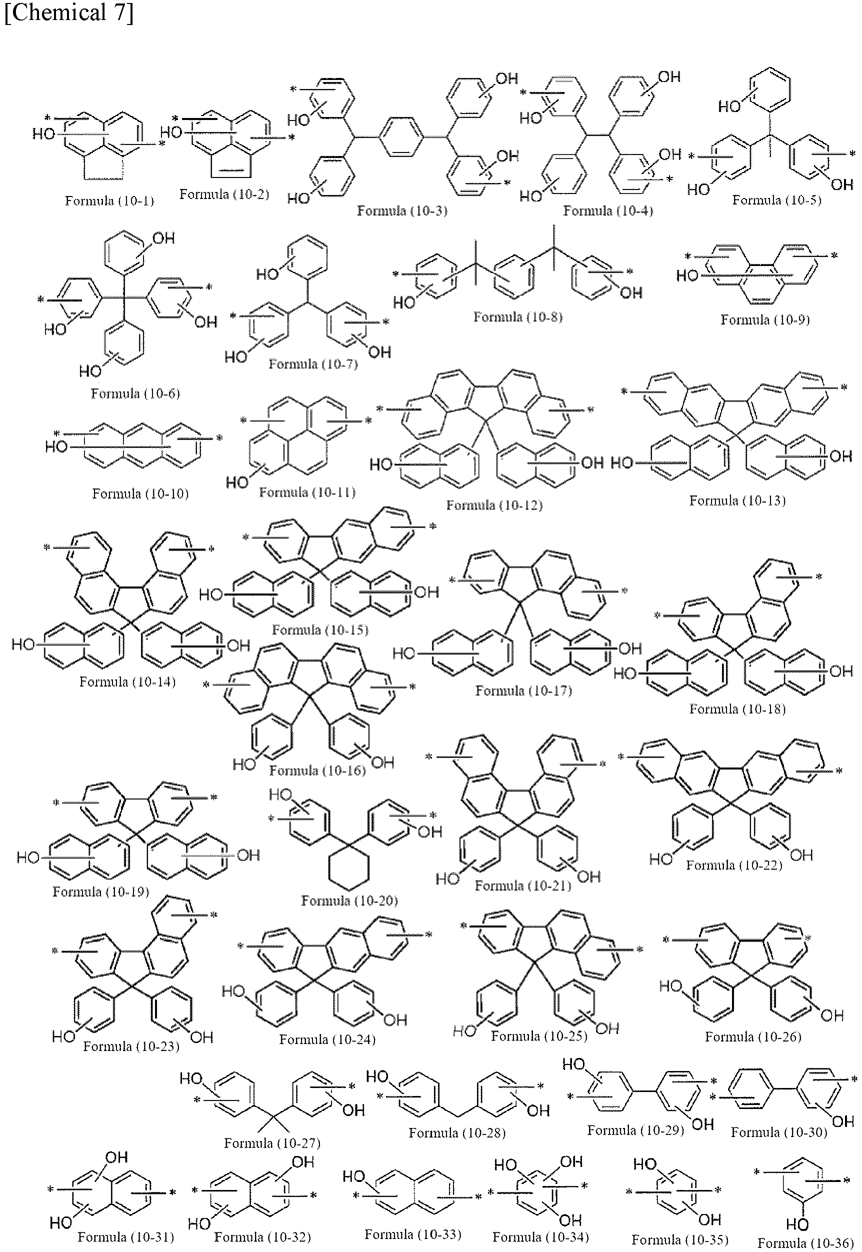 (in Formula (10-1) to Formula (10-36), * indicates a bond, and H of OH is arbitrarily substituted with a phenyl group or a C₂₋₁₀ alkynyl group), 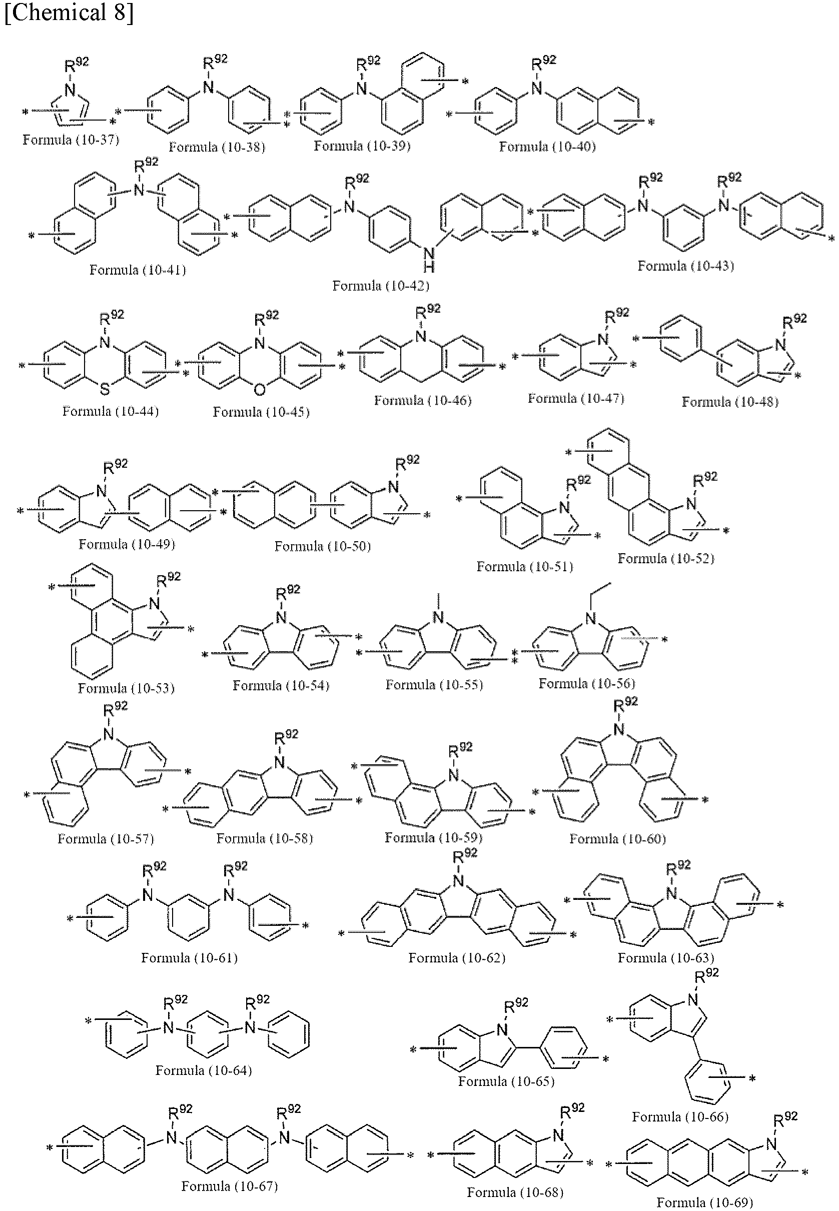 (in Formula (10-37) to Formula (10-69), * indicates a bond, and R⁹² is a hydrogen atom, a phenyl group, or a C₂₋₁₀ alkynyl group).

An eleventh aspect of the present invention relates to the resist underlayer film-forming composition according to the first aspect,
wherein the solvent is a solvent having a boiling point of 160°C or higher.

A twelfth aspect of the present invention relates to the resist underlayer film-forming composition according to the first aspect, further comprising a crosslinking agent.

A thirteenth aspect of the present invention relates to the resist underlayer film-forming composition according to the twelfth aspect,
wherein the crosslinking agent is an aminoplast crosslinking agent or a phenoplast crosslinking agent.

A fourteenth aspect of the present invention relates to the resist underlayer film-forming composition according to the first aspect, further comprising a surfactant.

A fifteenth aspect of the present invention relates to the resist underlayer film-forming composition according to the first aspect, further comprising an acid and/or salts of the acid and/or an acid generator.

A sixteenth aspect of the present invention relates to a resist underlayer film which is a baked product of a coating film formed of the composition according to any one of the first aspect to the fifteenth aspect.

A seventeenth aspect of the present invention relates to a method of forming a resist pattern used in production of semiconductors, the method comprising a step of applying the resist underlayer film-forming composition according to any one of the first aspect to the fifteenth aspect onto a semiconductor substrate and performing baking to form a resist underlayer film.

An eighteenth aspect of the present invention relates to a method of producing a semiconductor device, the method comprising:
a step of forming a resist underlayer film on a semiconductor substrate using the resist underlayer film-forming composition according to any one of the first aspect to the fifteenth aspect;
a step of forming a resist film on the resist underlayer film;
a step of forming a resist pattern on the resist film;
a step of etching the resist underlayer film using the resist pattern; and
a step of processing the semiconductor substrate using the patterned resist underlayer film.

A nineteenth aspect of the present invention relates to the method of producing a semiconductor device according to the eighteenth aspect,
wherein the resist pattern is formed on the resist film by irradiation with light or electron beams and development.

A twentieth aspect of the present invention relates to the method of producing a semiconductor device according to the eighteenth aspect,
wherein the resist film is patterned by a nanoimprinting method or with a self-assembled film.

A twenty-first aspect of the present invention relates to a method of producing a semiconductor device, the method comprising:
a step of forming a resist underlayer film on a semiconductor substrate using the resist underlayer film-forming composition according to any one of the first aspect to the fifteenth aspect;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask; and
a step of processing the semiconductor substrate using the patterned resist underlayer film.

A twenty-second aspect of the present invention relates to the method of producing a semiconductor device according to the twenty-first aspect,
wherein the hard mask is formed by applying a composition containing an inorganic substance or depositing a composition containing an inorganic substance.

A twenty-third aspect of the present invention relates to the method of producing a semiconductor device according to the twenty-first aspect,
wherein the resist pattern is formed on the resist film by irradiation with light or electron beams and development.

A twenty-fourth aspect of the present invention relates to the method of producing a semiconductor device according to the twenty-first aspect,
wherein the resist film is patterned by a nanoimprinting method or with a self-assembled film.

A twenty-fifth aspect of the present invention relates to a method of producing a semiconductor device, the method comprising:
a step of forming a resist underlayer film on a semiconductor substrate using the resist underlayer film-forming composition according to any one of the first aspect to the fifteenth aspect;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask;
a step of removing the hard mask; and
a step of processing the semiconductor substrate using the patterned resist underlayer film.

A twenty-sixth aspect of the present invention relates to the method of producing a semiconductor device according to the twenty-fifth aspect,
wherein the hard mask is formed by applying a composition containing an inorganic substance or depositing a composition containing an inorganic substance.

A twenty-seventh aspect of the present invention relates to the method of producing a semiconductor device according to the twenty-fifth aspect,
wherein the resist pattern is formed on the resist film by irradiation with light or electron beams and development.

A twenty-eighth aspect of the present invention relates to the method of producing a semiconductor device according to the twenty-fifth aspect,
wherein the resist film is patterned by a nanoimprinting method or with a self-assembled film.

A twenty-ninth aspect of the present invention relates to the method of producing a semiconductor device according to the twenty-fifth aspect,
wherein the hard mask is removed by etching or using an alkaline chemical solution.

A thirtieth aspect of the present invention relates to a method of producing a semiconductor device, the method comprising:
a step of forming a resist underlayer film on a semiconductor substrate using the resist underlayer film-forming composition according to any one of the first aspect to the fifteenth aspect;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask;
a step of removing the hard mask;
a step of forming a vapor-deposited film (spacer) on the resist underlayer film after the hard mask is removed;
a step of processing the vapor-deposited film (spacer) by etching;
a step of removing the patterned resist underlayer film such that the patterned vapor-deposited film (spacer) remains; and
a step of processing the semiconductor substrate using the patterned vapor-deposited film (spacer).

A thirty-first aspect of the present invention relates to the method of producing a semiconductor device according to the thirtieth aspect,
wherein the hard mask is formed by applying a composition containing an inorganic substance or depositing a composition containing an inorganic substance.

A thirty-second aspect of the present invention relates to the method of producing a semiconductor device according to the thirtieth aspect,
wherein the resist pattern is formed on the resist film by irradiation with light or electron beams and development.

A thirty-third aspect of the present invention relates to the method of producing a semiconductor device according to the thirtieth aspect,
wherein the resist film is patterned by a nanoimprinting method or with a self-assembled film.

A thirty-fourth aspect of the present invention relates to the method of producing a semiconductor device according to the thirtieth aspect,
wherein the hard mask is removed by etching or using an alkaline chemical solution.

### Effects of the Invention

Since a novolac resin containing a fused-ring amine structure and an end crosslinking group structure in its framework has favorable heat resistance, when it is used in a resist underlayer film-forming composition, the amount of sublimates during high-temperature baking is small, the in-plane film thickness uniformity is very high, and the etching resistance is also high. In addition, even if a crosslinking group is not included, since the polymer itself contains a crosslinking agent, sufficient curing properties can be obtained. In addition, the curing temperature is high, sufficient reflow properties are obtained, and thus embedding properties are also favorable.

### MODES FOR CARRYING OUT THE INVENTION

A resist underlayer film-forming composition of the present invention is a resist underlayer film-forming composition characterized by containing a novolac resin having a divalent group unit structure having at least two amino groups and a monovalent organic group C1 or organic group C2 that caps ends, and a solvent. In addition, the composition can arbitrarily contain a crosslinking agent, an acid generator or a surfactant.

Hereinafter, respective components will be described in detail.

### <Definitions of terms>

In this specification, the definitions of main terms related to a novolac resin according to one aspect of the present invention will be described below. Unless otherwise specified, the following term definitions apply to novolac resins.

### "Novolac resin"

The term "novolac resin" is used in a broad sense to include not only phenolformaldehyde resins (a so-called novolac type phenolic resin) and aniline-formaldehyde resins (a so-called novolac type aniline resin) in a narrow sense but also a wide range of polymerized polymers formed by formation of covalent bonds (a substitution reaction, an addition reaction, a condensation reaction or an addition-condensation reaction, etc.) between organic compounds having functional groups [for example, aldehyde groups, ketone groups, acetal groups, ketal groups, hydroxy groups or alkoxy groups bonded to secondary or tertiary carbon atoms, and hydroxy groups, alkoxy groups or halogen atoms bonded to the α-position carbon atom (benzylic-position carbon atom, etc.) of alkylaryl groups; and carbon-carbon unsaturated bonds such as those in divinylbenzene and dicyclopentadiene] that can form covalent bonds with aromatic rings and aromatic rings in compounds having aromatic rings (preferably having heteroatom-containing substituents such as oxygen atoms, nitrogen atoms, and sulfur atoms in the aromatic rings) generally in the presence of an acid catalyst or under reaction conditions equivalent thereto.

Therefore, the novolac resin herein is a polymer formed by linking compounds having a plurality of aromatic rings when an organic compound containing a carbon atom (which may be referred to as a "linking carbon atom") derived from the above functional group forms a covalent bond with an aromatic ring in a compound having an aromatic ring via a linking carbon atom.

In this specification, the terms "unit structure A," "unit structure A' " and "unit structure B" described below are used to indicate the unit structures constituting the "novolac resin." The unit structure A is a unit structure A1 or unit structure A2 described below. The unit structure A' may be another divalent group having an aromatic ring described below other than the unit structure A1 or the unit structure A2. The unit structure B is a unit structure derived from a compound having a functional group that can form a covalent bond with an aromatic ring of the unit structure A or the unit structure A'.

The unit structure D is a one unit structure having an equivalent bonding mode with a composite unit structure A-B (or a composite unit structure A'-B) described below, and is a unit structure derived from a compound having an aromatic ring and a functional group that can form a covalent bond with the aromatic ring of the unit structure A or the unit structure A'. Since the bonding mode is the same, the unit structure D can be substituted with the composite unit structure A-B (or the composite unit structure A'-B).

Here, in this specification, there is a C moiety that caps at least one end of the novolac resin. The C moiety is a monovalent organic group C1 or organic group C2.

### "Residue"

The term "residue" refers to an organic group in which a hydrogen atom bonded to a carbon atom or a heteroatom (a nitrogen atom, an oxygen atom, a sulfur atom, etc.) is substituted with a bond, and may be a monovalent group or a polyvalent group. For example, the residue is a monovalent organic group if one hydrogen atom is substituted with one bond and is a divalent organic group if two hydrogen atoms are substituted with two bonds.

### "Aromatic ring" (aromatic group, aryl group, and arylene group)

The term "aromatic ring" refers to a concept that includes aromatic hydrocarbon rings, aromatic heterocyclic rings, and residues thereof [which may also be called "aromatic groups" and "aryl groups" (in the case of monovalent groups) or "arylene groups" (in the case of divalent groups)], and includes not only monocyclic rings (aromatic monocyclic rings) but also polycyclic rings (aromatic polycyclic rings). In the case of polycyclic rings, at least one monocyclic ring is an aromatic monocyclic ring, but the remaining monocyclic rings that form a fused ring with the aromatic monocyclic ring may be a monocyclic heterocyclic ring (heteromonocyclic ring) or a monocyclic alicyclic hydrocarbon (alicyclic monocyclic ring).

Examples of aromatic rings include aromatic hydrocarbon rings such as benzene, indene, naphthalene, azulene, styrene, toluene, xylene, mesitylene, cumene, anthracene, phenanthrene, triphenylene, benzoanthracene, pyrene, chrysene, fluorene, biphenyl, corannulene, perylene, fluoranthene, benzo[k]fluoranthene, benzo[b]fluoranthene, benzo[ghi]perylene, coronene, dibenzo[g,p]chrysene, acenaphthylene, acenaphthene, naphthacene, pentacene, and cyclooctatetraene, and more typically aromatic hydrocarbon rings such as benzene, naphthalene, anthracene, phenanthrene, and pyrene; and aromatic heterocyclic rings such as furan, thiophene, pyrrole, N-alkylpyrrole, N-arylpyrrole, imidazole, pyridine, pyrimidine, pyrazine, triazine, thiazole, indole, phenylindole, purine, quinoline, isoquinoline, chromene, thianthrene, phenothiazine, phenoxazine, xanthene, acridine, phenazine, carbazole, and indolocarbazole, typically, indole, phenylindole, carbazole, indolocarbazole, furan, thiophene, pyrrole, imidazole, pyran, pyridine, pyrimidine, pyrazine, pyrrolidine, piperidine, piperazine, morpholine, and phenothiazine, and more typically indole, phenylindole, carbazole, indolocarbazole, furan, thiophene, pyrrole, and phenothiazine, but the present invention is not limited thereto.

The aromatic ring (for example, a benzene ring, a naphthalene ring, etc.) may have an optional substituent, and examples of such substituents include substituents such as a halogen atom, a saturated or unsaturated linear, branched or cyclic hydrocarbon group (-R) (the hydrocarbon chain may have one or more intervening oxygen atoms, including an alkyl group, an alkenyl group, an alkynyl group, a propargyl group and the like), an alkoxy group or an aryloxy group (-OR, here, R is the hydrocarbon group -R), an alkylamino group [-NHR or -NR₂ (two R's may be the same as or different from each other), here, R is the hydrocarbon group -R], a hydroxy group, an amino group (-NH₂), a carboxyl group, a cyano group, a nitro group, an ester group (-CO₂R or -OCOR, here, R is the hydrocarbon group -R), an amide group [-NHCOR, -CONHR, -NRCOR (two R's may be the same as or different from each other) or -CONR₂ (two R's may be the same as or different from each other), here, R is the hydrocarbon group -R], a sulfonyl group (-SO₂R, here, R is the hydrocarbon group -R), a sulfonic acid group (-SO₃H), a sulfide group (-SR, here, R is the hydrocarbon group -R), a thiol group (-SH), an organic group containing an ether bond [a residue of an ether compound of R¹¹-O-R¹¹ (R¹¹'s are each independently a C₁₋₆ alkyl group such as a methyl group or an ethyl group, a phenyl group, a naphthyl group, an anthranil group, or a pyrenyl group); for example, an organic group containing an ether bond such as a methoxy group, an ethoxy group, or a phenoxy group], and an aryl group.

In addition, organic groups having a fused ring of one or more aromatic rings (benzene, naphthalene, anthracene, pyrene, etc.) and one or more aliphatic rings or a heterocyclic ring are also included. In addition, examples of aliphatic rings herein include cyclobutane, cyclobutene, cyclopentane, cyclopentene, cyclohexane, cyclohexene, methylcyclohexane, methylcyclohexene, cycloheptane, and cycloheptene, and examples of heterocyclic rings include furan, thiophene, pyrrole, imidazole, pyran, pyridine, pyrimidine, pyrazine, pyrrolidine, piperidine, piperazine, and morpholine.

An organic group having a structure in which two or more aromatic rings are linked by a divalent linking group such as an alkylene group may be used.

### "Heterocyclic ring"

The term "heterocyclic ring" refers to a concept including both aliphatic heterocyclic rings and aromatic heterocyclic rings, and including not only monocyclic rings (heteromonocyclic rings) but also polycyclic rings (heteropolycyclic rings). In the case of polycyclic rings, at least one monocyclic ring may be a heteromonocyclic ring, and the remaining monocyclic rings may be aromatic hydrocarbon monocyclic rings or alicyclic monocyclic rings. As the aromatic heterocyclic ring, examples of the above "aromatic ring" can be referred to. Like the aromatic rings of the "aromatic ring," it may have a substituent.

### "Non-aromatic ring" (aliphatic ring)

The term "non-aromatic monocyclic ring" refers to a monocyclic hydrocarbon that does not belong to the aromatic group, and is typically a monocyclic ring of an alicyclic compound. It may also be called an aliphatic monocyclic ring (which may include an aliphatic heteromonocyclic ring or may contain an unsaturated bond as long as it does not belong to an aromatic compound). Like the aromatic rings of the "aromatic ring," it may have a substituent.

Examples of non-aromatic monocyclic rings (aliphatic rings, and aliphatic monocyclic rings) include cyclopropane, cyclobutane, cyclobutene, cyclopentane, cyclopentene, cyclohexane, methylcyclohexane, cyclohexene, methylcyclohexene, cycloheptane, and cycloheptene.

The term "non-aromatic polycyclic ring" refers to a polycyclic hydrocarbon that does not belong to the aromatic group, and is typically a polycyclic ring of an alicyclic compound. It may also be called an aliphatic polycyclic ring [which may include an aliphatic heteropolycyclic ring (at least one of the monocyclic rings constituting the polycyclic ring is an aliphatic heterocyclic ring) or may contain an unsaturated bond as long as it does not belong to an aromatic compound]. It includes non-aromatic bicyclic rings, non-aromatic tricyclic rings, and non-aromatic tetracyclic rings.

The term "non-aromatic bicyclic ring" refers to a fused ring composed of two monocyclic hydrocarbons that do not belong to the aromatic group, and is typically a fused ring of two alicyclic compounds. In this specification, it may also be called an aliphatic bicyclic ring (which may include an aliphatic heterobicyclic ring or may contain an unsaturated bond as long as it does not belong to an aromatic compound). Examples of non-aromatic bicyclic rings include bicyclopentane, bicyclooctane, and bicycloheptene.

The term "non-aromatic tricyclic ring" refers to a fused ring composed of three monocyclic hydrocarbons that do not belong to the aromatic group, and is typically a fused ring of three alicyclic compounds (each of which may be heterocyclic rings or may contain an unsaturated bond as long as it does not belong to an aromatic compound). Examples of non-aromatic tricyclic rings include tricyclooctane, tricyclononane, and tricyclodecane.

The term "non-aromatic tetracyclic ring" refers to a fused ring composed of four monocyclic hydrocarbons that do not belong to the aromatic group, and is typically a fused ring of four alicyclic compounds (each of which may be a heterocyclic ring or may contain an unsaturated bond as long as it does not belong to an aromatic compound). Examples of non-aromatic tetracyclic rings include hexadecahydropyrene.

The term "carbon atoms constituting a ring (moiety)" refers to carbon atoms constituting a ring, which is an unsubstituted hydrocarbon ring (which may be an aromatic ring, an aliphatic ring, or a heterocyclic ring).

The term "azaaryl fused ring" generally refers to a fused ring of an azaaryl group (nitrogen-containing aromatic heterocyclic ring) with another aromatic ring. In the present invention, particularly, a nitrogen-containing aromatic heterocyclic ring as an azaaryl group is a pyrrole ring.

In addition, the term "bis(azaaryl fused ring) compound" refers to a compound including a structural unit having two azaaryl fused rings, and in the present invention, it particularly refers to a novolac resin including unit structures of Formula (4) and Formula (4-2) described below.

The term "hydrocarbon group" refers to a group formed by removing one or two or more hydrogen atoms from a hydrocarbon, and such hydrocarbons include saturated or unsaturated aliphatic hydrocarbons, saturated or unsaturated alicyclic hydrocarbons, and aromatic hydrocarbons.

In the chemical structural formula showing the unit structure of the novolac resin in this specification, bonds (indicated by *) may be shown for convenience, but unless otherwise specified, such bonds can take any bond position in the unit structure at which bonding is possible, and do not limit the bond position in the unit structure at all.

### <Resist underlayer film-forming composition>

The resist underlayer film-forming composition according to one aspect of the present invention contains a specific novolac resin and a solvent. In addition, the composition may contain a crosslinking agent and an acid, and may contain, as necessary, additives such as an acid generator and a surfactant.

### <Novolac resin>

The specific novolac resin contained in the resist underlayer film-forming composition according to one aspect of the present invention includes a unit structure A having at least two amino groups, and the unit structure A is a divalent group derived from a compound having a fused ring structure.

The resist underlayer film-forming composition of the present invention contains a novolac resin in which the unit structure A is a unit structure A1 or a unit structure A2. In addition, as long as the effects of the present invention are not impaired, the resist underlayer film-forming composition of the present invention may contain a novolac resin in which the unit structure A is another divalent group having an aromatic ring other than the unit structure A1 or the unit structure A2.

### <Unit structure A1>

The unit structure A1 is the following Formula (3).

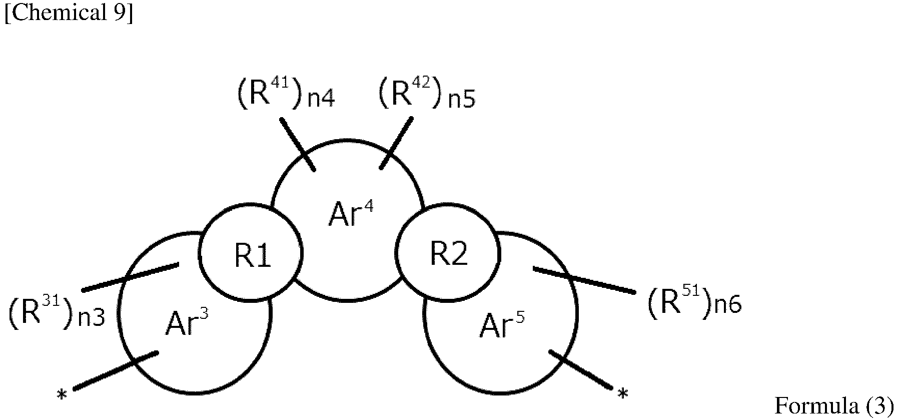

In Formula (3), Ar⁴ is a benzene ring, Ar³ and Ar⁵ are each independently a benzene ring or a fused ring composed of two or three benzene rings, R1 and R2 are each a 5-membered ring containing one nitrogen atom, Ar³ and R1, R1 and Ar⁴, Ar⁴ and R2, and R2 and Ar⁵ are condensed to each other, and Ar³, R1, Ar⁴, R2 and Ar⁵ form a condensed polycyclic ring together,

R⁴¹ and R⁴² are the same or different substituents on Ar⁴, the substituents can be bonded via a single bond or condensed, R³¹ and R⁵¹ are the same or different substituents on Ar³ and Ar⁵, respectively, R³¹, R⁴¹, R⁴² and R⁵¹ are each a linear, branched, or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they can be bonded. Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z. n3 and n6 are the number of substituents for R³¹ and R⁵¹ and are each independently an integer of 0 to 4, n4 and n5 are the number of substituents for R⁴¹ and R⁴², and are each independently an integer of 0 to 2, and n4+n5 is an integer of 0 to 4.

Unless otherwise specified, hereinafter, in this specification, * or ** indicates a bond.

The unit structure A1 is a divalent group having at least two secondary amino groups, and the group is preferably a divalent group derived from a compound having a fused ring structure and an aromatic group that substitutes a hydrogen atom on the fused ring.

In addition, when Ar³, Ar⁴ and Ar⁵ are each a benzene ring, and R1 and R2 are each a 5-membered ring hydrocarbon containing one nitrogen atom, the unit structure A1 of Formula (3) can be a divalent group derived from a compound having an indolocarbazole structure.

In addition, the group R³¹, R⁴¹, R⁴² or R⁵¹ that substitutes a hydrogen atom on the fused ring includes, for example, a phenyl group, a naphthyl group, an anthryl group, and a pyrene group, and a phenyl group can be preferably used.

Examples of compounds having the unit structure A1 are shown below.

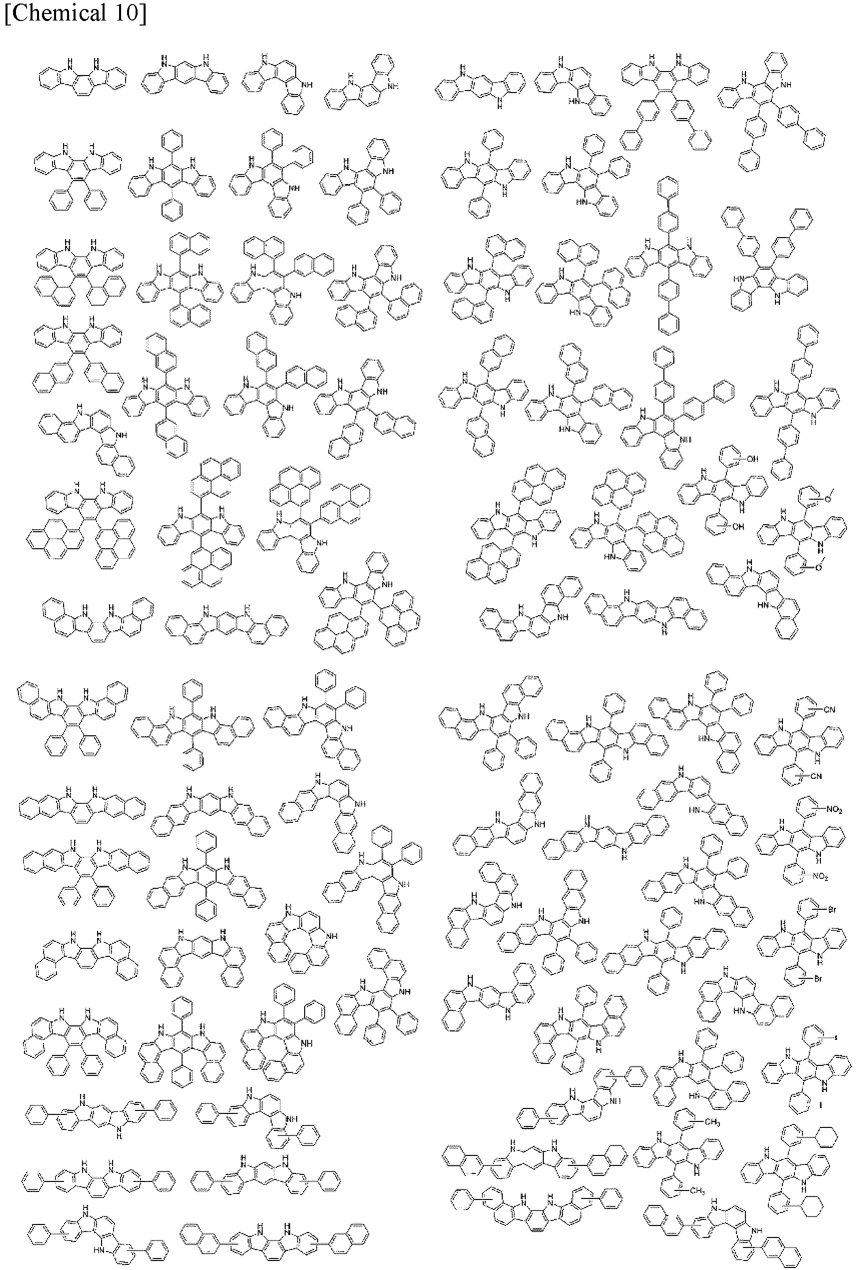

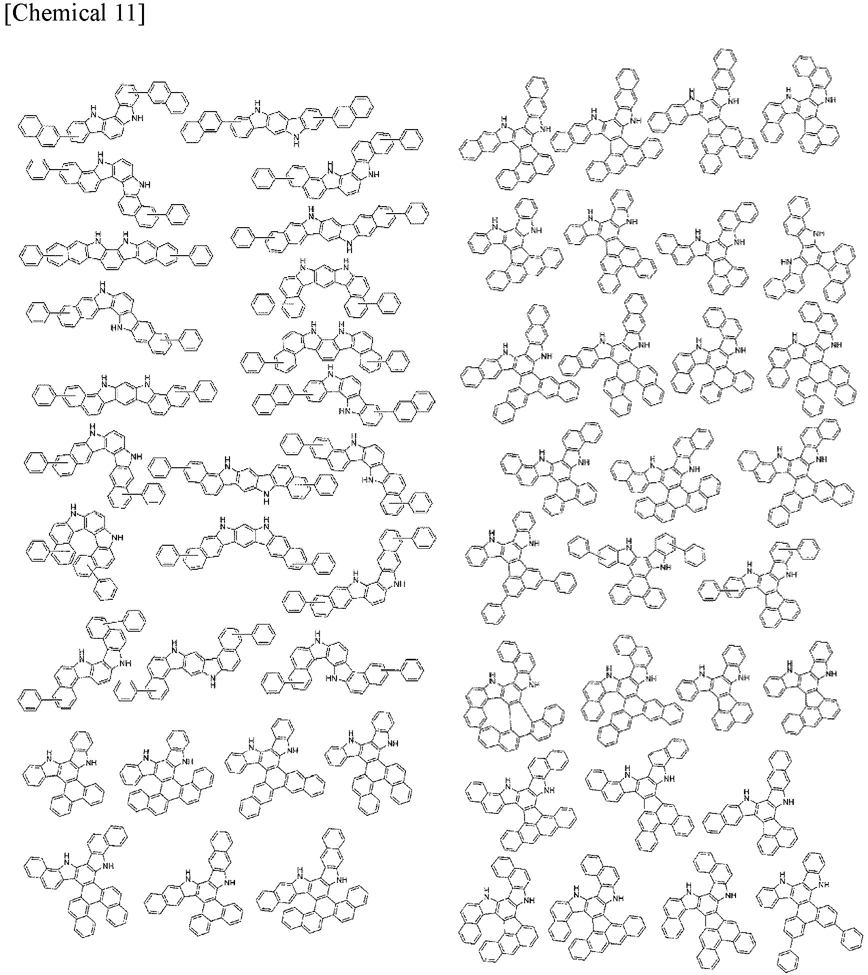

### <Unit structure A2>

The unit structure A2 includes one or more bis(azaaryl fused ring) structural units of the following Formula (4) or Formula (4-2), that is, structural units in which two azaaryl fused rings, preferably two indole rings (which may have a substituent, for example, 2-phenylindole) are bonded via a linking group.

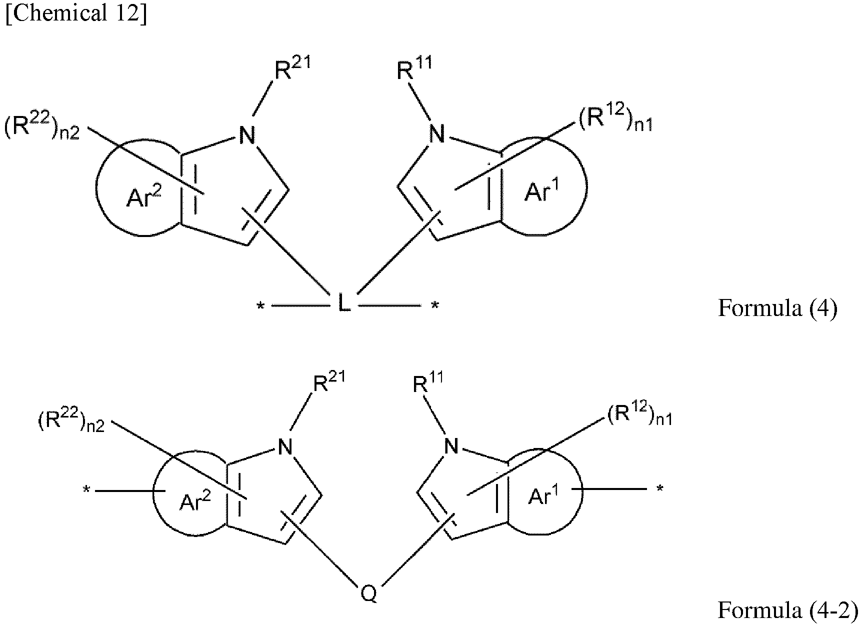

Here, in Formula (4), the bond indicated by * extends from the linking group L. In Formula (4-2), * indicates a bond, and extends from Ar¹ and Ar².

In Formula (4), L is a divalent linking group, excluding a single bond, which is bonded to any of carbon atoms constituting each azaaryl fused ring, and additionally bonded to another structure of the novolac resin. Here, in Formula (4-2), Q is a divalent linking group, excluding a single bond, which is bonded to any of carbon atoms constituting each azaaryl fused ring. The linking group may be bonded to aromatic carbon atoms constituting the following moiety in Ar¹ and Ar², that is, an azaaryl fused ring, in Formula (4) and Formula (4-2), 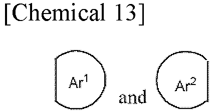 , but it is preferably bonded to a carbon atom constituting a pyrrole ring moiety in the azaaryl fused ring.

A preferable linking group L is selected from the group consisting of - (CR⁴R⁵)m¹-, -R⁶-, -(Ar)m²-, -CH₂-(Ar)m²-CH₂-, and -(cyclo-R)-.

A preferable linking group Q is selected from the group consisting of -O-, -S-, -SO₂-, -CO-, -CONH-, -COO-, -NH-, -(CR⁴R⁵)ₘ¹-, -R⁶-, -(Ar)m²-, -CH₂-(Ar)m²-CH₂-, and - (cyclo-R)-.

R⁴ and R⁵ are the same as or different from each other, and are each independently a hydrogen atom; a C₁₋₅ hydrocarbon group; or a C₆₋₃₀ aryl group; and m¹ is an integer of 1 to 10.

R⁶ is a C₃₋₆ cycloalkylene group,
Ar is a C₆₋₃₀ arylene group which may be bonded to each other via a single bond; and m² is an integer of 1 to 3. Examples of such Ar include divalent benzene rings, naphthalene rings, anthracene rings, pyrene rings, biphenyl rings, and terphenyl rings.

cyclo-R is a divalent alicyclic hydrocarbon group having a 5- to 8-membered ring, and preferably a 6- to 8-membered ring, which may form a fused ring with one or two benzene rings or naphthalene rings. In addition, the two bonds of cyclo-R are bonds extending from carbon atoms (preferably the same carbon atom, excluding carbon atoms belonging to an arbitrarily contained condensation benzene ring or condensation naphthalene ring) constituting the ring of the alicyclic hydrocarbon group. The alicyclic hydrocarbon group may be a divalent monocyclic hydrocarbon group derived from cyclohexane, cyclopentane or the like, or may be a divalent polycyclic hydrocarbon group derived from dicyclopentadiene or the like. In addition, examples of alicyclic hydrocarbon groups that form a fused ring with a benzene ring or a naphthalene ring include divalent hydrocarbon groups derived from tetralin, 9,10-dihydroanthracene, 9,10-dihydrophenanthrene, indane, fluorene, benzocyclobutene, benzofluorene, dibenzofluorene, and acenaphthene. However, when the alicyclic hydrocarbon group is a 5-membered ring, that is, a divalent hydrocarbon group derived from cyclopentane, the number of benzene rings or naphthalene rings to form a fused ring is preferably 0 to 2.

In one aspect of the present invention, when L in Formula (4) or Q in Formula (4-2) is a fluorene ring, at least some of R¹¹ and R²¹ are preferably an alkynyl group described below.

Ar¹ and Ar² are the same as or different from each other, and are each independently a benzene ring or a fused ring composed of two or three benzene rings, and form a fused ring (azaaryl fused ring) with a pyrrole ring moiety in Formula (4) or Formula (4-2). Examples of fused rings composed of two or three benzene rings include naphthalene rings, anthracene rings, and phenanthrene rings. In addition, examples of substituted rings include biphenyl (benzene ring substituted with a phenyl group) and terphenyl (benzene ring substituted with a biphenyl group).

Ar¹ and Ar² are preferably a benzene ring.

R¹¹ and R²¹ are substituents on the nitrogen atom of the azaaryl fused ring, that is, substituents on the nitrogen atom of the pyrrole ring moiety.

Here, R¹¹ and R²¹ are the same as or different from each other, and are each independently,
(i) a hydrogen atom or a methylol group,
(ii) a C₆₋₃₀ aryl group, or
(iii) a linear, branched or cyclic alkoxymethyl group having a carbon atom number of 2 to 20 (a methoxymethyl group, etc.); a linear, branched or cyclic alkyl group having a carbon atom number of 1 to 20; a C₂₋₁₀ alkenyl group; or a C₂₋₁₀ alkynyl group, provided that the above (ii) and (iii) may be additionally substituted with an oxygen atom-containing substituent (a hydroxy group, an alkoxy group, an aryloxy group, a carboxyl group, a carbonyl group, etc.), a sulfur atom-containing substituent (a sulfonic acid group, a sulfide-containing group, a sulfonyl-containing group, etc.), a nitrogen atom-containing substituent (an amino group, a substituted amino group (a mono- or di-substituted amino group such as monoalkylamine or dialkylamine), an amide group, a nitro group, a cyano group, etc.), an aryl group (preferably a C₆₋₁₅ aryl group, for example, a phenyl group, etc.) or a halogen atom, but in the above (iii), the hydrocarbon chain moiety may have an additional intervening oxygen atom-containing substituent (-O-, -C(O)-, -C(O)O-, -OC(O)-, etc.), sulfur atom-containing substituent (-S-, etc.), nitrogen atom-containing substituent (-N(R)C(O)-, -C(O)N(R)-, -OC(O)N(R)-, -N(R)C(O)O-, -N(R)C(O)N(R)-, -NR-, etc.), or arylene group (a phenylene group, etc.). Here, among the substituents used for intervening, R's are the same as or different from each other, and are each independently C₁₋₃₀ hydrocarbon group.

In addition, at least some of R¹¹ and R²¹ are substitutable with a C₂₋₁₀ alkynyl group.

R¹² and R²² are the same as or different from each other, and are each independently optional substituents on carbon atoms constituting an azaaryl fused ring, and may be a carbon atom constituting a pyrrole ring moiety or a carbon atom constituting an aromatic ring moiety of Ar¹ and Ar² forming a fused ring with a pyrrole ring moiety.

Here, R¹² and R²² are the same as or different from each other, and are each independently,
(iv) a hydroxy group, a nitro group, a cyano group, a carboxyl group, a trifluoromethyl group, or a halogen atom,
(v) a C₆₋₁₅ aryloxy group, a C₈₋₁₅ arylalkoxycarbonyl group, a C₇₋₁₅ aryloxycarbonyl group, or a C₆₋₃₀ aryl group, or
(vi) a C₁₋₁₅ acyl group, a C₁₋₁₅ alkoxy group, a C₇₋₁₅ arylalkoxy group, a C₁₋₁₅ alkoxycarbonyl group, a linear, branched or cyclic alkyl group having a carbon atom number of 1 to 10, a C₂₋₂₀ alkenyl group, or a C₂₋₁₀ alkynyl group.

However, the above (v) and (vi) may be additionally substituted with an oxygen atom-containing substituent, a sulfur atom-containing substituent, a nitrogen atom-containing substituent, an aryl group or a halogen atom as in the above (ii) and (iii); and in the above (vi), the hydrocarbon chain moiety may have an additional intervening oxygen atom-containing substituent, sulfur atom-containing substituent, nitrogen atom-containing substituent, or arylene group (a phenylene group, etc.) as in the above (iii).

In addition, n1 and n2 are the same as or different from each other, and are each independently the numbers of substituents for R¹² and R²², and may be 0.

Some representative examples of bis(azaaryl fused ring) structural units are listed below.

Here, the bonds from the structural units are omitted. In addition, representative examples in which a hydrogen atom is bonded to a nitrogen atom on an azaaryl fused ring (indole ring) are shown, but at least some of these may be substituted with the substituents defined by R¹¹ and R²¹ defined in Formula (4) or Formula (4-2). In addition, the substituents defined by R¹² and R²² defined in Formula (4) or Formula (4-2) may be arbitrarily included.

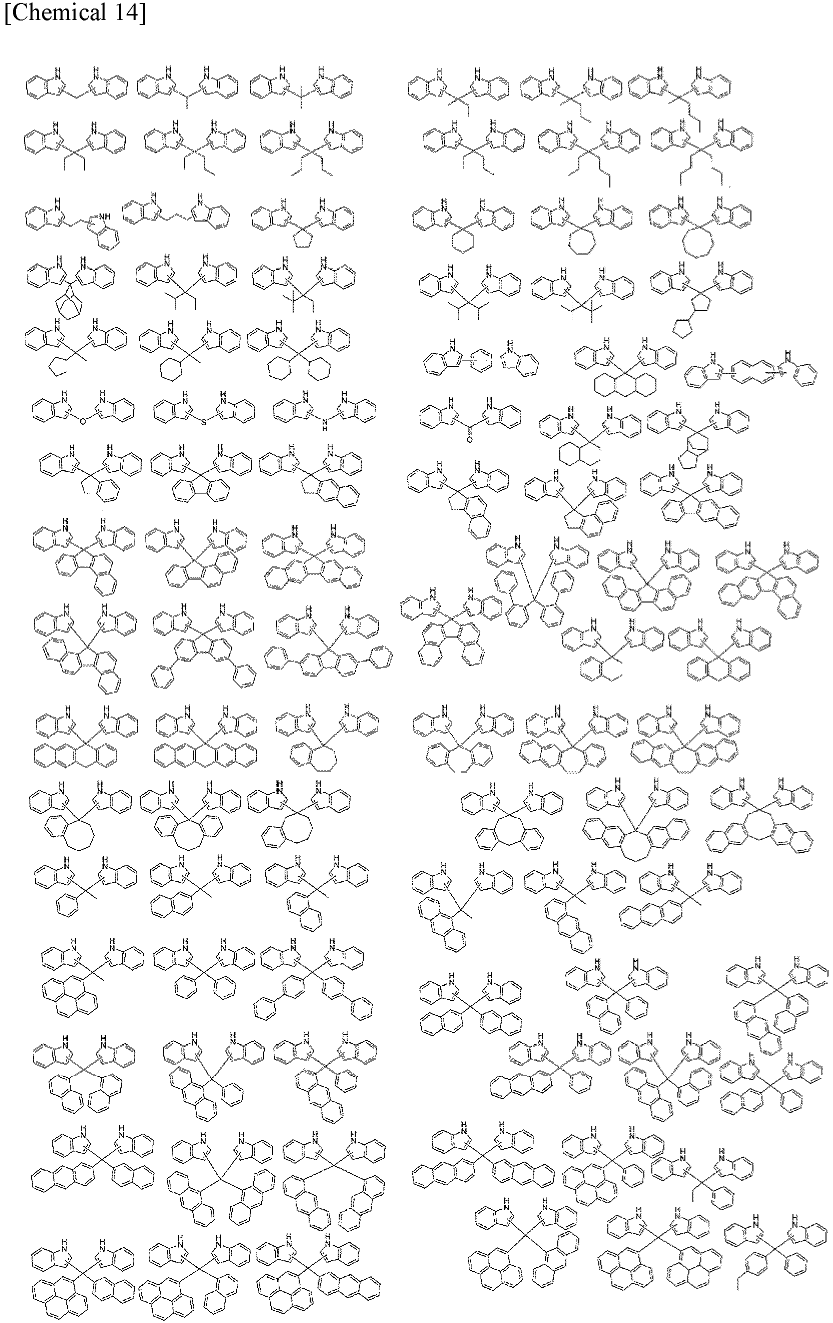

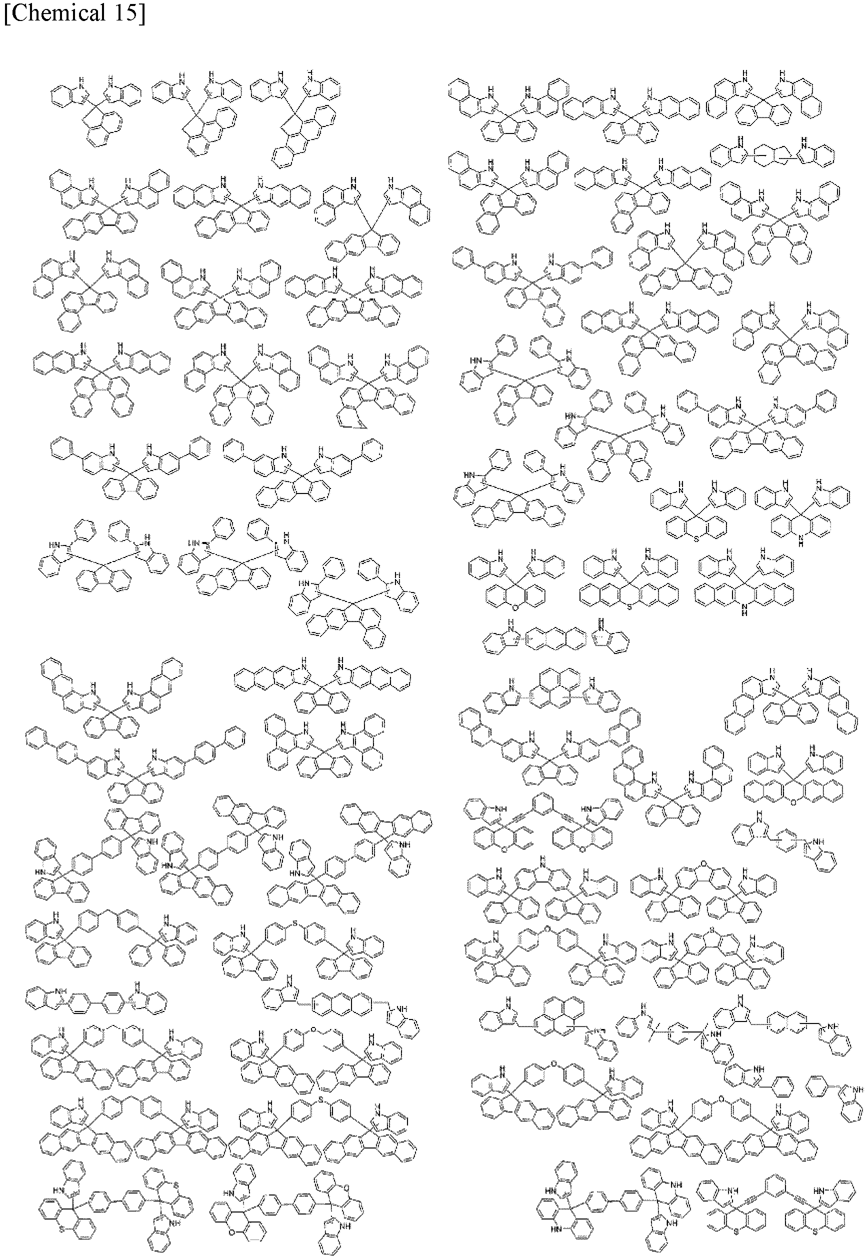

In addition, H of NH of the amine framework may be substituted with the following substituents.

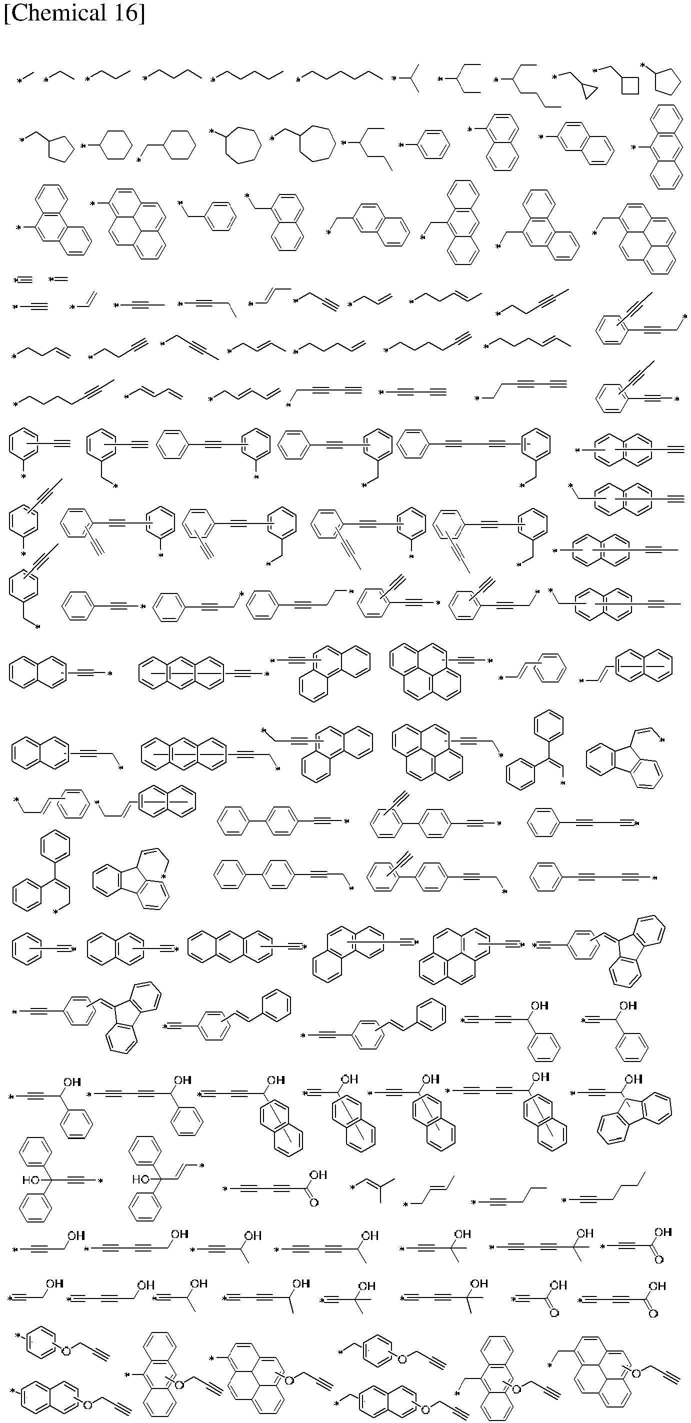

### <Other unit structures>

As described above, as long as the effects of the present invention are not impaired, the novolac resin of the present invention may further include another unit structure in addition to the above unit structures. For example, the novolac resin includes a unit structure A' that is another divalent group having an aromatic ring other than the unit structure A1 or the unit structure A2. One end of the unit structure may be bonded to the bond of the organic group C1 or the organic group C2.

Preferably, such an aromatic ring has a carbon atom number of 6 to 30, and more preferably a carbon atom number of 6 to 24.

Such an aromatic ring is preferably one or more benzene rings, naphthalene rings, anthracene rings, or pyrene rings; or a fused ring (a fluorene ring, a benzofluorene ring, a dibenzofluorene ring, an indole ring, a carbazole ring, etc.) of a benzene ring, a naphthalene ring, an anthracene ring, or a pyrene ring with a heterocyclic ring or an aliphatic ring.

The aromatic ring may have an optional substituent, and the substituent preferably contains a heteroatom. In addition, regarding the aromatic ring, two or more aromatic rings may be linked by a linking group, and the linking group preferably contains a heteroatom. Examples of heteroatoms include oxygen atoms, nitrogen atoms, and sulfur atoms.

Preferably, the "aromatic ring" is an organic group having a carbon atom number of 6 to 30 or a carbon atom number of 6 to 24, including at least one heteroatom selected from among N, S and O on, in, or between the rings.

Examples of heteroatoms contained on the ring include nitrogen atoms contained in amino groups (for example, a propargylamino group) and cyano groups; and oxygen atoms contained in formyl groups, hydroxy groups, carboxyl groups, and alkoxy groups (for example, a propargyloxy group), which are oxygen-containing substituents, and nitrogen atoms and oxygen atoms contained in nitro groups, which are oxygen-containing substituents and nitrogen-containing substituents. Examples of heteroatoms contained in the ring include oxygen atoms contained in xanthene and nitrogen atoms contained in carbazole.

Examples of heteroatoms contained in the linking group of two or more aromatic rings include nitrogen atoms, oxygen atoms, and sulfur atoms contained in -NH-bond, -NHCO- bond, -O- bond, -COO- bond, -CO- bond, -S- bond, -SS- bond, and -SO₂-bond. The unit structure A is preferably a unit structure having an aromatic ring that has the above oxygen-containing substituent, a unit structure having two or more aromatic rings that are linked by -NH-, or a unit structure having a fused ring of one or more aromatic hydrocarbon ring and one or more heterocyclic rings.

Preferably, examples of unit structures A' include a phenol unit structure and an amine unit structure. For example, the phenol unit structure is derived from monomers of, for example, the following Formula (10-1) to Formula (10-36), and the amine unit structure is derived from monomers of, for example, the following Formula (10-37) to Formula (10-69).

Here, exemplified structures described below are simply examples, and in compounds in which, on an aromatic ring, a hydroxy group can be substituted, the number of hydroxy groups is not limited to those of specific exemplified structures, and may be substituted within a theoretically possible range, and the structures also include those in which any substituent described below that can be theoretically bonded is bonded to an aromatic ring.

### (Examples of monomers having phenol unit structure)

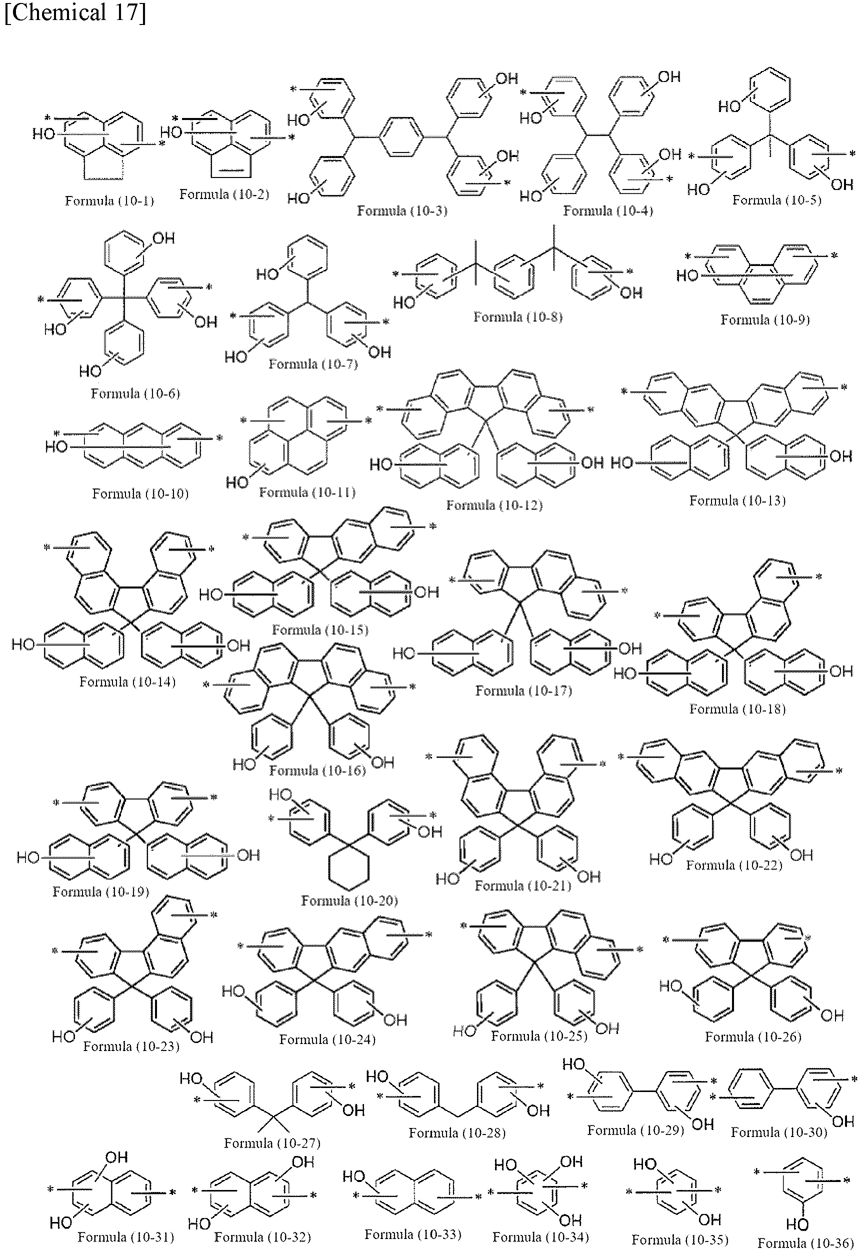

(* indicates a bond).

In addition, H of OH of monomers having the phenol unit structure may be substituted with a phenyl group or a C₂₋₁₀ alkynyl group.

### (Examples of monomers having amine unit structure)

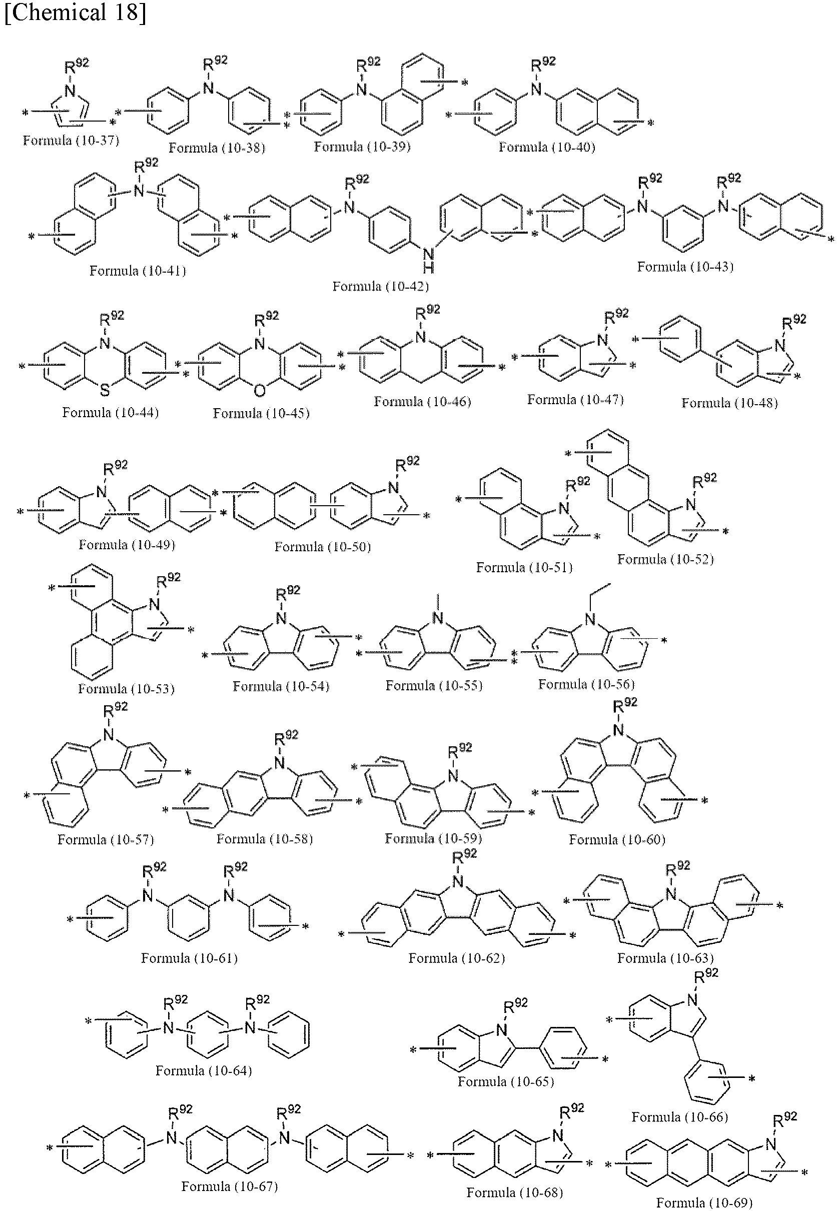

(* indicates a bond).

In addition, in the amine framework, R⁹² is a hydrogen atom, a phenyl group, or a C₂₋₁₀ alkynyl group.

### <Organic group C1>

The end of the novolac resin is capped with a monovalent organic group C1 or organic group C2.

The organic group C1 is represented by the following Formula (1).

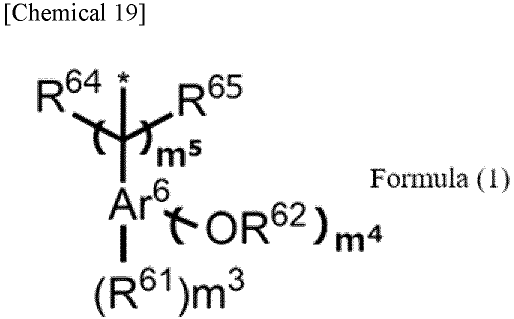

In Formula (1), * indicates a bond by which the organic group C1 is bonded to at least one end of the novolac resin,
Ar⁶ is a C₆₋₄₀ aryl group, R⁶¹ is a linear, branched or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they can be bonded. Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z. R⁶² is a hydrogen atom, a C₁₋₁₀ alkyl group, a C₂₋₁₀ alkenyl group or a C₂₋₁₀ alkynyl group. R⁶⁴ and R⁶⁵ are each independently a hydrogen atom, a phenyl group substitutable with a hydroxy group, or a naphthyl group substitutable with a hydroxy group, and when R⁶⁴ and R⁶⁵ are a phenyl group or a naphthyl group, R⁶⁴ or R⁶⁵ and the aryl group Ar⁶ can form a new ring via a single bond or a methylene group.

m⁴ is 0 or 1, m³ is an integer of 0 to (3+2n) when m⁴ is 0, m³ is an integer of 0 to (2+2n) when m⁴ is 1, n is a condensation degree of the benzene ring of the aryl group Ar⁶, and m⁵ is 0 or 1.

In this specification, the condensation degree of a benzene ring is the number of benzene rings condensed to one benzene ring. For example, a single benzene ring has a condensation degree of 0, a naphthalene ring has a condensation degree of 1, and an anthracene ring has a condensation degree of 2.

The organic group C1 of Formula (1) is a monovalent group derived from the compound of the following Formula (5).

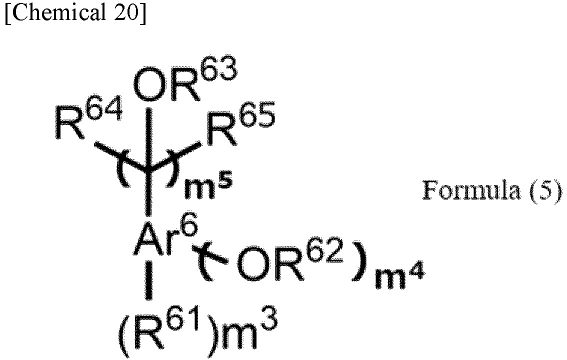

In Formula (5), Ar⁶, R⁶¹, R⁶², R⁶⁴, R⁶⁵, m³, m⁴ and m⁵ are the same as in Formula (1), and R⁶³ is a hydrogen atom or a methyl group.

Examples of compounds of Formula (5) are shown below.

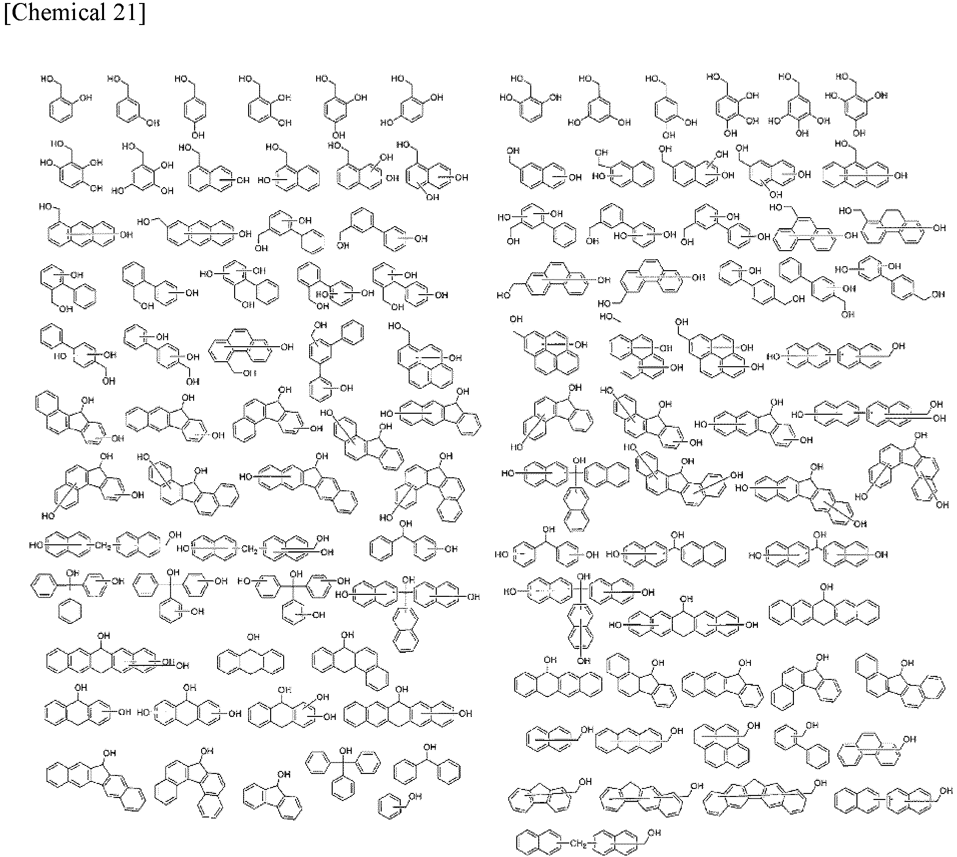

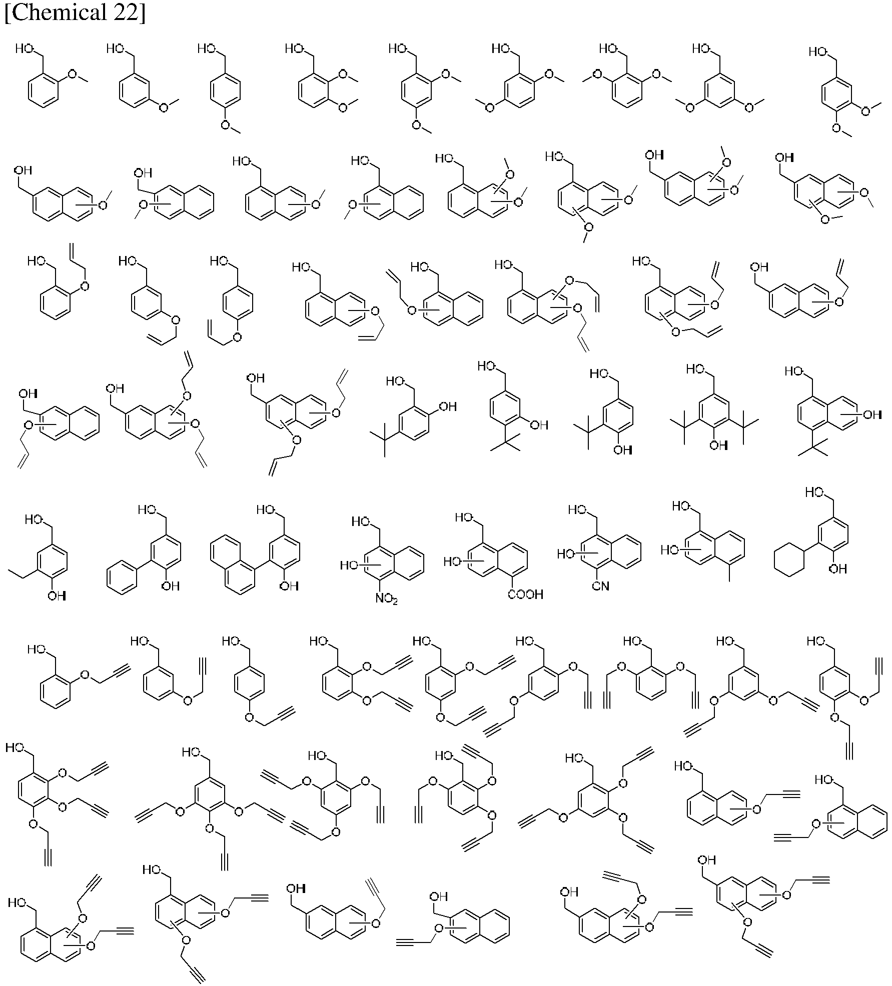

Among these, the organic group C1 is preferably a monovalent group derived from a hydroxy-containing aromatic methylol compound, which is 2-hydroxybenzyl alcohol, 3-hydroxybenzyl alcohol, 4-hydroxybenzyl alcohol, or 2,6-di-tert-butyl-4-hydroxymethylphenol.

### <Organic group C2>

The organic group C2 is represented by the following Formula (2).

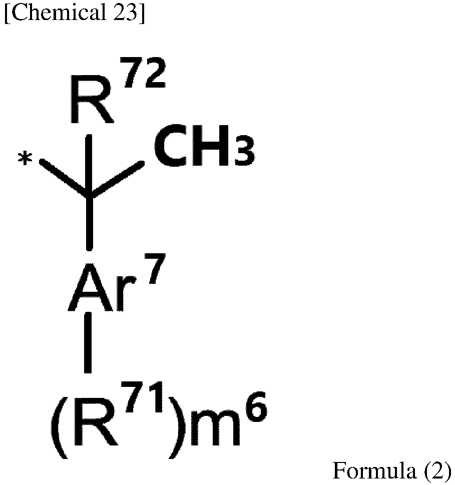

In Formula (2), * indicates a bond by which the organic group C2 is bonded to at least one end of the novolac resin, Ar⁷ is a C₆₋₄₀ aryl group, and R⁷¹ is a linear, branched or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they can be bonded. Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z. R⁷² is a hydrogen atom, a methyl group, or a phenyl group. m⁶ is an integer of 0 to (3+2n), and n is a condensation degree of an aromatic ring constituting the aryl group Ar⁷.

The organic group C2 of Formula (2) is a monovalent group derived from an aromatic vinyl compound of the following Formula (6).

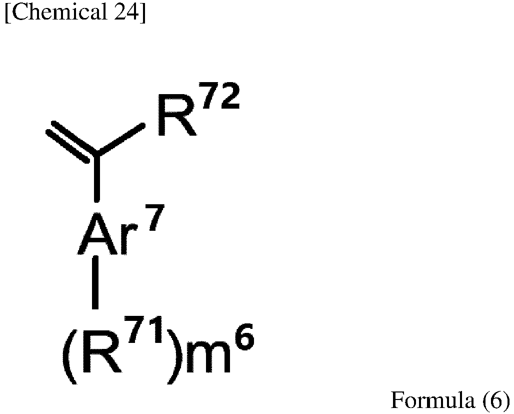

In Formula (6), Ar⁷, R⁷¹, R⁷² and m⁶ are the same as in Formula (2).

Examples of aromatic vinyl compounds of Formula (6) are shown below.

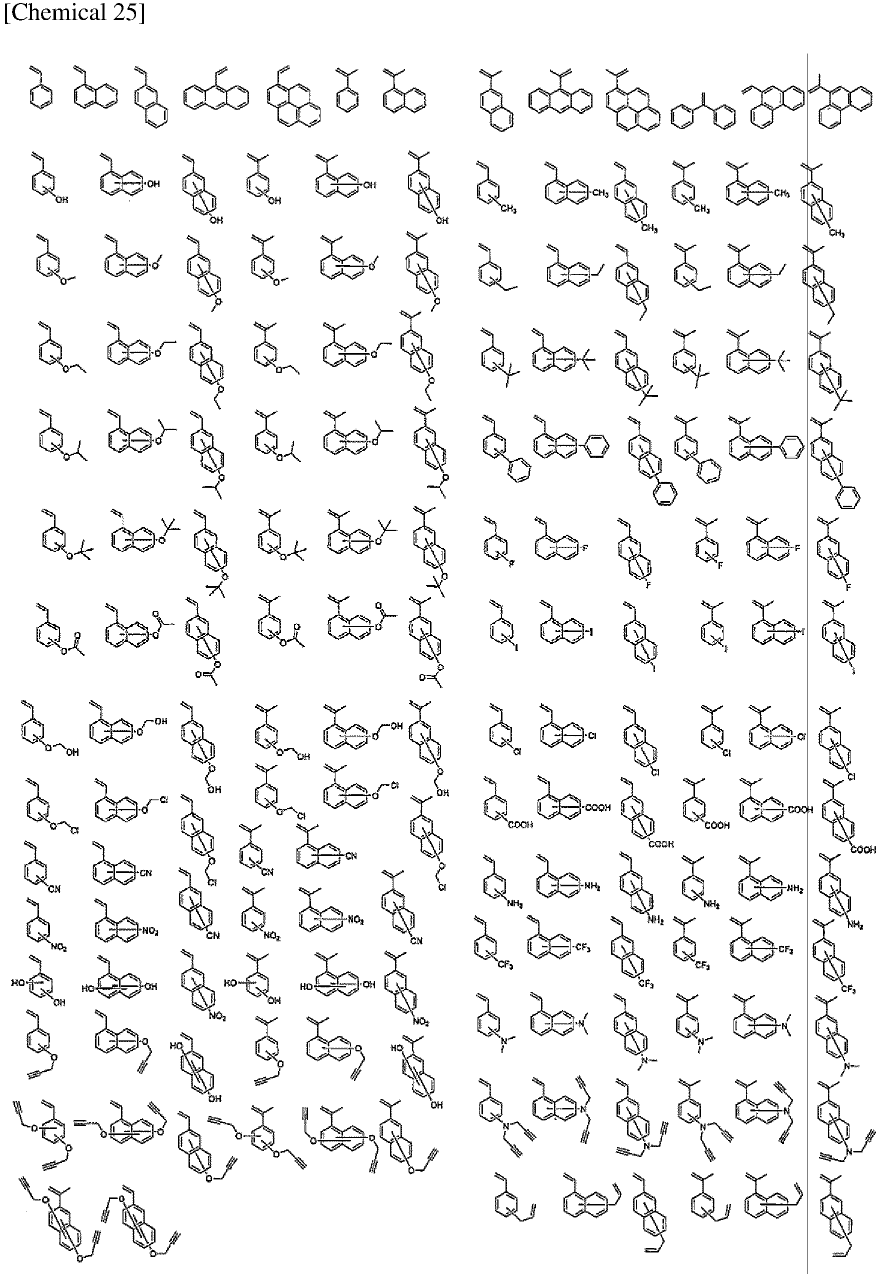

Among these, preferably, the organic group C2 is a monovalent group derived from an aromatic vinyl compound such as styrene, 2-vinylnaphthalene, 4-tert-butylstyrene, or 4-tert-butoxystyrene.

### <Unit structure B>

The novolac resin of the present invention preferably includes a composite unit structure A-B of the following Formula (7) and a C moiety that caps at least one end of the composite unit structure A-B.

Here, the composite unit structure A-B of Formula (7) is described, but in addition to the unit structure A-B, the novolac resin may further include other unit structures, for example, the unit structure A'.

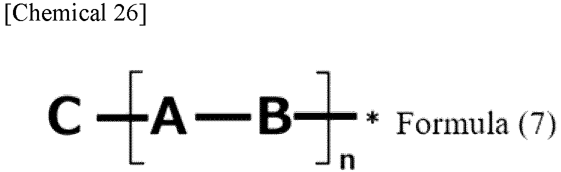

In Formula (7), n is the number of composite unit structures A-B, and the unit structure A is the unit structure A1 or the unit structure A2, or may be another divalent group having an aromatic ring. The C moiety is the organic group C1 or the organic group C2.

The unit structure B is one or more unit structures containing a linking carbon atom [refer to the section of definitions of terms] bonded to an aromatic ring in the unit structure A, and includes a structure of Formula (B1), (B2) or (B3) described below. The unit structure B is linked to the carbon atom of the unit structure A by a covalent bond.

In addition, at least one composite unit structure A-B may be substituted with one or more unit structures D including structures of Formulae (D1), (D2) and (D3) described below as one unit structure equivalent thereto.

### <Formula (B1)>

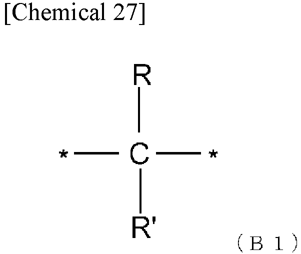

In Formula (B1), R and R' are each independently a hydrogen atom, a C₆₋₃₀ aromatic ring which may have a substituent, a C₃₋₃₀ heterocyclic ring which may have a substituent, or a linear, branched or cyclic alkyl group having a carbon atom number of 10 or less which may have a substituent.

In addition, the two bonds in Formula (B1) can be covalently bonded to the aromatic ring in the unit structure A.

In the definitions of R and R' in Formula (B1), the terms "aromatic ring" and "heterocyclic ring" can be referred to the <Definitions of terms> section.

In the definitions of R, and R' in Formula (B1), examples of "alkyl group" include methyl group, ethyl group, n-propyl group, i-propyl group, cyclopropyl group, n-butyl group, i-butyl group, s-butyl group, t-butyl group, cyclobutyl group, 1-methyl-cyclopropyl group, 2-methyl-cyclopropyl group, n-pentyl group, 1-methyl-n-butyl group, 2-methyl-n-butyl group, 3-methyl-n-butyl group, 1,1-dimethyl-n-propyl group, 1,2-dimethyl-n-propyl group, 2,2-dimethyl-n-propyl group, 1-ethyl-n-propyl group, cyclopentyl group, 1-methyl-cyclobutyl group, 2-methyl-cyclobutyl group, 3-methyl-cyclobutyl group, 1,2-dimethyl-cyclopropyl group, 2,3-dimethyl-cyclopropyl group, 1-ethyl-cyclopropyl group, 2-ethyl-cyclopropyl group, n-hexyl group, 1-methyl-n-pentyl group, 2-methyl-n-pentyl group, 3-methyl-n-pentyl group, 4-methyl-n-pentyl group, 1,1-dimethyl-n-butyl group, 1,2-dimethyl-n-butyl group, 1,3-dimethyl-n-butyl group, 2,2-dimethyl-n-butyl group, 2,3-dimethyl-n-butyl group, 3,3-dimethyl-n-butyl group, 1-ethyl-n-butyl group, 2-ethyl-n-butyl group, 1,1,2-trimethyl-n-propyl group, 1,2,2-trimethyl-n-propyl group, 1-ethyl-1-methyl-n-propyl group, 1-ethyl-2-methyl-n-propyl group, cyclohexyl group, 1-methyl-cyclopentyl group, 2-methyl-cyclopentyl group, 3-methyl-cyclopentyl group, 1-ethyl-cyclobutyl group, 2-ethyl-cyclobutyl group, 3-ethyl-cyclobutyl group, 1,2-dimethyl-cyclobutyl group, 1,3-dimethyl-cyclobutyl group, 2,2-dimethyl-cyclobutyl group, 2,3-dimethyl-cyclobutyl group, 2,4-dimethyl-cyclobutyl group, 3,3-dimethyl-cyclobutyl group, 1-n-propyl-cyclopropyl group, 2-n-propyl-cyclopropyl group, 1-i-propyl-cyclopropyl group, 2-i-propyl-cyclopropyl group, 1,2,2-trimethyl-cyclopropyl group, 1,2,3-trimethyl-cyclopropyl group, 2,2,3-trimethyl-cyclopropyl group, 1-ethyl-2-methyl-cyclopropyl group, 2-ethyl-1-methyl-cyclopropyl group, 2-ethyl-2-methyl-cyclopropyl group, 2-ethyl-3-methyl-cyclopropyl group, n-heptyl group, n-octyl group, n-nonyl group, and n-decyl group.

Preferably, R, and R' are each independently phenyl, naphthalenyl, anthracenyl, phenanthrenyl, naphthacenyl, or pyrenyl.

In addition, the unit structure including a structure of Formula (B1) may include, for example, structures in which two or three of structures of Formula (B1), which are the same as or different from each other, are bonded to a divalent or trivalent linking group to form a dimeric or trimeric structure. In this case, each of the structures of Formula (B1) is represented by the following Formula (B11). 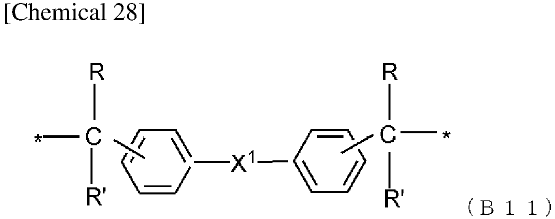 (X¹ is a single bond, a methylene group, an oxygen atom, a sulfur atom, or -N(R¹)-, and R¹ is a hydrogen atom or a C₁₋₂₀ hydrocarbon group (which may be a chain hydrocarbon group and a cyclic hydrocarbon group (which may be aromatic or non-aromatic)).

Examples of such linking groups include linking groups having two or three aromatic rings. Specific examples of divalent or trivalent linking groups include the following divalent linking group (L1) of Formula (B11): 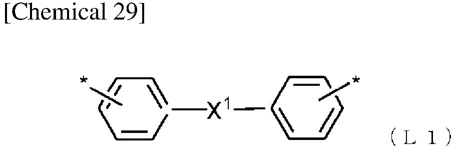 [X¹ is a single bond, a methylene group, an oxygen atom, a sulfur atom, or -N(R¹)-, and R¹ is a hydrogen atom or a C₁₋₂₀ hydrocarbon group (which may be a chain hydrocarbon group and a cyclic hydrocarbon group (which may be aromatic or non-aromatic))].

Other examples include divalent or trivalent linking groups of the following Formulae (L2) and (L3). 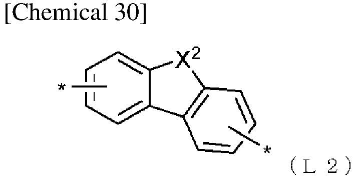 [X² is a methylene group, an oxygen atom, or -N(R²)-, and R² is a hydrogen atom, C₁₋₁₀ aliphatic hydrocarbon group, or C₅₋₂₀ aromatic hydrocarbon group].

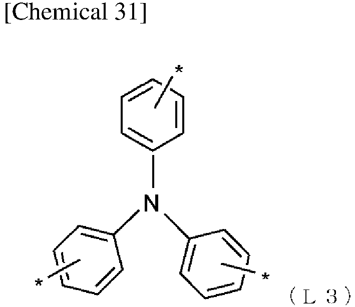

A divalent linking group such as that shown in the following Formula (L4) which can form a covalent bond with a linking carbon atom according to an addition reaction between acetylide and ketone may be exemplified.

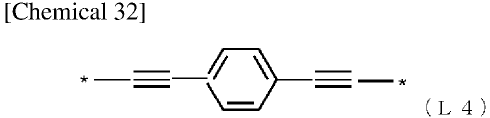

Here, when at least one of R and R' in Formula (B1) is an aromatic ring, the aromatic ring [for example, refer to Ar in the following Formula (B12)] may additionally bond to another unit structure B.

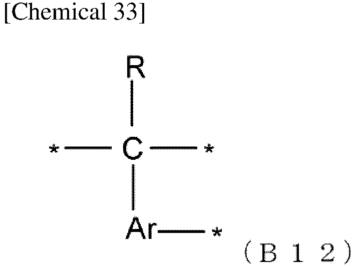

In this case, as shown in the following Formula (D1), when one bond of the linking carbon atom is bonded to a polymer end T (hydrogen atom; various functional groups such as a hydroxy group and an unsaturated aliphatic hydrocarbon group, an end unit structure A, a unit structure A in other polymer chains, etc.), it can be substituted with at least one composite unit structure A-B as one unit structure D equivalent to the composite unit structure A-B. That is, along with by bonding the aromatic ring in Formula (D1) [Ar in Formula (D1)] to another unit structure B, the polymer chain may be extended by performing bonding to the aromatic ring of the unit structure A via a bond from the remaining linking carbon atoms shown in Formula (D1).

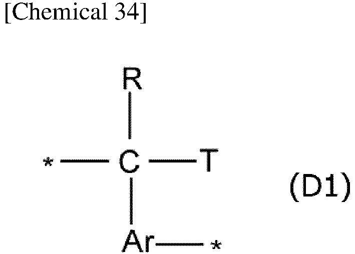

Some specific examples of the unit structure B including a structure of Formula (B1) are as follows. * basically indicates a bonding moiety with the unit structure A. Needless to say, structures including the exemplified structures as a part of the whole may be used. 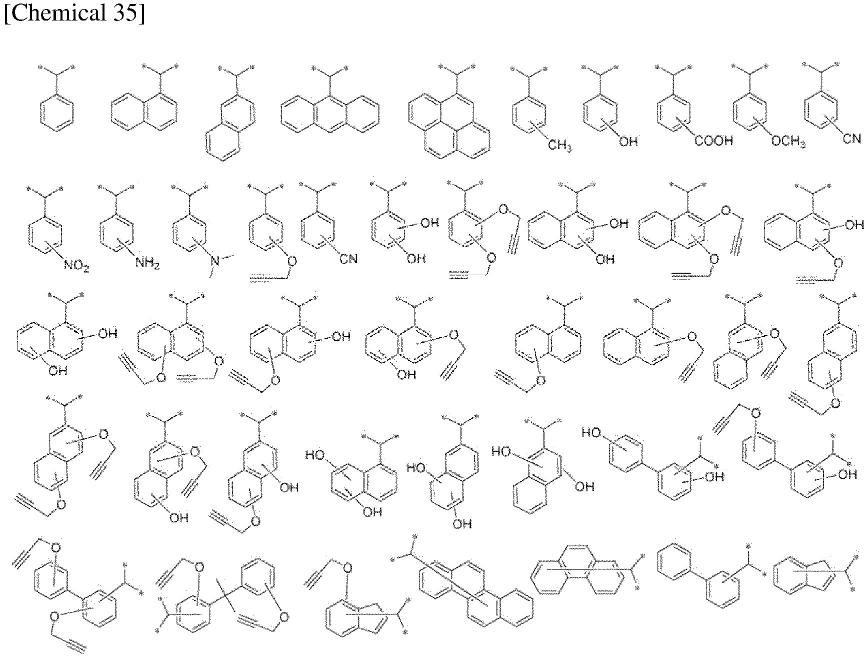 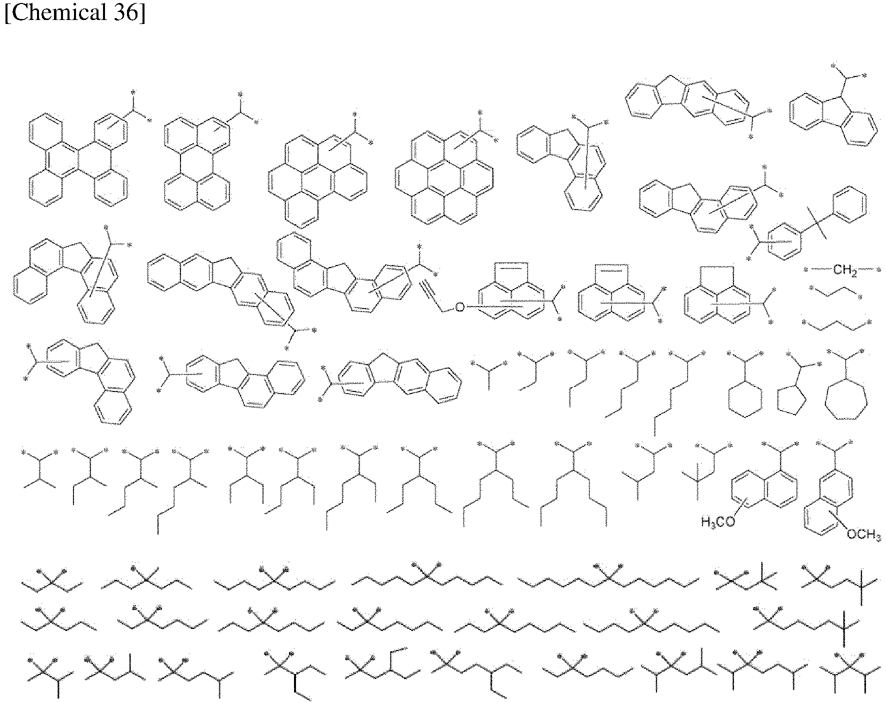 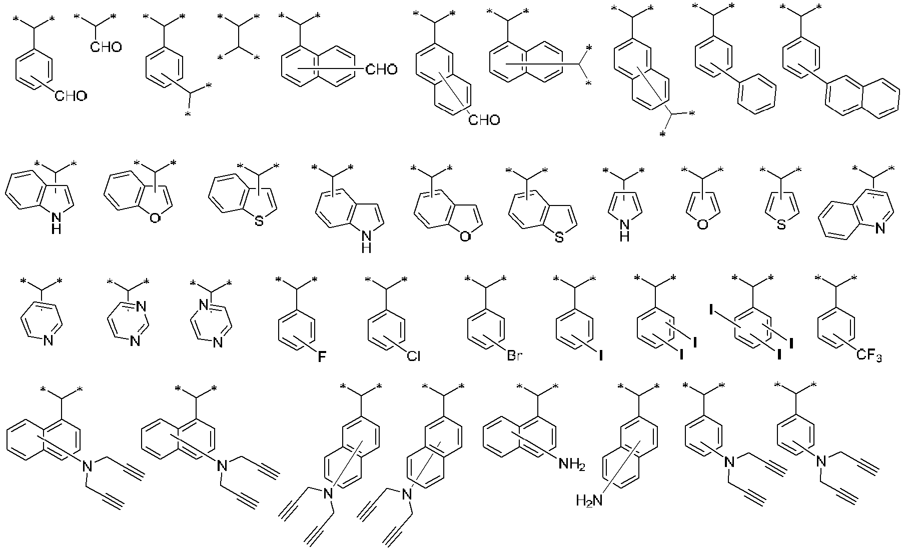 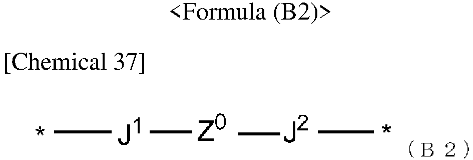 In Formula (B2),
Z⁰ is a C₆₋₃₀ aromatic ring residue that may have a substituent, an aliphatic ring residue, or an organic group in which two aromatic or aliphatic rings are linked by a single bond. Examples of organic groups in which two aromatic rings or aliphatic rings are linked by a single bond include divalent residues such as biphenyl, cyclohexylphenyl, and bicyclohexyl.

J¹ and J² are each independently a divalent organic group which may have a direct bond or a substituent. The divalent organic group is preferably a linear or branched alkylene group having a carbon atom number of 1 to 6 which may be substituted with a hydroxy group, an aryl group (a phenyl group, a substituted phenyl group, etc.) or a halogen atom (for example, fluorine) as a substituent. Examples of linear alkylene groups include methylene group, ethylene group, propylene group, butylene group, pentylene group, and hexylene group.

In addition, the unit structure including a structure of Formula (B2) may include, as in Formula (B1), structures in which two or three structures of Formula (B2), which are the same as or different from each other, are bonded to a divalent or trivalent linking group to form a dimeric or trimeric structure.

Here, since Formula (B2) includes an aspect in which an aromatic ring is contained [Z⁰ in Formula (B2)], as in Formula (B1), the aromatic ring [for example, an aromatic ring in Z⁰_{Ar} in the following Formula (B21)] may be additionally bonded to another unit structure B [vertical bond in Formula (B21)]. 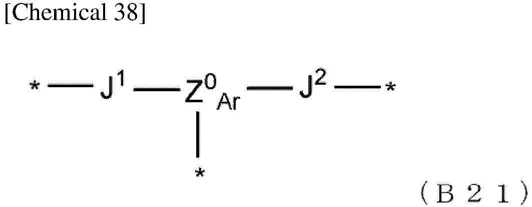 [in Formula (B21),
Z⁰_{Ar} is a C₆₋₃₀ aromatic ring residue which may have a substituent or an organic group in which two aromatic rings or aliphatic rings are linked by a single bond, and is an organic group having at least one aromatic ring, the bond extending downward from Z⁰_{Ar} extends from the aromatic ring in Z⁰_{Ar}, and J¹ and J² are the same as those defined in Formula (B2)].

In this case, as shown in the following Formula (D2): 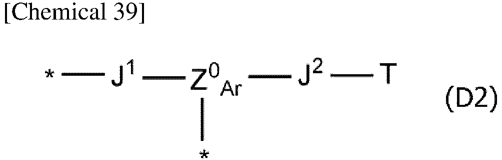 [in Formula (D2),
Z⁰_{Ar}, J¹ and J² are the same as those defined in Formula (B21), and T is a polymer end]
when one bond of the linking carbon atom is bonded to a polymer end T (hydrogen atom; various functional groups such as a hydroxy group and an unsaturated aliphatic hydrocarbon group, an end unit structure A, a unit structure A in other polymer chains, etc.), it can be substituted with at least one composite unit structure A-B as one unit structure D equivalent to the composite unit structure A-B. That is, along with by bonding the aromatic ring in Formula (D2) [aromatic ring in Z⁰_{Ar} in Formula (D2)] to another unit structure B, the polymer chain may be extended by performing bonding to the aromatic ring of the unit structure A via a bond from the remaining linking carbon atoms shown in Formula (D2).

Some specific examples of the unit structure including a structure of Formula (B2) are as follows. * indicates a bonding moiety with the unit structure A. Needless to say, unit structures including the exemplified structures as a part of the whole may be used.

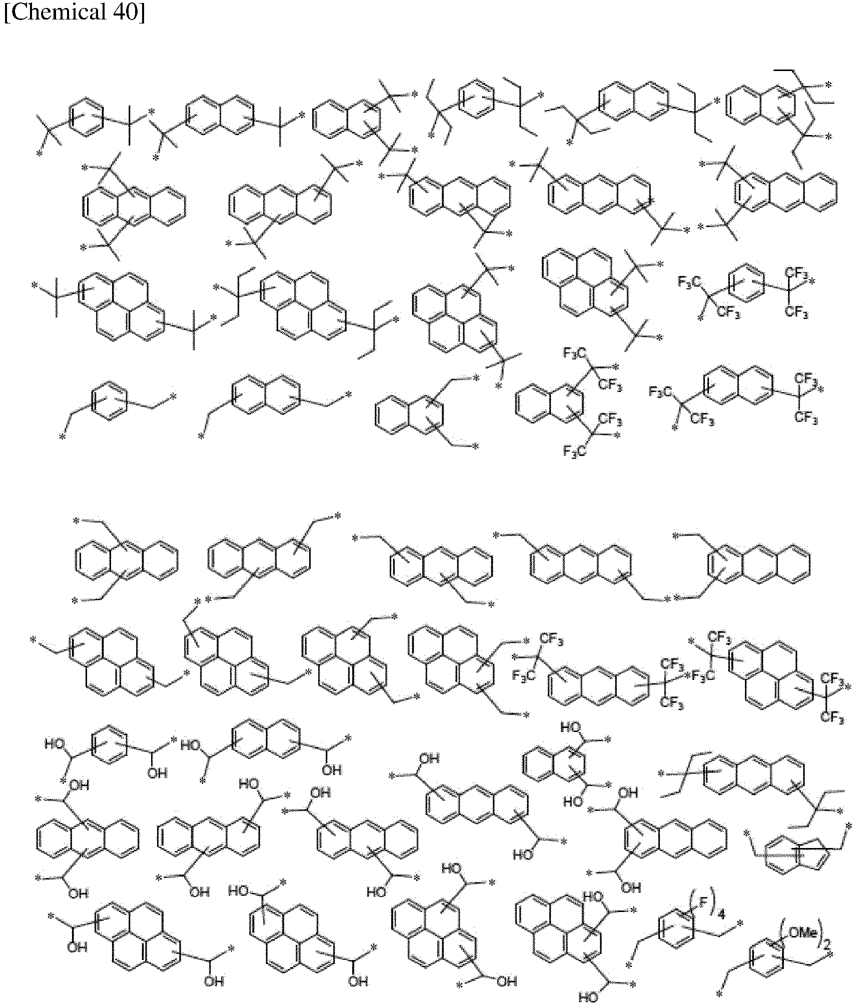

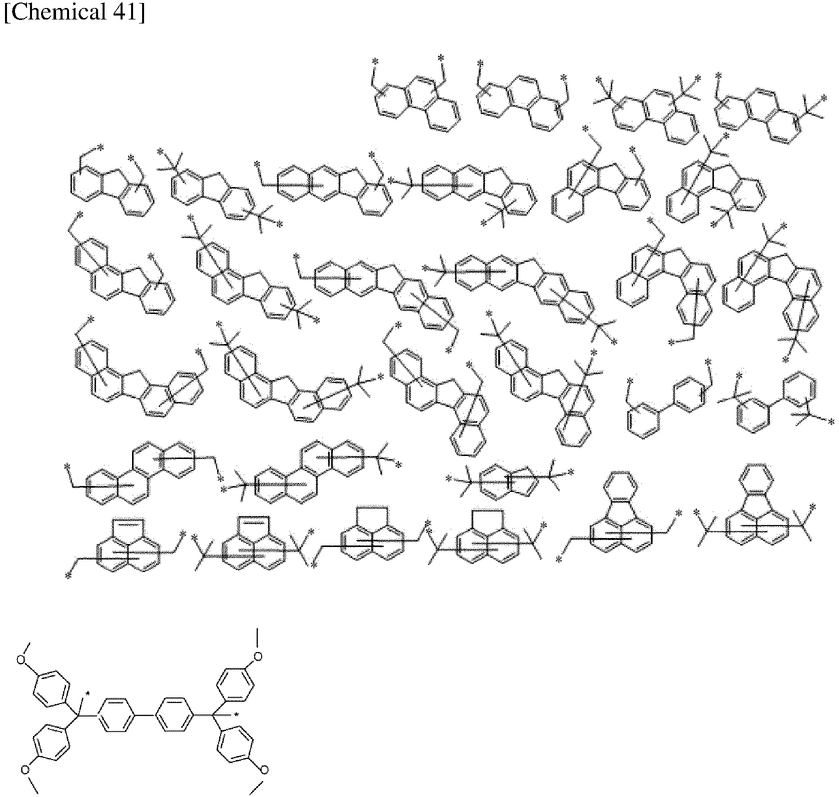

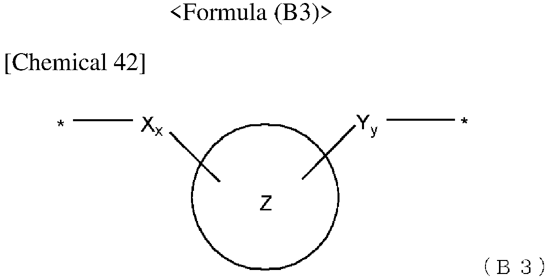

In Formula (B3),
Z is a monocyclic ring that has a carbon atom number of 4 to 25 and that may have a substituent, or a bicyclic, tricyclic, or tetracyclic fused ring that has a carbon atom number of 4 to 25 and that may have a substituent. In addition, the number of carbon atoms herein is only the number of carbon atoms constituting the ring framework of the monocyclic ring or bicyclic, tricyclic or tetracyclic fused ring excluding the substituent, and does not include the number of heteroatoms constituting the heterocyclic ring when the monocyclic ring or fused ring is a heterocyclic ring.

The monocyclic ring is a non-aromatic monocyclic ring; and at least one of the monocyclic rings constituting the bicycle, tricycle or tetracycle is a non-aromatic monocyclic ring, and the remaining monocyclic rings may be aromatic monocyclic rings or non-aromatic monocyclic rings.

The monocyclic ring, or bicyclic, tricyclic or tetracyclic fused ring may additionally form a fused ring with one or more aromatic rings to form a penta- or higher-cyclic fused ring, the number of carbon atoms of the penta- or higher-cyclic fused ring is preferably 40 or less, the number of carbon atoms herein is only the number of carbon atoms constituting the ring framework of the penta- or higher-cyclic fused ring excluding the substituent, and does not include the number of heteroatoms constituting the heterocyclic ring when the penta- or higher-cyclic fused ring is a heterocyclic ring.

X and Y are the same as or different from each other, and are a -CR³R⁴-group, and R³ and R⁴ are the same as or different from each other, and are a hydrogen atom or C₁₋₆ hydrocarbon group.

x and y are the numbers of X's and Y's, respectively, and are each independently 0 or 1. 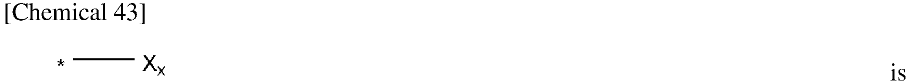 bonded to any carbon atom (referred to as "carbon atom 1") constituting the non-aromatic monocyclic ring of Z (when x=1) or extends from carbon atom 1 (when x=0), 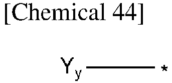 is bonded to any carbon atom (referred to as "carbon atom 2") constituting the non-aromatic monocyclic ring of Z (when y=1) or extends from carbon atom 2 (when y=0), and carbon atom 1 and carbon atom 2 may be the same as or different from each other, and when carbon atom 1 and carbon atom 2 are different from each other, they may belong to the same non-aromatic monocyclic ring or to different non-aromatic monocyclic rings.

In addition, in Formula (B3), arbitrarily, a linking carbon atom other than carbon atom 1 and carbon atom 2 may be contained.

Here, when Z is a tri- or higher-cyclic fused ring, the permutation relationship between one or two non-aromatic monocyclic rings to which carbon atoms 1 and 2 of Formula (B3) belong and the remaining monocyclic rings in the fused ring are arbitrary, and when carbon atom 1 and carbon atom 2 belong to different non-aromatic monocyclic rings (referred to as a "non-aromatic monocyclic ring 1" and a "non-aromatic monocyclic ring 2," respectively), the permutation relationship between the non-aromatic monocyclic ring 1 and the non-aromatic monocyclic ring 2 in the fused ring is also arbitrary.

In the unit structure including a structure of Formula (B3), as in Formula (B1), two or three structures of Formula (B3), which are the same as or different from each other, may be bonded to a divalent or trivalent linking group to form a dimeric or trimeric structure.

Some specific examples of organic groups including a structure of Formula (B3) are as follows. The bonding moiety with the unit structure A is not particularly limited. Needless to say, structures including the exemplified structures as a part of the whole may be used.

Here, examples include those having more than two bonds (*), and these extra bonds can be used for bonding to aromatic rings in other polymer chains, crosslinking and the like.

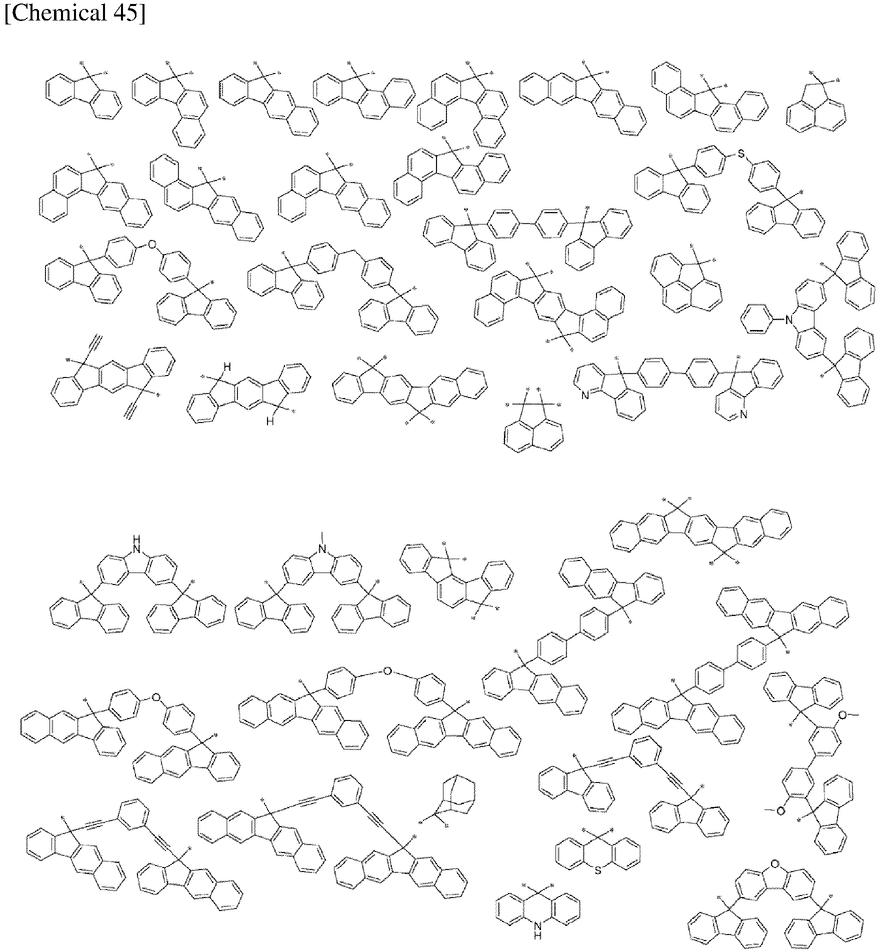

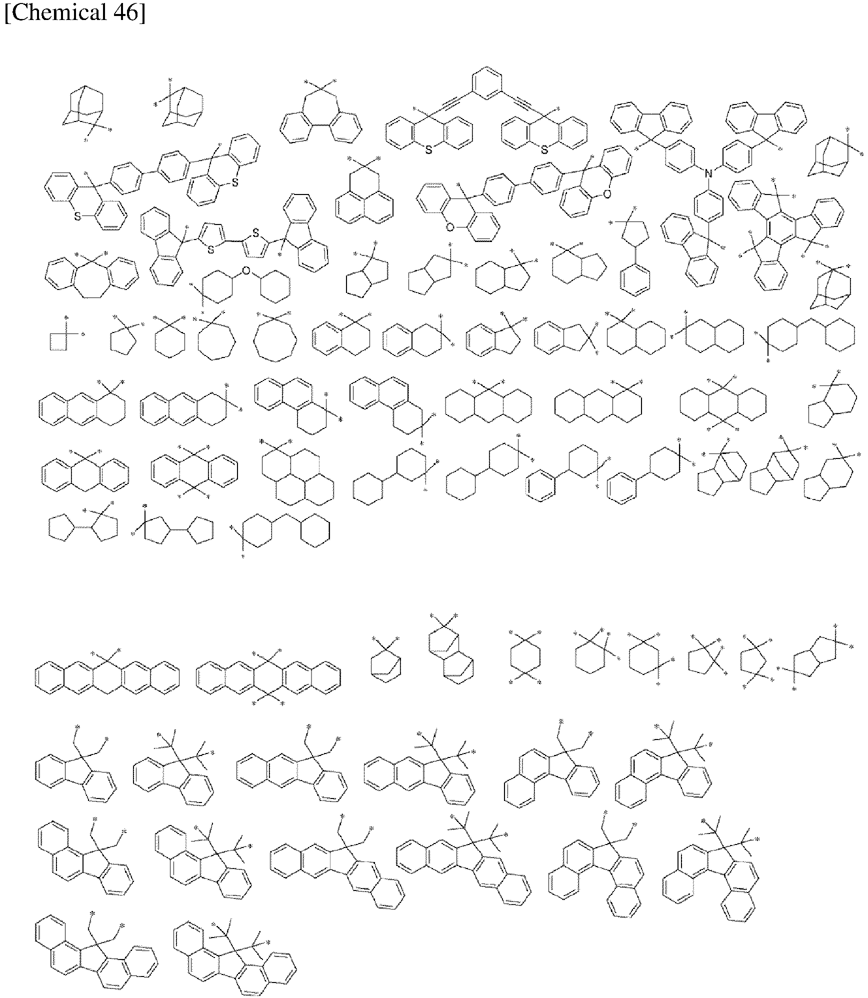

Here, when Z in Formula (B3) contains an aromatic ring, the aromatic ring [for example, refer to Ar¹ in the following Formula (B32)] may additionally be bonded to another unit structure B.

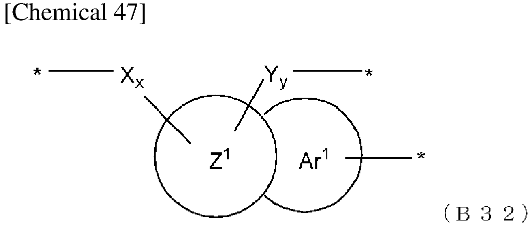

In Formula (B32),
Z¹ is at least one non-aromatic monocyclic ring, Ar¹ is at least one aromatic monocyclic ring that forms a fused ring with the non-aromatic monocyclic ring of Z¹, and Z and Ar¹ together form a bicyclic, tricyclic, tetracyclic, or pentacyclic fused ring that has a carbon atom number of 8 to 25 and that may have a substituent. In addition, the number of carbon atoms herein is only the number of carbon atoms constituting the ring framework of the bicyclic, tricyclic or tetracyclic fused ring excluding the substituent, and does not include the number of heteroatoms constituting the heterocyclic ring when the bicyclic, tricyclic, or tetracyclic fused ring is a heterocyclic ring.

The bicyclic, tricyclic, tetracyclic, or pentacyclic organic group may additionally form a fused ring with one or more aromatic rings to form a hexa- or higher-cyclic ring, the number of carbon atoms of the hexa- or higher-cyclic fused ring is preferably 40 or less, and the number of carbon atoms herein is only the number of carbon atoms constituting the ring framework of the penta- or higher-cyclic fused ring excluding the substituent, and does not include the number of heteroatoms constituting the heterocyclic ring when the hexa- or higher-cyclic fused ring is a heterocyclic ring.

In addition, in the cyclic organic group, the sequence and position relationship between one, two or more non-aromatic monocyclic rings belonging to Z¹ and one, two or more aromatic monocyclic rings belonging to Ar¹ may be arbitrary. For example, when there are two or more non-aromatic monocyclic rings belonging to Z¹ and there are two or more aromatic monocyclic rings belonging to Ar¹, the non-aromatic monocyclic rings belonging to Z¹ and the aromatic monocyclic rings belonging to Ar¹ may be alternately arranged to form a fused ring.

In addition, X, Y, x, and y are the same as those defined in Formula (B3).

In this case, as shown in the following Formula (D3): 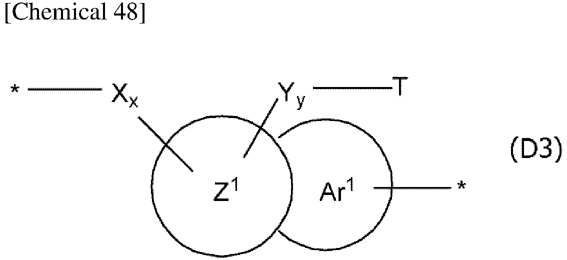 [in Formula (D3),
Z¹, Ar¹, X, Y, x and y are the same as those defined in Formula (B32), and T is a polymer end]
when one bond of the linking carbon atom is bonded to a polymer end T (hydrogen atom; various functional groups such as a hydroxy group and an unsaturated aliphatic hydrocarbon group, an end unit structure A, a unit structure A in other polymer chains, etc.), it can be substituted with at least one composite unit structure A-B as one unit structure D equivalent to the composite unit structure A-B. That is, along with by bonding the aromatic ring in Formula (D3) [Ar¹ in Formula (D3)] to another unit structure B, the polymer chain may be extended by performing bonding to the aromatic ring of the unit structure A via a bond from the remaining linking carbon atoms shown in Formula (D3).

As a more specific structure of Formula (D3), for example, in the following Formula (D31), T in Formula (D3) is a hydrogen atom which is an end group, and among p, k₁ and k₂ which can be bonds, p and k₁ or p and k₂ can form one unit structure D equivalent to the composite unit structure A-B.

Here, k₁ and k₂ can also function as the unit structure A.

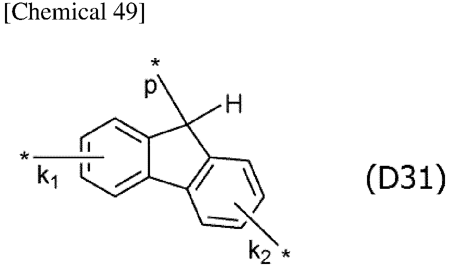

In addition, the following Formula (D32) shows an example in which T in Formula (D3) is a phenyl group. In this example, among p, k₁, k₂ and m which can be bonds, p and k₁, p and k₂, or p and m can form one unit structure D equivalent to the composite unit structure A-B.

Here, k₁ and k₂, k₁ and m, or k₂ and m can also function as the unit structure A.

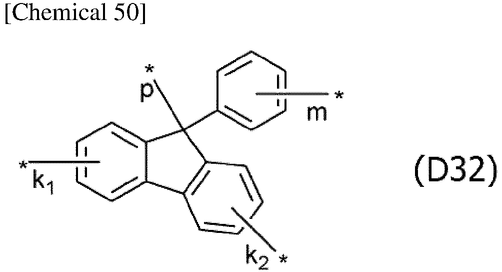

Various more specific examples of the unit structure D (one unit structure equivalent to the composite unit structure A-B) of Formula (D3) are as follows. * indicates a bonding moiety with the unit structure A.

In the unit structure D, separately, a bond extends from the aromatic ring in these structures to bond to the unit structure B, but in the following specific examples, such a bond is omitted. Needless to say, unit structures including the exemplified structures as a part of the whole may be used.

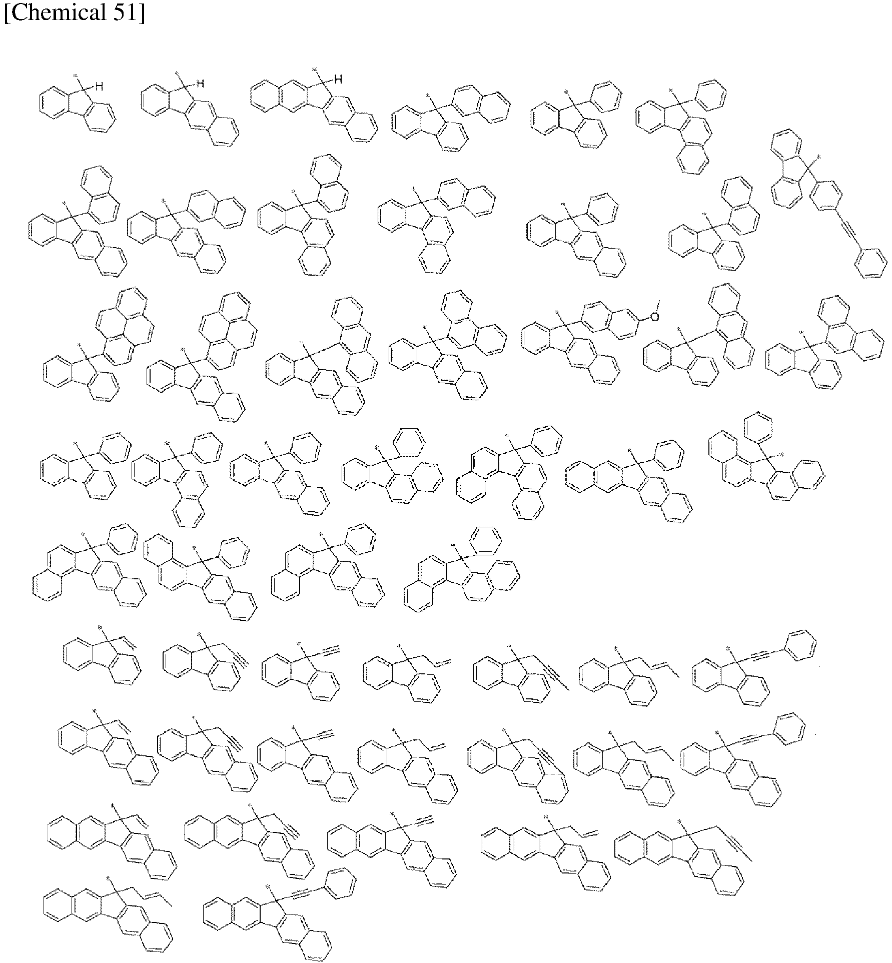

Here, in the above specific examples, when there is no bond from the aromatic ring, it can be a specific example of a polymer end.

In the novolac resin of the present invention, all or some of the hydrogen atoms of the hydroxy group, amino group or alkylamino group are substitutable with a C₂₋₁₀ alkynyl group.

### <Production of novolac resin>

A novolac resin having the structure of Formula (7) can be prepared by a known method.

For example, the composite unit structure A-B can be prepared by condensing a ring-containing compound of H-A-H and an oxygen-containing compound of OHC-B, O=C-B, RO-B-OR, RO-CH₂-B-CH₂-OR or the like. Here, in the formula, A and B are as defined above. R is a hydrogen atom, a halogen atom, or an alkyl group having a carbon atom number of about 1 to 3.

The ring-containing compounds and the oxygen-containing compounds each may be used alone or two or more thereof may be used in combination. In this condensation reaction, per 1 mol of the ring-containing compound, the oxygen-containing compound can be used in a proportion of 0.1 to 10 mol and preferably 0.1 to 2 mol.

The condensation reaction for forming the composite unit structure A-B moiety of the novolac resin and the addition reaction for forming the C moiety of the novolac resin end can proceed simultaneously.

As the catalyst used in these reactions, for example, mineral acids such as sulfuric acid, phosphoric acid, and perchloric acid, organic sulfonic acids such as p-toluenesulfonic acid, p-toluenesulfonic acid monohydrate, methanesulfonic acid, and trifluoromethanesulfonic acid, and carboxylic acids such as formic acid and oxalic acid can be used. The amount of the catalyst used varies depending on the type of the catalyst used, but is generally 0.001 to 10,000 parts by mass, preferably 0.01 to 1,000 parts by mass, and more preferably 0.05 to 100 parts by mass with respect to 100 parts by mass of the ring-containing compound (a total amount when a plurality of types thereof is used).

The condensation reaction and the addition reaction can be performed without a solvent, but are generally performed using a solvent. The solvent is not particularly limited as long as it can dissolve the reactant and does not inhibit the reaction. Examples thereof include ethers such as 1,2-dimethoxyethane, diethylene glycol dimethyl ether, propylene glycol monomethyl ether, propylene glycol monomethyl ether acetate, tetrahydrofuran, and dioxane. In addition, for example, if the catalyst used is a liquid such as formic acid, it can also serve as a solvent.

The condensation reaction temperature is generally 40°C to 200°C, and preferably 100°C to 180°C. The reaction time varies depending on the reaction temperature, but is generally 5 minutes to 50 hours, and preferably 5 minutes to 24 hours.

The weight average molecular weight of the novolac resin according to one aspect of the present invention is generally 500 to 100,000 and preferably 600 to 50,000, 700 to 10,000, or 800 to 8,000.

### <Solvent>

The resist underlayer film-forming composition according to one aspect of the present invention contains a solvent. The solvent is not particularly limited as long as it can dissolve a specific novolac resin and other optional components that are added as necessary.

Examples of solvents include methyl cellosolve acetate, ethyl cellosolve acetate, propylene glycol, propylene glycol monomethyl ether, propylene glycol monoethyl ether, propylene glycol monopropyl ether, methyl isobutyl carbinol, propylene glycol monobutyl ether, propylene glycol monomethyl ether acetate, propylene glycol monoethyl ether acetate, propylene glycol monopropyl ether acetate, propylene glycol monobutyl ether acetate, toluene, xylene, methyl ethyl ketone, cyclopentanone, cyclohexanone, ethyl 2-hydroxypropionate, ethyl 2-hydroxy-2-methylpropionate, ethoxyethyl acetate, hydroxyethyl acetate, methyl 2-hydroxy-3-methyl butanoate, methyl 3-methoxypropionate, ethyl 3-methoxypropionate, ethyl 3-ethoxypropionate, methyl 3-ethoxypropionate, methyl pyruvate, ethyl pyruvate, ethylene glycol monomethyl ether, ethylene glycol monoethyl ether, ethylene glycol monopropyl ether, ethylene glycol monobutyl ether, ethylene glycol monomethyl ether acetate, ethylene glycol monomethyl ether acetate, ethylene glycol monoethyl ether acetate, ethylene glycol monopropyl ether acetate, ethylene glycol monobutyl ether acetate, diethylene glycol monomethyl ether, diethylene glycol monoethyl ether, diethylene glycol dimethyl ether, diethylene glycol diethyl ether, diethylene glycol dipropyl ether, diethylene glycol dibutyl ether, propylene glycol monomethyl ether, propylene glycol dimethyl ether, propylene glycol diethyl ether, propylene glycol dipropyl ether, propylene glycol dibutyl ether, ethyl lactate, propyl lactate, isopropyl lactate, butyl lactate, isobutyl lactate, methyl formate, ethyl formate, propyl formate, isopropyl formate, butyl formate, isobutyl formate, amyl formate, isoamyl formate, methyl acetate, ethyl acetate, amyl acetate, isoamyl acetate, hexyl acetate, methyl propionate, ethyl propionate, propyl propionate, isopropyl propionate, butyl propionate, isobutyl propionate, methyl butyrate, ethyl butyrate, propyl butyrate, isopropyl butyrate, butyl butyrate, isobutyl butyrate, hydroxyethyl acetate, methyl 2-hydroxy-2-methylpropionate, ethyl 2-hydroxy-2-methylpropionate, methyl 3-methoxy-2-methylpropionate, methyl 2-hydroxy-3-methylbutyrate, ethyl methoxyacetate, ethoxyethyl acetate, methyl 3-methoxypropionate, ethyl 3-ethoxypropionate, ethyl 3-methoxypropionate, 3-methoxybutyl acetate, 3-methoxypropyl acetate, 3-methyl-3-methoxybutyl acetate, 3-methyl-3-methoxybutyl propionate, 3-methyl-3-methoxybutyl butyrate, methyl acetoacetate, toluene, xylene, methyl ethyl ketone, methyl propyl ketone, methyl butyl ketone, 2-heptanone, 3-heptanone, 4-heptanone, cyclohexanone, N,N-dimethylformamide, N-methylacetamide, N,N-dimethylacetamide, N-methylpyrrolidone, 4-methyl-2-pentanol, and γ-butyrolactone. These solvents can be used alone or two or more thereof can be used in combination.

In addition, the composition may contain a combination of a solvent with a boiling point of 160°C or higher and a solvent with a boiling point of lower than 160°C.

As such a high boiling point solvent, for example, the following compounds described in WO2018/131562 (A1) can be preferably used. 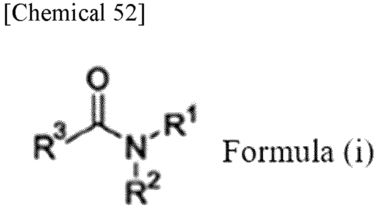 [in Formula (i), R¹, R² and R³ are each a hydrogen atom, an oxygen atom, a sulfur atom or a C₁₋₂₀ alkyl group which may have an intervening amide bond, and may be the same as or different from each other, and may be bonded to each other to form a ring structure].

Alternatively, 1,6-diacetoxyhexane (with a boiling point of 260°C) and tripropylene glycol monomethyl ether (with a boiling point of 242°C) described in JP 2021-84974 A, as well as various high boiling point solvents described in paragraph 0082 of the publication can be preferably used.

Alternatively, dipropylene glycol monomethyl ether acetate (with a boiling point of 213°C), diethylene glycol monoethyl ether acetate (with a boiling point of 217°C), diethylene glycol monobutyl ether acetate (with a boiling point of 247°C), dipropylene glycol dimethyl ether (with a boiling point of 171°C), dipropylene glycol monomethyl ether (with a boiling point of 187°C), dipropylene glycol monobutyl ether (with a boiling point of 231°C), tripropylene glycol monomethyl ether (with a boiling point of 242°C), γ-butyrolactone (with a boiling point of 204°C), benzyl alcohol (with a boiling point of 205°C), propylene carbonate (with a boiling point of 242°C), tetraethylene glycol dimethyl ether (with a boiling point of 275°C), 1,6-diacetoxyhexane (with a boiling point of 260°C), dipropylene glycol (with a boiling point of 230°C), and 1,3-butylene glycol diacetate (with a boiling point of 232°C) described in JP 2019-20701 A, as well as various high boiling point solvents described in paragraphs 0023 to 0031 of the publication can be preferably used.

### <Acid and/or its salts and/or acid generator>

The resist underlayer film-forming composition according to one aspect of the present invention can contain an acid and/or its salts and/or an acid generator.

Examples of acids include p-toluenesulfonic acid, trifluoromethanesulfonic acid, salicylic acid, 5-sulfosalicylic acid, 4-phenolsulfonic acid, camphorsulfonic acid, 4-chlorobenzenesulfonic acid, benzenedisulfonic acid, 1-naphthalenesulfonic acid, citric acid, benzoic acid, hydroxybenzoic acid, and naphthalenecarboxylic acid.

As the salt, salts of the above acids can be used. Although the salt is not limited, ammonia derivative salts such as trimethylamine salts and triethylamine salts, pyridine derivative salts, morpholine derivative salts and the like can be suitably used.

Acids and/or its salts can be used alone or two or more thereof can be used in combination. The amount added with respect to a total solid content is generally 0.0001 to 20 % by mass, preferably 0.0005 to 10 % by mass, and more preferably 0.01 to 5 % by mass.

Examples of acid generators include thermal acid generators and photo acid generators.

Examples of thermal acid generators include 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (commercially available from King Industries, Inc.), SI-45, SI-60, SI-80, SI-100, SI-110, and SI-150 (commercially available from Sanshin Chemical Industry Co., Ltd.), and other organic sulfonic acid alkyl esters.

The photoacid generator generates an acid when the resist is exposed. Therefore, the acidity of the underlayer film can be adjusted. This is a method of adjusting the acidity of the underlayer film to the acidity of the upper layer resist. In addition, when the acidity of the underlayer film is adjusted, it is possible to adjust the pattern shape of the resist formed on the upper layer.

Examples of photoacid generators contained in the resist underlayer film-forming composition of the present invention include onium salt compounds, sulfonimide compounds, and disulfonyldiazomethane compounds.

Examples of onium salt compounds include iodonium salt compounds such as dphenyliodonium hexafluorophosphate, diphenyliodonium trifluoromethanesulfonate, diphenyliodonium nonafluoro-n-butanesulfonate, diphenyliodonium perfluoro-n-octanesulfonate, diphenyliodonium camphorsulfonate, bis(4-tert-butylphenyl)iodonium camphorsulfonate and bis(4-tert-butylphenyl)iodonium trifluoromethanesulfonate, and sulfonium salt compounds such as triphenylsulfonium hexafluoroantimonate, triphenylsulfonium nonafluoro-n-butanesulfonate, triphenylsulfonium camphorsulfonate and triphenylsulfonium trifluoromethanesulfonate.

Examples of sulfonimide compounds include N-(trifluoromethanesulfonyloxy)succinimide, N-(nonafluoro-n-butanesulfonyloxy)succinimide, N-(camphorsulfonyloxy)succinimide and N-(trifluoromethanesulfonyloxy)naphthalimide.

Examples of disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

The acid generators can be used alone or two or more thereof can be used in combination.

When an acid generator is used, the proportion thereof with respect to a solid content of 100 parts by mass of the resist underlayer film-forming composition is 0.01 to 10 parts by mass, 0.1 to 8 parts by mass, or 0.5 to 5 parts by mass.

### <Other optional components>

The resist underlayer film-forming composition according to one aspect of the present invention can contain, as necessary, a crosslinking agent, a surfactant, a light absorbing agent, a rheology controlling agent, an adhesive auxiliary agent and the like in addition to the above components.

### <Crosslinking agent>

Examples of representative crosslinking agents include aminoplast crosslinking agents and phenoplast crosslinking agents.

As the crosslinking agent, a crosslinking agent having high heat resistance can be used. As the crosslinking agent having high heat resistance, a compound containing a crosslink-forming substituent having an aromatic ring (for example, a benzene ring or a naphthalene ring) in the molecule can be preferably used.

Examples of aminoplast crosslinking agents include highly alkylated, alkoxylated, or alkoxyalkylated melamines, benzoguanamines, glycolurils, ureas, and polymers thereof. A crosslinking agent having at least two crosslink-forming substituents is preferable, and is a compound such as methoxymethylated glycoluril, butoxymethylated glycoluril, methoxymethylated melamine, butoxymethylated melamine, methoxymethylated benzoguanamine, butoxymethylated benzoguanamine, methoxymethylated urea, butoxymethylated urea, methoxymethylated thiourea, or methoxymethylated thiourea. In addition, a condensation product of these compounds can also be used.

At least one selected from the group consisting of tetramethoxymethylglycoluril and hexamethoxymethylmelamine is preferable.

Some specific examples are as follows.

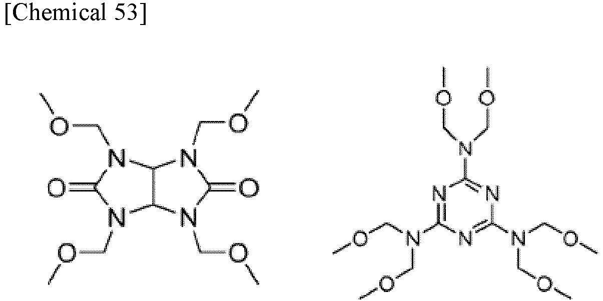

Examples of phenoplast crosslinking agents include highly alkylated, alkoxylated, or alkoxyalkylated aromatics, and polymers thereof. A crosslinking agent having at least two crosslink-forming substituents in one molecule is preferable, and is a compound such as 2,6-dihydroxymethyl-4-methylphenol, 2,4-dihydroxymethyl-6-methylphenol, bis(2-hydroxy-3-hydroxymethyl-5-methylphenyl)methane, bis(4-hydroxy-3-hydroxymethyl-5-methylphenyl)methane, 2,2-bis(4-hydroxy-3,5-dihydroxymethylphenyl)propane, bis(3-formyl-4-hydroxyphenyl)methane, bis(4-hydroxy-2,5-dimethylphenyl)formylmethane, or α,α-bis(4-hydroxy-2,5-dimethylphenyl)-4-formyltoluene. In addition, a condensation product of these compounds can also be used.

In addition to the above examples, examples of such compounds include compounds having a partial structure of the following Formula (11) and polymers or oligomers having a repeating unit of the following Formula (12).

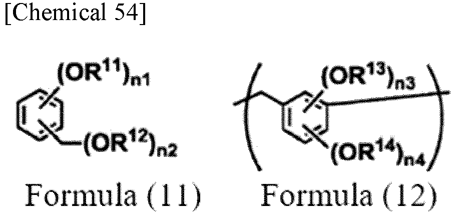

R¹¹, R¹², R¹³, and R¹⁴ are a hydrogen atom or a C₁₋₁₀ alkyl group, and the above examples can be used as these alkyl groups. n1 is an integer of 1 to 4, n2 is an integer of 1 to (5-n1), and (n1+n2) is an integer of 2 to 5. n3 is an integer of 1 to 4, n4 is 0 to (4-n3), and (n3+n4) is an integer of 1 to 4. Oligomers and polymers having a number of repeating unit structures in a range of 2 to 100 or 2 to 50 can be used.

Some specific examples are as follows.

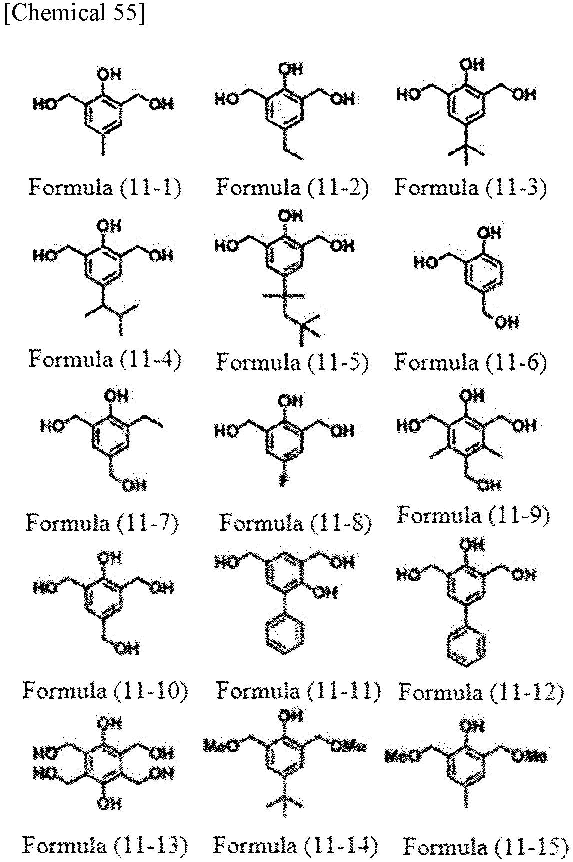

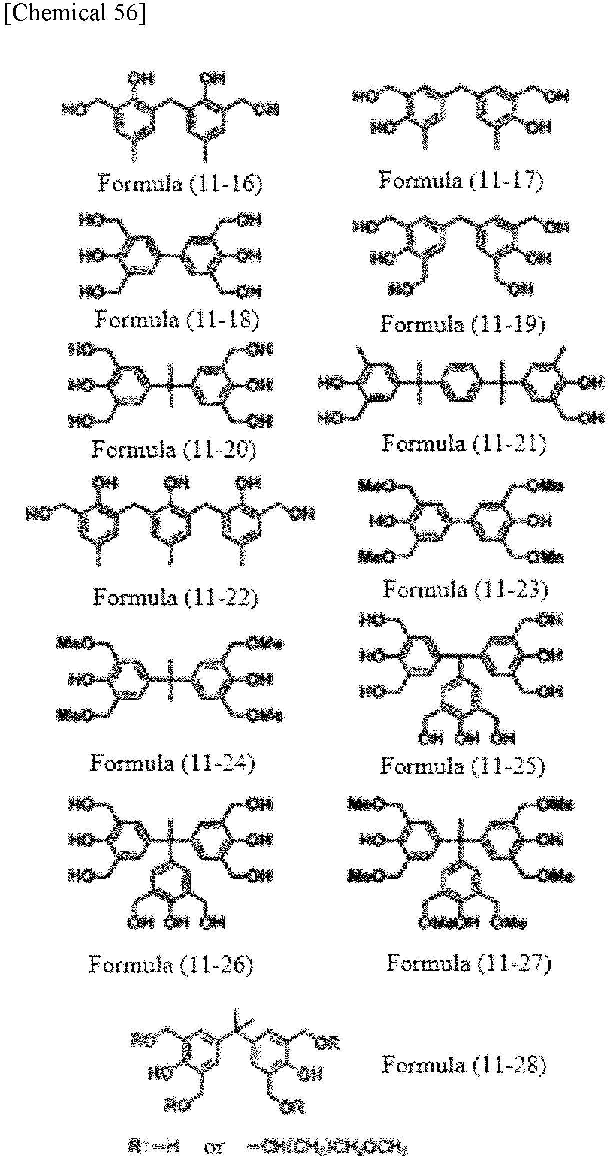

The crosslinking agents such as aminoplast crosslinking agents and phenoplast crosslinking agents may be used alone or two or more thereof may be used in combination. The aminoplast crosslinking agent can be produced by a method known per se or a method similar thereto, or commercially available products may be used.

In addition, the used amount of the crosslinking agent such as an aminoplast crosslinking agent or a phenoplast crosslinking agent varies depending on a coating solvent used, a base substrate used, a required solution viscosity, a required film shape and the like, but is 0.001 % by mass or more, 0.01 % by mass or more, 0.05 % by mass or more, 0.5 % by mass or more, or 1.0 % by mass or more, and 80 % by mass or less, 50 % by mass or less, 40 % by mass or less, 20 % by mass or less, or 10 % by mass or less with respect to a total solid content of the resist underlayer film-forming composition according to the present invention.

### <Surfactant>

In the resist underlayer film-forming composition according to the present invention, in order to prevent pinholes, striations or the like from being generated and further improve applicability against surface unevenness, a surfactant can be added.

Examples of surfactants include nonionic surfactants, for example, polyoxyethylene alkyl ethers such as polyoxyethylene lauryl ether, polyoxyethylene stearyl ether, polyoxyethylene cetyl ether, and polyoxyethylene oleyl ether; polyoxyethylene alkylaryl ethers such as polyoxyethylene octylphenol ether and polyoxyethylene nonylphenol ether; polyoxyethylene-polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate.

Examples further include fluorine-based surfactants such as EFTOP EF301, EF303, and EF352 (product name, commercially available from Tochem Products Co., Ltd.), Megaface F171, F173, R-30, and R-40 (product name, commercially available from Dainippon Ink and Chemicals, Inc.), Fluorad FC430, and FC431 (product name, commercially available from Sumitomo 3M Ltd.), AsahiGuard AG710, Surflon S-382, SC101, SC102, SC103, SC104, SC105, and SC106 (product name, commercially available from Asahi Glass Co., Ltd.), and organosiloxane polymer KP341 (commercially available from Shin-Etsu Chemical Co., Ltd.).

The amount of these surfactants added is generally 2.0 % by mass or less and preferably 1.0 % by mass or less with respect to a total solid content of the resist underlayer film-forming composition according to the present invention. These surfactants may be added alone or two or more thereof may be added in combination.

### <Light absorbing agent>

As the light absorbing agent, for example, commercially available light absorbing agents described in "Kogyoyo Shikiso no Gijutsu to Shijo (Technology and Market of Industrial Colorant)" (CMC Publishing Co., Ltd.) and "Senryo Binran (Dye Book)" (edited by The Society of Synthetic Organic Chemistry, Japan), for example, C. I. Disperse Yellow 1, 3, 4, 5, 7, 8, 13, 23, 31, 49, 50, 51, 54, 60, 64, 66, 68, 79, 82, 88, 90, 93, 102, 114 and 124; C. I. Disperse Orange 1, 5, 13, 25, 29, 30, 31, 44, 57, 72 and 73; C. I. Disperse Red 1, 5, 7, 13, 17, 19, 43, 50, 54, 58, 65, 72, 73, 88, 117, 137, 143, 199 and 210; C. I. Disperse Violet 43; C. I. Disperse Blue 96; C. I. Fluorescent Brightening Agent 112, 135 and 163; C. I. Solvent Orange 2 and 45; C. I. Solvent Red 1, 3, 8, 23, 24, 25, 27 and 49; C. I. Pigment Green 10; C. I. Pigment Brown 2 and the like can be suitably used. The light absorbing agent is added in a proportion of generally 10 % by mass or less and preferably 5 % by mass or less with respect to a total solid content of the resist underlayer film-forming composition according to the present invention.

### <Rheology controlling agent>

The rheology controlling agent is added for the main purpose of improving the fluidity of the resist underlayer film-forming composition; in particular, the purpose of improving the thickness uniformity of a resist underlayer film or improving filling of the interior of a hole with the resist underlayer film-forming composition in a baking process. Specific examples thereof include phthalic acid derivatives such as dimethyl phthalate, diethyl phthalate, diisobutyl phthalate, dihexyl phthalate, and butyl isodecyl phthalate, adipic acid derivatives such as di-n-butyl adipate, diisobutyl adipate, diisooctyl adipate, and octyldecyl adipate, maleic acid derivatives such as di-n-butyl maleate, diethyl malate, and dinonyl maleate, oleic acid derivatives such as methyl oleate, butyl oleate, and tetrahydrofurfuryl oleate, and stearic acid derivatives such as n-butyl stearate and glyceryl stearate. These rheology controlling agents are added in a proportion of generally less than 30 % by mass with respect to a total solid content of the resist underlayer film-forming composition according to the present invention.

### <Adhesive auxiliary agent>

The adhesive auxiliary agent is mainly added in order to improve the adhesion between the substrate or the resist and the resist underlayer film-forming composition, and prevent the resist from peeling off particularly during development. Specific examples thereof include chlorosilanes such as trimethylchlorosilane, dimethylvinylchlorosilane, methyldiphenylchlorosilane, and chloromethyldimethylchlorosilane, alkoxysilanes such as trimethylmethoxysilane, dimethyldiethoxysilane, methyldimethoxysilane, dimethylvinylethoxysilane, diphenyldimethoxysilane, and phenyltriethoxysilane, silazanes such as hexamethyldisilazane, N,N'-bis(trimethylsilyl)urea, dimethyltrimethylsilylamine, and trimethylsilylimidazole, silanes such as vinyltrichlorosilane, γ-chloropropyltrimethoxysilane, γ-aminopropyltriethoxysilane, and γ-glycidoxypropyltrimethoxysilane, heterocyclic compounds such as benzotriazole, benzimidazole, indazole, imidazole, 2-mercaptobenzimidazole, 2-mercaptobenzothiazole, 2-mercaptobenzoxazole, urazole, thiouracil, mercaptoimidazole, and mercaptopyrimidine, and ureas or thiourea compounds such as 1,1-dimethylurea and 1,3-dimethylurea. These adhesive auxiliary agents are added in a proportion of generally less than 5 % by mass and preferably less than 2 % by mass with respect to a total solid content of the resist underlayer film-forming composition according to the present invention.

The solid content of the resist underlayer film-forming composition according to the present invention is 0.1 to 70 % by mass, or 0.1 to 60 % by mass. The solid content is the content of all components excluding the solvent from the resist underlayer film-forming composition. The solid content may contain a crosslinkable resin in a proportion of 1 to 99.9 % by mass, 50 to 99.9 % by mass, 50 to 95 % by mass, or 50 to 90 % by mass.

### <Resist underlayer film>

For example, the resist underlayer film can be formed using the resist underlayer film-forming composition according to the present invention as follows.

A resist underlayer film is formed by applying the resist underlayer film-forming composition according to one aspect of the present invention onto a substrate (for example, a silicon wafer substrate, a silicon dioxide coated substrate (SiOz substrate), a silicon nitride substrate (SiN substrate), a silicon oxynitride substrate (SiON substrate), a titanium nitride substrate (TiN substrate), a tungsten substrate (W substrate), a glass substrate, an ITO substrate, a polyimide substrate, and a low-dielectric-constant material (low-k material)-coated substrate or the like) used in the production of a semiconductor device by an appropriate coating method such as using a spinner or a coater, and then by performing baking using a heating means such as a hot plate. Baking conditions are appropriately selected from among a baking temperature of 80°C to 800°C and a baking time of 0.3 to 60 minutes. Preferably, the baking temperature is 150°C to 400°C, and the baking time is 0.5 to 2 minutes. As the atmospheric gas during baking, air may be used, and an inert gas such as nitrogen or argon can also be used. In one aspect, the oxygen concentration is particularly preferably 1% or less. Here, the film thickness of the underlayer film formed is, for example, 10 to 1,000 nm, 20 to 500 nm, 30 to 400 nm, or 50 to 300 nm. In addition, if a quartz substrate is used as the substrate, a quartz replica mold for imprinting (replica mold) can be produced.

In addition, an adhesion layer and/or a silicon-containing layer which contains 99 % by mass or less or 50 % by mass or less of Si can be formed on the resist underlayer film according to one aspect of the present invention by application or vapor deposition. For example, in addition to a method of applying an adhesion layer described in JP 2013-202982 A or Japanese Patent No. 5827180 or a silicon-containing resist underlayer film (inorganic resist underlayer film)-forming composition described in WO2009/104552 (A1) by spin coating, an Si-based inorganic material film can be formed by a CVD method or the like.

In addition, the resist underlayer film-forming composition according to one aspect of the present invention may be applied onto a semiconductor substrate having a stepped portion and a non-stepped portion (a so-called uneven substrate), followed by baking of the composition, and thus the step between the stepped portion and the non-stepped portion can be reduced.

### <Method of producing semiconductor device>

(i) A method of producing a semiconductor device according to one aspect of the present invention includes a step of forming a resist underlayer film on a semiconductor substrate using the resist underlayer film-forming composition according to one aspect of the present invention, a step of forming a resist film on the resist underlayer film, a step of forming a resist pattern on the resist film by irradiation with light or electron beams and development, a step of etching and patterning the resist underlayer film using the resist pattern, and a step of processing the semiconductor substrate using the patterned resist underlayer film.
(ii) In addition, a method of producing a semiconductor device according to one aspect of the present invention includes a step of forming a resist underlayer film on a semiconductor substrate using the resist underlayer film-forming composition according to one aspect of the present invention, a step of forming a hard mask on the resist underlayer film, a step of additionally forming a resist film on the hard mask, a step of forming a resist pattern on the resist film by irradiation with light or electron beams and development, a step of etching and patterning the hard mask using the resist pattern, a step of etching and patterning the resist underlayer film using the patterned hard mask, and a step of processing the semiconductor substrate using the patterned resist underlayer film.
(iii) In addition, a method of producing a semiconductor device according to one aspect of the present invention includes a step of forming a resist underlayer film on a semiconductor substrate using the resist underlayer film-forming composition according to one aspect of the present invention, a step of forming a hard mask on the resist underlayer film, a step of additionally forming a resist film on the hard mask, a step of forming a resist pattern on the resist film by irradiation with light or electron beams and development, a step of etching and patterning the hard mask using the resist pattern, a step of etching and patterning the resist underlayer film using the patterned hard mask, a step of removing the hard mask, and a step of processing the semiconductor substrate using the patterned resist underlayer film.
(iv) In addition, a method of producing a semiconductor device according to one aspect of the present invention includes a step of forming a resist underlayer film on a semiconductor substrate using the resist underlayer film-forming composition according to one aspect of the present invention, a step of forming a hard mask on the resist underlayer film, a step of additionally forming a resist film on the hard mask, a step of forming a resist pattern on the resist film by irradiation with light or electron beams and development, a step of etching and patterning the hard mask using the resist pattern, a step of etching and patterning the resist underlayer film using the etched hard mask, a step of removing the hard mask, a step of forming a vapor-deposited film (spacer) on the resist underlayer film after the hard mask is removed, a step of processing the vapor-deposited film (spacer) by etching, a step of removing the patterned resist underlayer film such that the patterned vapor-deposited film (spacer) remains, and a step of processing the semiconductor substrate using the patterned vapor-deposited film (spacer). A semiconductor substrate can be processed using any one of the above production methods (i) to (iv).

The step of forming a resist underlayer film using the resist underlayer film-forming composition according to one aspect of the present invention is as described above in the "resist underlayer film" section.

A hard mask such as a silicon-containing film may be formed as a second resist underlayer film on the resist underlayer film formed by the step described above, and a resist pattern may be formed thereon [the above (ii) to (iv)].

The hard mask may be a coating film formed of a composition containing an inorganic substance, or a vapor-deposited film formed of a composition containing an inorganic substance formed by a vapor deposition method such as a CVD or PVD, and examples thereof include an SiON film, an SiN film and an SiO₂ film.

In addition, an anti-reflective coating (BARC) may be formed on the hard mask, or a resist shape correction film without anti-reflective properties may be formed.

In the step of forming the resist pattern, exposure is performed through a mask (reticle) for forming a predetermined pattern or direct writing. As an exposure source, for example, a g-line, i-line, KrF excimer laser, ArF excimer laser, EUV, or electron beams can be used. After exposure, as necessary, post-exposure baking (POST EXPOSURE BAKE) is performed. Then, development is performed using a developing solution (for example, a 2.38 % by mass tetramethylammonium hydroxide aqueous solution), and rinsing with a rinse solution or pure water is additionally performed to remove the used developing solution. Then, post-baking is performed to dry the resist pattern and to improve adhesion to the base.

The etching step performed after the resist pattern is formed is performed by dry etching.

The resist film may be patterned by a nanoimprinting method or a self-assembled film method.

In the nanoimprinting method, a resist composition is formed using a mold (form) that is transparent to emitted light and has a pattern formed thereon. In addition, in the self-assembled film method, a pattern is formed using a self-assembled film that naturally forms a regular structure on the nanometer order such as a diblock polymer (polystyrene-polymethyl methacrylate, etc.).

In the nanoimprinting method, before a curable composition that forms a resist film is applied, a silicon-containing layer (hard mask layer) may be optionally formed on the resist underlayer film by application or vapor deposition, an adhesion layer may be additionally formed on the resist underlayer film or on the silicon-containing layer (hard mask layer) by application or vapor deposition, and the curable composition that forms a resist film may be applied onto the adhesion layer.

Here, the following gases, that is, CF₄, CHF₃, CH₂F₂, CH₃F, C₄F₆, C₄F₈, O₂, N₂O, NO₂, He, and H₂, can be used to process the hard mask (silicon-containing layer), the resist underlayer film and the substrate. These gases may be used alone or a mixture of two or more gases may be used. In addition, these gases that are mixed with argon, nitrogen, carbon dioxide, carbonyl sulfide, sulfur dioxide, neon, or nitrogen trifluoride can be used.

Here, a wet etching treatment may be performed to simplify the process step and reduce damage to the processed substrate. This leads to minimizing fluctuations in processing dimensions and reducing the pattern roughness and makes it possible to process the substrate with a high yield. Therefore, in the above (ii) to (iv), the hard mask can be removed by etching or using an alkaline chemical solution. Particularly, when an alkaline chemical solution is used, there are no restrictions on components, but it is preferable that the alkaline components contain the following examples.

Examples of alkaline components include tetramethylammonium hydroxide, tetraethylammonium hydroxide, tetrapropylammonium hydroxide, tetrabutylammonium hydroxide, methyltripropylammonium hydroxide, methyltributylammonium hydroxide, ethyltrimethylammonium hydroxide, dimethyldiethylammonium hydroxide, benzyltrimethylammonium hydroxide, hexadecyltrimethylammonium hydroxide, (2-hydroxyethyl)trimethylammonium hydroxide, monoethanolamine, diethanolamine, triethanolamine, 2-(2-aminoethoxy)ethanol, N,N-dimethylethanolamine, N,N-diethylethanolamine, N,N-dibutylethanolamine, N-methylethanolamine, N-ethylethanolamine, N-butylethanolamine, N-methyldiethanolamine, monoisopropanolamine, diisopropanolamine, triisopropanolamine, tetrahydrofurfurylamine, N-(2-aminoethyl)piperazine, 1,8-diazabicyclo[5.4.0]undecene-7, 1,4-diazabicyclo[2.2.2]octane, hydroxyethyl piperazine, piperazine, 2-methylpiperazine, trans-2,5-dimethylpiperazine, cis-2,6-dimethylpiperazine, 2-piperidinemethanol, cyclohexylamine, and 1,5-diazabicyclo[4,3,0]nonene-5. In addition, particularly, in consideration of handling, tetramethylammonium hydroxide and tetraethylammonium hydroxide are particularly preferable, and an inorganic base may be used in combination with quaternary ammonium hydroxide. As the inorganic base, alkali metal hydroxides such as potassium hydroxide, sodium hydroxide, and rubidium hydroxide are preferable, and potassium hydroxide is more preferable.

### Examples

Hereinafter, the present invention will be described in more detail with reference to synthesis examples, examples and comparative examples, but the present invention is not limited to the following examples.

### [Synthesis of polymer]

For polymers used for resist underlayer films, the following compound group A, compound group B, compound group C, catalyst group D, solvent group E, and reprecipitation solvent group F were used to synthesize Structural Formulae (S1) to (S9) and synthesize Structural Formulae (S'1) to (S'5) as comparative examples.

### (Compound groups A to C)

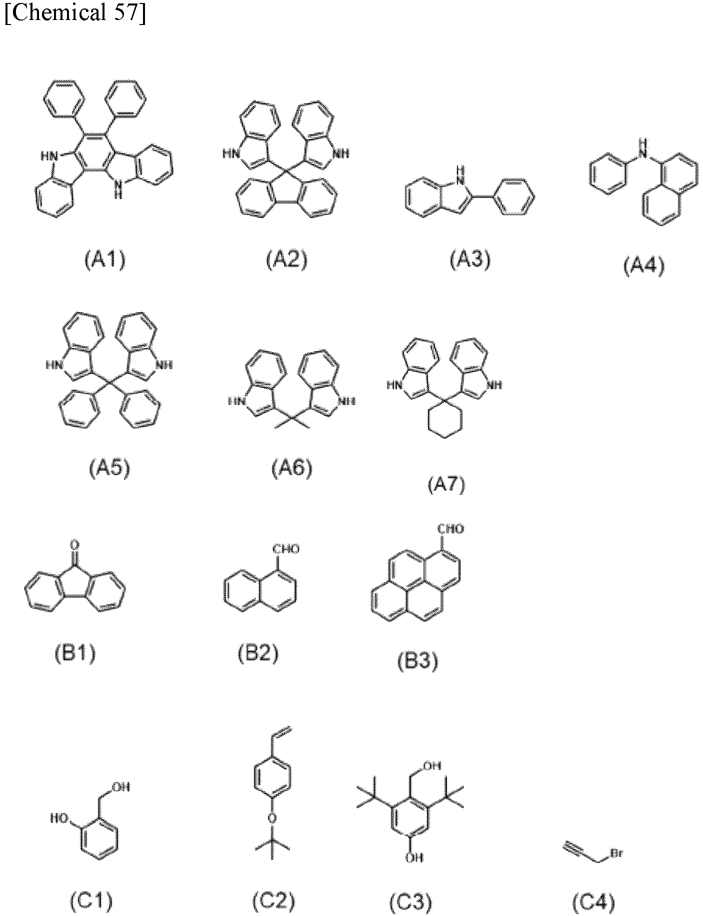

### (Catalyst group D)

methanesulfonic acid: D1
3-mercaptopropionic acid: D2
tetrabutylammonium iodide: D3

### (Solvent group E)

propylene glycol monomethyl ether acetate (=PGMEA): E1
propylene glycol monomethyl ether (=PGME): E2
1,4-dioxane: E3
tetrahydrofuran: E4
sodium hydroxide aqueous solution: E5

### (Reprecipitation solvent group F)

methanol: F1

### (Separation solvent group G)

butyl acetate/water: G1

### Synthesis Example 1

12.0 g of (A1), 5.2 g of (B1), 3.5 g of (C1), 5.5 g of (D1), 0.8 g of (D2), and 40.6 g of (E1) were put into a flask. Then, the mixture was heated to 80°C under nitrogen and reacted for about 5 hours. After the reaction was stopped, the mixture was reprecipitated with (F1) and dried to obtain a resin (S1). The weight average molecular weight Mw measured by GPC in terms of polystyrene was about 2,500. The obtained resin was dissolved in PGMEA, and ion exchange was performed using a cation exchange resin and an anion exchange resin for 4 hours to obtain a desired compound solution.

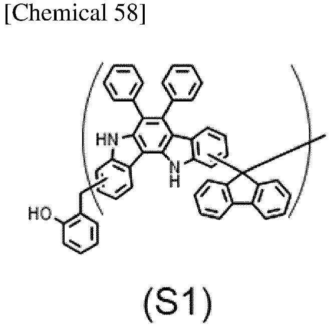

Here, the weight average molecular weight of the polymer was the result measured through gel permeation chromatography (hereinafter abbreviated as GPC). For the measurement, a GPC device (commercially available from Tosoh Corporation) was used, and measurement conditions and the like are as follows.
Device: HLC-8320 GPC (commercially available from Tosoh Corporation)
GPC column: TSKgel Super-MultiporeHZ-N (two columns)
Column temperature: 40°C
Flow rate: 0.35 mL/min
Eluent: THF
Standard sample: polystyrene

### Synthesis Examples 2 to 13

Polymers used for resist underlayer films were synthesized by changing the compound group A, the compound group B, the compound group C, the catalyst group D, the solvent group E, and the reprecipitation solvent group F. Here, an experimental operation was the same as in Synthesis Example 1.

The compounds were combined under the following conditions to obtain Example Polymers (S1) to (S8), Comparative Example Polymers (S'1) to (S'5) and their solutions.

**[Table 1]**

| Synthesis Example | Structural Formula | Compound | Catalyst | Solvent | Temperature/time | Reprecipitation | Molecular weight |
|---|---|---|---|---|---|---|---|
| 1 | S1 | A1/B1/C1 | D1/D2 | E1 | 80C | F1 | 2500 |
| | | 12.0 g/5.2 g/3.5 g | 5.5 g/0.8 g | 40.6 g | 5 hours | | |
| 2 | S2 | A2/B1/C1 | D1/D2 | E1 | 80C | F1 | 2000 |
| | | 18.6 g/8.5 g/2.9 g | 1.4 g/0.2 g | 42.9 g | 4 hours | | |
| 3 | S3 | A2/B2/C1 | D1/D2 | E1 | 80C | F1 | 1700 |
| | | 12.4 g/4.9 g/0.9 g | 1.2 g/0.1 g | 30.9 g | 5 hours | | |
| 4 | S4 | A2/B1/C2 | D1/D2 | E1 | 80C | F1 | 1800 |
| | | 12.2 g/5.5 g/1.1 g | 1.2 g/0.1 g | 31.9 g | 5 hours | | |
| 5 | S5 | A2/A3/B1/C1 | D1/D2 | E1 | 80C | F1 | 2300 |
| | | 18.5 g/9.0 g/16.8 g/5.8 g | 2.7 g/0.7 g | 79.5 g | 4 hours | | |
| 6 | S6 | A2/A3/B1/C1 | D1/D2 | E1 | 80C | F1 | 1900 |
| | | 18.5 g/27.0 g/33.5 g/6.9 g | 5.4 g/0.6 g | 137.8 g | 4 hours | | |
| 7 | S7 | A1/A5/A6/B1/C1 | D1/D2 | E1 | 80C | F1 | 2600 |
| | | 10.0 g/0.5 g/0.7 g/4.4 g/3.0 g | 4.6 g/0.6 g | 27.9 g | 12 hours | | |
| 8 | S8 | A1/A7/B1/C1 | D1/D2 | E1 | 80C | F1 | 3000 |
| | | 10.0 g/0.6 g/4.4 g/3.0 g | 4.6 g/0.6 g | 26.9 g | 12 hours | | |
| 9 | S'1 | A1/B1 | D1/D2 | E1 | 80C | F1 | 2400 |
| | | 14.0 g/6.2 g | 6.6 g/0.7 g | 41.3 g | 3 hours | | |
| 10 | S'2 | A2/B 1 | D1/D2 | E1 | 80C | F1 | 2100 |
| | | 14.2 g/6.5 g | 5.2 g/0.6 g | 47.3 g | 9 hours | | |
| 11 | S'3 | A3/B1/C1 | D1/D2 | E1 | 80C | F1 | 1100 |
| | | 8.0 g/7.3 g/5.0 g | 7.8 g/1.1 g | 43.8 g | 8 hours | | |
| 12 | S'4 | A3/B3/C1 | D1 | E2 | 130C | F1 | 1400 |
| | | 8.0 g/5.7 g/2.1 g | 0.4 g | 30.0 g | 24 hours | | |
| 13 | S'5 | A4/B3/C3 | D1 | E3 | reflux | F1 | 2600 |
| | | 10.0 g/10.5 g/5.4 g | 1.0 g | 40.0 g | 24 hours | | |

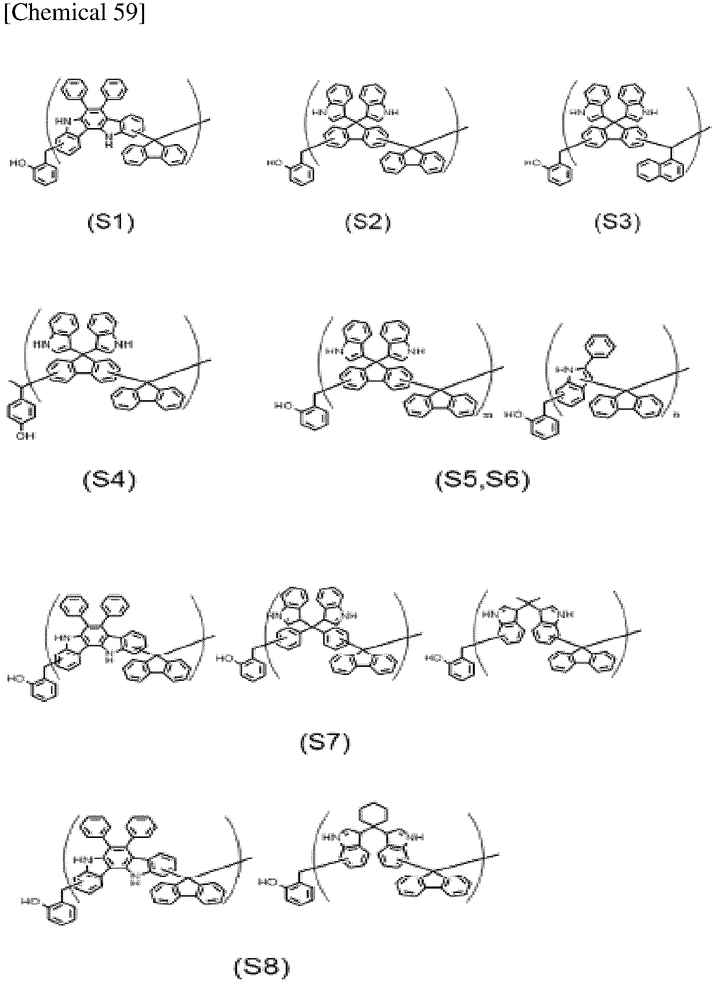

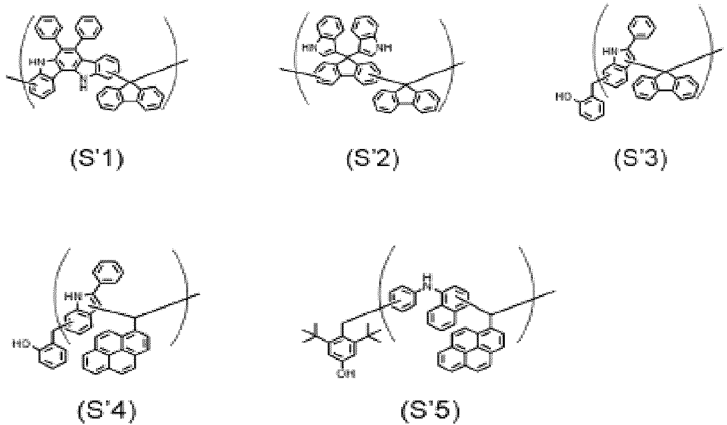

### Synthesis Example 14

10.0 g of the resin (S5) after a reprecipitation treatment obtained in Synthesis Example 5, 10.4 g of (C4), 0.5 g of (D3), 26.4 g of (E3), and 8.8 g of (E4) were put into a flask. Then, the mixture was heated to 55°C under nitrogen and reacted for about 24 hours. After the reaction was stopped, a separation operation with (G1) was repeated, the organic layer was concentrated and re-dissolved in PGMEA, and reprecipitated using (F1) and dried to obtain a resin (S9). The weight average molecular weight Mw measured by GPC in terms of polystyrene was about 2,800. The obtained resin was dissolved in PGMEA, and ion exchange was performed using a cation exchange resin and an anion exchange resin for 4 hours to obtain a desired compound solution.

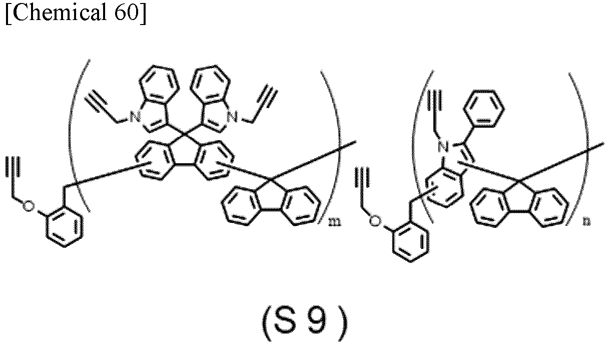

### [Preparation of resist underlayer film]

Polymers (S1) to (S9), and (S'1) to (S'5), a crosslinking agent (CR1), an acid generator (Ad1), solvents (propylene glycol monomethyl ether acetate (PGMEA), propylene glycol monomethyl ether (PGME)), and Megaface R-40 (R-40, commercially available from DIC Corporation) as a surfactant were mixed in the proportions shown in the following table, the mixture was filtered through a 0.1 µm polytetrafluoroethylene microfilter to prepare a resist underlayer film material (Examples M1 to M10 and Comparative Examples M1 to M5).

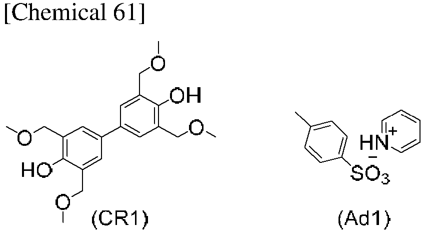

**[Table 2]**

| Composition | Polymer | Crosslinking agent | Acid generator | Surfactant | Solvent (total 100) | |
|---|---|---|---|---|---|---|
| Example | Synthesis Example 1 | - | - | R-40 | PGMEA | PGME |
| M1 | 100 | | | 0.1 | 100 | 0 |
| Example | Synthesis Example 1 | CR1 | Ad1 | R-40 | PGMEA | PGME |
| M2 | 100 | 10 | 1 | 0.1 | 70 | 30 |
| Example | Synthesis Example 2 | - | - | R-40 | PGMEA | PGME |
| M3 | 100 | | | 0.1 | 100 | 0 |
| Example | Synthesis Example 3 | - | - | R-40 | PGMEA | PGME |
| M4 | 100 | | | 0.1 | 100 | 0 |
| Example | Synthesis Example 4 | - | - | R-40 | PGMEA | PGME |
| M5 | 100 | | | 0.1 | 100 | 0 |
| Example | Synthesis Example 5 | - | - | R-40 | PGMEA | PGME |
| M6 | 100 | | | 0.1 | 100 | 0 |
| Example | Synthesis Example 6 | - | - | R-40 | PGMEA | PGME |
| M7 | 100 | | | 0.1 | 100 | 0 |
| Example | Synthesis Example 7 | - | - | R-40 | PGMEA | PGME |
| M8 | 100 | | | 0.1 | 100 | 0 |
| Example | Synthesis Example 8 | - | - | R-40 | PGMEA | PGME |
| M9 | 100 | | | 0.1 | 100 | 0 |
| Example | Synthesis | - | - | R-40 | PGMEA | PGME |
| | Example 14 | | | | | |
| M10 | 100 | | | 0.1 | 100 | 0 |
| Comparative Example | Synthesis Example 9 | - | - | R-40 | PGMEA | PGME |
| M1 | 100 | | | 0.1 | 100 | 0 |
| Comparative Example | Synthesis Example 10 | - | - | R-40 | PGMEA | PGME |
| M2 | 100 | | | 0.1 | 100 | 0 |
| Comparative Example | Synthesis Example 11 | - | - | R-40 | PGMEA | PGME |
| M3 | 100 | | | 0.1 | 70 | 30 |
| Comparative Example | Synthesis Example 12 | - | - | R-40 | PGMEA | PGME |
| M4 | 100 | | | 0.1 | 70 | 30 |
| Comparative Example | Synthesis Example 13 | - | - | R-40 | PGMEA | PGME |
| M5 | 100 | | | 0.1 | 70 | 30 |

### [Test of elution in resist solvent]

The resist underlayer film materials of Examples M1 to M10 and Comparative Examples M1 to M5 each were baked at 400°C for 60 seconds and adjusted to a concentration of about 100 nm. Regarding this film, using ACT-8 (commercially available from Tokyo Electron Ltd.), the resist underlayer film material was applied onto a silicon wafer and baked at a predetermined temperature for a predetermined time shown in the table in air to form a 100 nm resist underlayer film. The formed resist underlayer film was immersed in a general-purpose thinner, PGME/PGMEA=7/3 for 60 seconds, and resistance to the solvent was confirmed. When the rate of reduction in the film thickness before and after immersion in the thinner was 1% or less, it was determined to be ○ (Table 3). Here, since it was difficult to evaluate samples (Comparative Example M1 and Comparative Example M2) that did not exhibit solvent resistance under baking conditions in air as resist underlayer films, the samples were not evaluated in the following tests.

### [Measurement of etching rate]

The etcher and etching gas used in etching rate measurement are as follows.
RIE-200NL (commercially available from SAMCO Inc.): CF₄50 sccm
RIE-200NL (commercially available from SAMCO Inc.): O₂/N₂ 10 sccm/200 sccm

The resist underlayer film materials of Examples M1 to M10 and Comparative Examples M3 to M5 each were baked at 400°C for 60 seconds and adjusted to a concentration of about 100 nm, and applied on a silicon wafer using a spin coater, followed by baking. The dry etching rate was measured using CF₄ gas or O₂/N₂ gas as an etching gas. The dry etching speed ratio was defined as a dry etching speed ratio of (resist underlayer film)/(KrF resist), and a composition with a dry etching speed ratio of less than 0.8 was determined to be ○ (Table 3).

### [Measurement of heat resistance]

The resist underlayer film materials of Examples M1 to M10 and Comparative Examples M3 to M5 each were baked at 400°C for 60 seconds and adjusted to a concentration of about 100 nm, and applied on a silicon wafer using a spin coater, followed by baking. The obtained film was heated from room temperature (about 20°C) at a rate of 10°C per minute and increased the temperature while heating and subjected to thermogravimetric analysis in air, and films with a weight loss of 5% or less at 400°C were determined to be ○ (Table 3).

### [Sublimate measurement]

Resist underlayer film materials of Examples M1 to M10 and Comparative Examples M3 to M5 each were baked at 400°C for 60 seconds and adjusted to a concentration of about 100 nm, and applied onto a silicon wafer using a spin coater. The wafer was set in a sublimate measurement device integrated with a hot plate adjusted to 300°C, baked for 60 seconds and collected and quantified using a sublimate QCM sensor. For the measurement, the hot plate was heated to 300°C, the pump flow rate was set to 0.24 m³/s, the sample was left for the first 60 seconds for aging, immediately after that, the film-coated wafer was quickly placed on the hot plate from the slide opening (the measurement object was installed), and the sublimate was collected from the 60 second point to the 120 second point (for 60 seconds). The QCM sensor using an electrode made of a material of a compound containing silicon and aluminum, having a crystal resonator diameter (sensor diameter) of 14 mm, an electrode diameter on the crystal resonator surface of 5 mm, and a resonance frequency of 9 MHz was used. Compositions with less than 1,500 ng of the sublimate in 60 seconds were determined to be ○ (Table 3).

### [Embedding property test for stepped substrate]

As a coating test for a stepped substrate, it was checked whether the resist underlayer film was filled in an open area (OPEN) in which no pattern was formed and in a 50 nm width trench on an SiO₂ substrate with a film thickness of 100 nm. The resist underlayer film-forming compositions of Examples M1 to M8 and Comparative Examples M3 to M5 each were applied onto the substrate, and then baked at 400°C for 60 seconds to form a resist underlayer film with about 100 nm. The planarization properties of the substrate were observed using a scanning electron microscope (S-4800, commercially available from Hitachi High-Technologies Corporation), and when there were no voids and the film filled the space, the embedding properties were deemed favorable and determined to be O (Table 3).

**[Table 3]**

| Example/Comparative Example | Baking temperature | Solvent resistance | Etching resistance | | Heat resistance | Sublimate | Embedding property |
|---|---|---|---|---|---|---|---|
| | | Air 400C | CF₄ | N₂/O₂ | | | |
| Example M1 | 400°C/60 sec | ○ | ○ | ○ | ○ | ○ | ○ |
| Example M2 | 400°C/60 sec | ○ | ○ | ○ | ○ | ○ | ○ |
| Example M3 | 400°C/60 sec | ○ | ○ | ○ | ○ | ○ | ○ |
| Example M4 | 400°C/60 sec | ○ | ○ | ○ | ○ | ○ | ○ |
| Example M5 | 400°C/60 sec | ○ | ○ | ○ | ○ | ○ | ○ |
| Example M6 | 400°C/60 sec | ○ | ○ | ○ | ○ | ○ | ○ |
| Example M7 | 400°C/60 sec | ○ | ○ | ○ | ○ | ○ | ○ |
| Example M8 | 400°C/60 sec | ○ | ○ | ○ | ○ | ○ | ○ |
| Example M9 | 400°C/60 sec | ○ | ○ | ○ | ○ | ○ | ○ |
| Example M10 | 400°C/60 sec | ○ | ○ | ○ | ○ | ○ | ○ |
| Comparative Example M1 | 400°C/60 sec | × | - | - | - | - | - |
| Comparative Example M2 | 400°C/60 sec | × | - | - | - | - | - |
| Comparative Example M3 | 400°C/60 sec | ○ | × | × | × | × | ○ |
| Comparative Example M4 | 400°C/60 sec | ○ | × | × | × | × | ○ |
| Comparative Example M5 | 400°C/60 sec | ○ | × | × | × | × | ○ |

As above, when the polymer obtained in the present invention is used, the polymer alone not only exhibits sufficient solvent resistance in air but also exhibits sufficient etching resistance against F-based and O-based gases, which are general-purpose etching gases. In addition, since the occurrence of sublimates can be minimized due to high heat resistance, and the self-crosslinking group in the polymer can increase the crosslinking initiation temperature, sufficient reflow properties are obtained and favorable embedding properties are provided for the patterned substrate. From these points, application to a wide range of semiconductor devices can be expected.

### INDUSTRIAL APPLICABILITY

The resist underlayer film material used in the lithography process using the multilayer film of the present invention can provide a resist underlayer film which exhibits excellent etching resistance, has favorable planarization properties and embedding properties with respect to a finely processed substrate, allows excellent resist pattern to be obtained, is also resistant to a solvent even in an atmospheric atmosphere, exhibits sufficient curing properties, and also has the effect of the anti-reflective coating. In addition, it has been found that the underlayer film material of the present invention has heat resistance that allows a hard mask to be formed on the upper layer by vapor deposition.

## Claims

1. A resist underlayer film-forming composition comprising a novolac resin and a solvent,
wherein the novolac resin includes a unit structure A having at least two amino groups, the unit structure A being a divalent group derived from a compound having a fused ring structure, and further includes a monovalent organic group C1 or organic group C2 that caps at least one end of the novolac resin,
the organic group C1 is the following Formula (1): 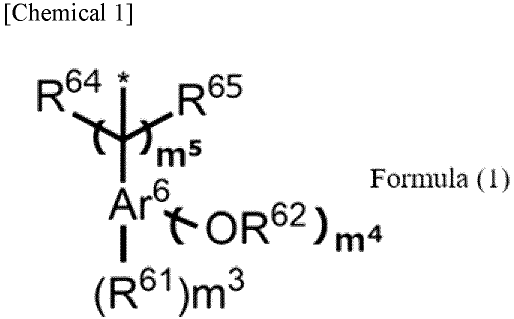 (in Formula (1), * indicates a bond by which the organic group C1 is bonded to at least one end of the novolac resin,
Ar⁶ is a C₆₋₄₀ aryl group, R⁶¹ is a linear, branched, or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they are able to be bonded, Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z, R⁶² is a hydrogen atom, a C₁₋₁₀ alkyl group, a C₂₋₁₀ alkenyl group or a C₂₋₁₀ alkynyl group, R⁶⁴ and R⁶⁵ are each independently a hydrogen atom, a phenyl group substitutable with a hydroxy group, or a naphthyl group substitutable with a hydroxy group, when R⁶⁴ and R⁶⁵ are a phenyl group or a naphthyl group, R⁶⁴ or R⁶⁵ and the aryl group Ar⁶ are able to form a new ring via a single bond or a methylene group,
m⁴ is 0 or 1, m³ is an integer of 0 to (3+2n) when m⁴ is 0, m³ is an integer of 0 to (2+2n) when m⁴ is 1, n is a condensation degree of the benzene ring of the aryl group Ar⁶, and m⁵ is 0 or 1), and
the organic group C2 is the following Formula (2): 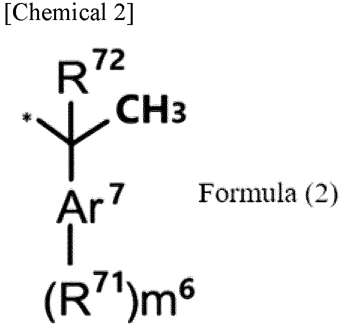 (in Formula (2), * indicates a bond by which the organic group C2 is bonded to at least one end of the novolac resin,
Ar⁷ is a C₆₋₄₀ aryl group, R⁷¹ is a linear, branched, or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they are able to be bonded, Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z, R⁷² is a hydrogen atom, a methyl group, or a phenyl group, m⁶ is an integer of 0 to (3+2n), and n is a condensation degree of an aromatic ring constituting the aryl group Ar⁷).

2. The resist underlayer film-forming composition according to claim 1,
wherein the unit structure A is a unit structure A1 or a unit structure A2, and
the unit structure A1 is the following Formula (3): 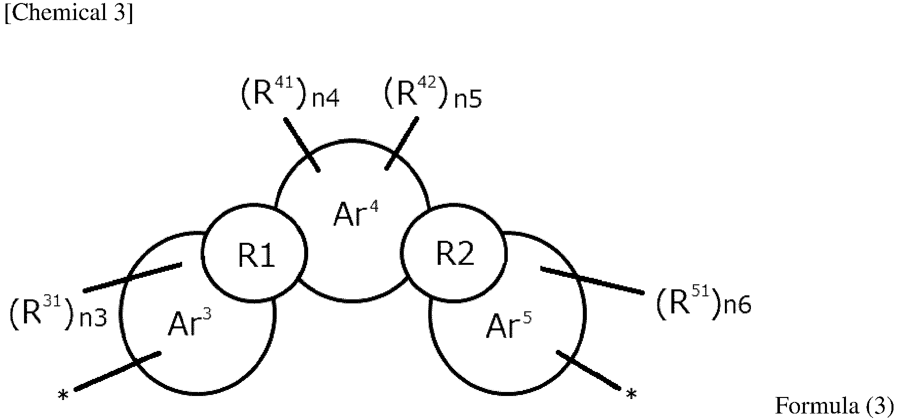
(in Formula (3), * indicates a bond,
Ar⁴ is a benzene ring, Ar³ and Ar⁵ are each independently a benzene ring or a fused ring composed of two or three benzene rings, R1 and R2 are each a 5-membered ring containing one nitrogen atom, Ar³ and R1, R1 and Ar⁴, Ar⁴ and R2, and R2 and Ar⁵ are condensed to each other, and Ar³, R1, Ar⁴, R2 and Ar⁵ form a condensed polycyclic ring together,
R⁴¹ and R⁴² are the same or different substituents on Ar⁴, the substituents are able to be bonded via a single bond or condensed, R³¹ and R⁵¹ are the same or different substituents on Ar³ and Ar⁵, respectively, R³¹, R⁴¹, R⁴² and R⁵¹ are each a linear, branched, or cyclic alkyl group having a carbon atom number of 1 to 10, a C₂₋₁₀ alkenyl group, a C₂₋₁₀ alkynyl group, a C₆₋₄₀ aryl group, a hydroxy group, a cyano group, a nitro group, an amino group, a carboxyl group, an acetyl group, a -Y-Z group, a halogen atom, or a monovalent group formed by bonding them when they are able to be bonded, Y is an amino group, an oxygen atom, a sulfur atom, a carbonyl group, or an ester group, Z is a C₁₋₁₀ alkyl group, a C₂₋₁₀ alkenyl group or a C₂₋₁₀ alkynyl group, provided that, when Y is an amino group, a hydrogen atom of the amino group is substitutable with Z, n3 and n6 are the number of substituents for R³¹ and R⁵¹ and are each independently an integer of 0 to 4, n4 and n5 are the number of substituents for R⁴¹ and R⁴², and are each independently an integer of 0 to 2, and n4+n5 is an integer of 0 to 4), and
the unit structure A2 includes a bis(azaaryl fused ring) structural unit of the following Formula (4) or Formula (4-2): 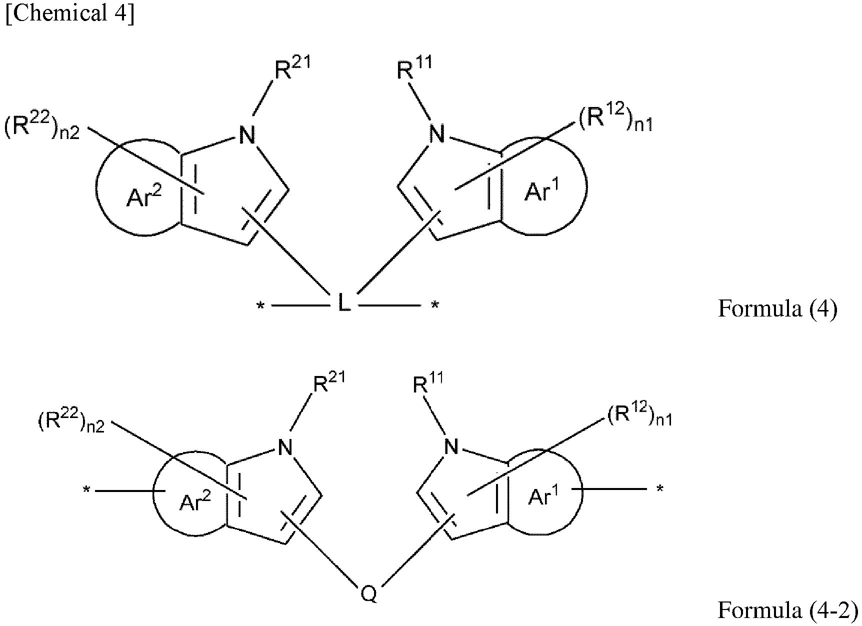 (in Formula (4) and Formula (4-2), * indicates a bond, L is a linking group which bonds to a carbon atom constituting a nitrogen-containing ring of an azaaryl fused ring and additionally bonds to another structure of the novolac resin, and is selected from the group consisting of -(CR⁴R⁵)m¹-, -R⁶-, -(Ar)m²-, -CH₂-(Ar)m²-CH₂- and -(cyclo-R)-, R⁴ and R⁵ are the same as or different from each other, and are each independently a hydrogen atom, a C₁₋₅ hydrocarbon group, or a C₆₋₃₀ aryl group, m¹ is an integer of 1 to 10, R⁶ is a C₃₋₆ cycloalkylene group, Ar is a C₆₋₃₀ arylene group which is arbitrarily bonded to each other via a single bond, m² is an integer of 1 to 3, cyclo-R is a divalent alicyclic hydrocarbon group having a 5- to 8-membered ring which arbitrarily forms a fused ring with one or two benzene rings or naphthalene rings,
Q is a linking group bonded to a carbon atom constituting a nitrogen-containing ring of an azaaryl fused ring, and is selected from the group consisting of -O-, -S-, -SO₂-, -CO-, -CONH-, -COO-, -NH-, -(CR⁴R⁵)m¹-, -R⁶-, -(Ar)m²-, -CH₂-(Ar)m²-CH₂- and -(cyclo-R)-, R⁴ and R⁵ are the same as or different from each other, and are each independently a hydrogen atom, a C₁₋₅ hydrocarbon group, or a C₆₋₃₀ aryl group, m¹ is an integer of 1 to 10, R⁶ is a C₃₋₆ cycloalkylene group, Ar is a C₆₋₃₀ arylene group which is arbitrarily bonded to each other via a single bond, m² is an integer of 1 to 3, and cyclo-R is a divalent alicyclic hydrocarbon group having a 5- to 8-membered ring which arbitrarily forms a fused ring with one or two benzene rings or naphthalene rings,
R¹¹ and R²¹ are the same as or different from each other, and are each independently,
(i) a hydrogen atom or a methylol group,
(ii) a C₆₋₃₀ aryl group, or
(iii) a linear, branched, or cyclic alkoxymethyl group having a carbon atom number of 2 to 20; a linear, branched, or cyclic alkyl group having a carbon atom number of 1 to 20; a C₂₋₁₀ alkenyl group; or a C₂₋₁₀ alkynyl group,
R¹² and R²² are substituents on carbon atoms constituting an azaaryl fused ring, are the same as or different from each other, and are each independently,
(iv) a hydroxy group, a nitro group, a cyano group, a carboxyl group, a trifluoromethyl group, or a halogen atom,
(v) a C₆₋₁₅ aryloxy group, a C₈₋₁₅ arylalkoxycarbonyl group, a C₇₋₁₅ aryloxycarbonyl group, or a C₆₋₃₀ aryl group, or
(vi) a C₁₋₁₅ acyl group, a C₁₋₁₅ alkoxy group, a C₇₋₁₅ arylalkoxy group, a C₁₋₁₅ alkoxycarbonyl group, a linear, branched, or cyclic alkyl group having a carbon atom number of 1 to 10, a C₂₋₂₀ alkenyl group, or a C₂₋₁₀ alkynyl group,
n1 and n2 are the same as or different from each other, and are each independently the number of substituents for R¹² and R²², and are arbitrarily 0, and
Ar¹ and Ar² are the same as or different from each other, and are each independently a benzene ring or a fused ring composed of two or three benzene rings).

3. The resist underlayer film-forming composition according to claim 1,
wherein the organic group C1 of Formula (1) is a monovalent group derived from a hydroxy-containing aromatic methylol compound of the following Formula (5): 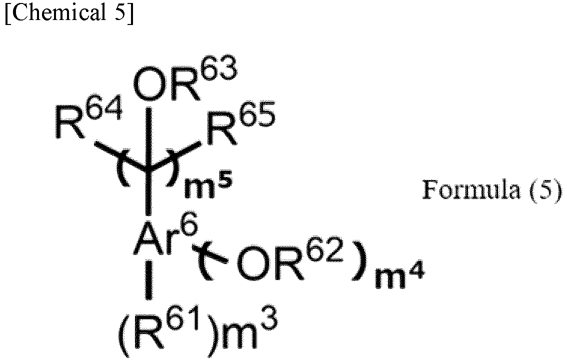 (in Formula (5), Ar⁶, R⁶¹, R⁶², R⁶⁴, R⁶⁵, m³, m⁴ and m⁵ are the same as defined in Formula (1), and R⁶³ is a hydrogen atom or a methyl group).

4. The resist underlayer film-forming composition according to claim 1,
wherein the organic group C1 of Formula (1) is a monovalent group derived from 2-hydroxybenzyl alcohol, 3-hydroxybenzyl alcohol, 4-hydroxybenzyl alcohol, or 2,6-di-tert-butyl-4-hydroxymethylphenol.

5. The resist underlayer film-forming composition according to claim 1,
wherein the organic group C2 of Formula (2) is a monovalent group derived from an aromatic vinyl compound of the following Formula (6): 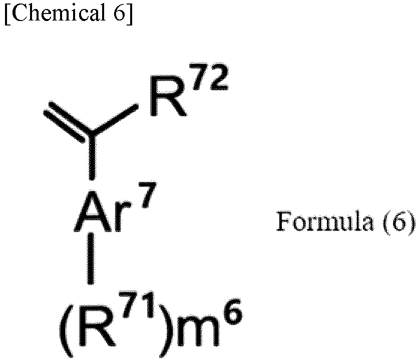 (in Formula (6), Ar⁷, R⁷¹, R⁷² and m⁶ are the same as defined in Formula (2)).

6. The resist underlayer film-forming composition according to claim 1,
wherein the organic group C2 of Formula (2) is a monovalent group derived from styrene, 2-vinylnaphthalene, 4-tert-butylstyrene or 4-tert-butoxystyrene.

7. The resist underlayer film-forming composition according to claim 2,
wherein the unit structure A1 of Formula (3) is a divalent group derived from a compound having an indolocarbazole structure.

8. The resist underlayer film-forming composition according to claim 7,
wherein an aromatic group that substitutes a hydrogen atom on the fused ring of the compound having the indolocarbazole structure is a phenyl group.

9. The resist underlayer film-forming composition according to claim 2,
wherein all or some of hydrogen atoms of the hydroxy group, amino group or alkylamino group in the novolac resin are substituted with a C₂₋₁₀ alkynyl group.

10. The resist underlayer film-forming composition according to claim 2,
wherein the novolac resin further includes another unit structure,
the other unit structure is a divalent group derived from monomers of the following Formula (10-1) to Formula (10-36) and/or a divalent group derived from monomers of the following Formula (10-37) to Formula (10-69), and one end of the unit structure is arbitrarily bonded to a bond of the organic group C1 or the organic group C2: 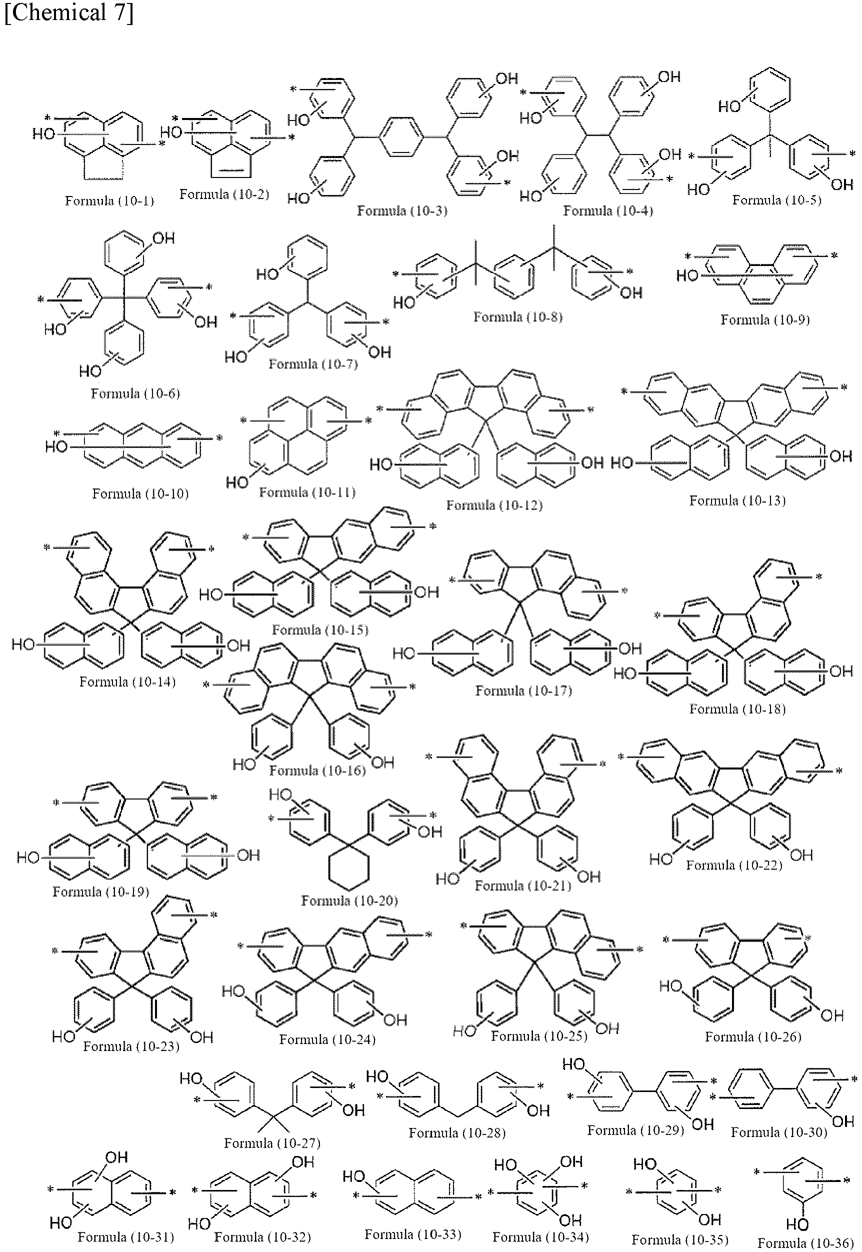
(in Formula (10-1) to Formula (10-36), * indicates a bond, and H of OH is arbitrarily substituted with a phenyl group or a C₂₋₁₀ alkynyl group), 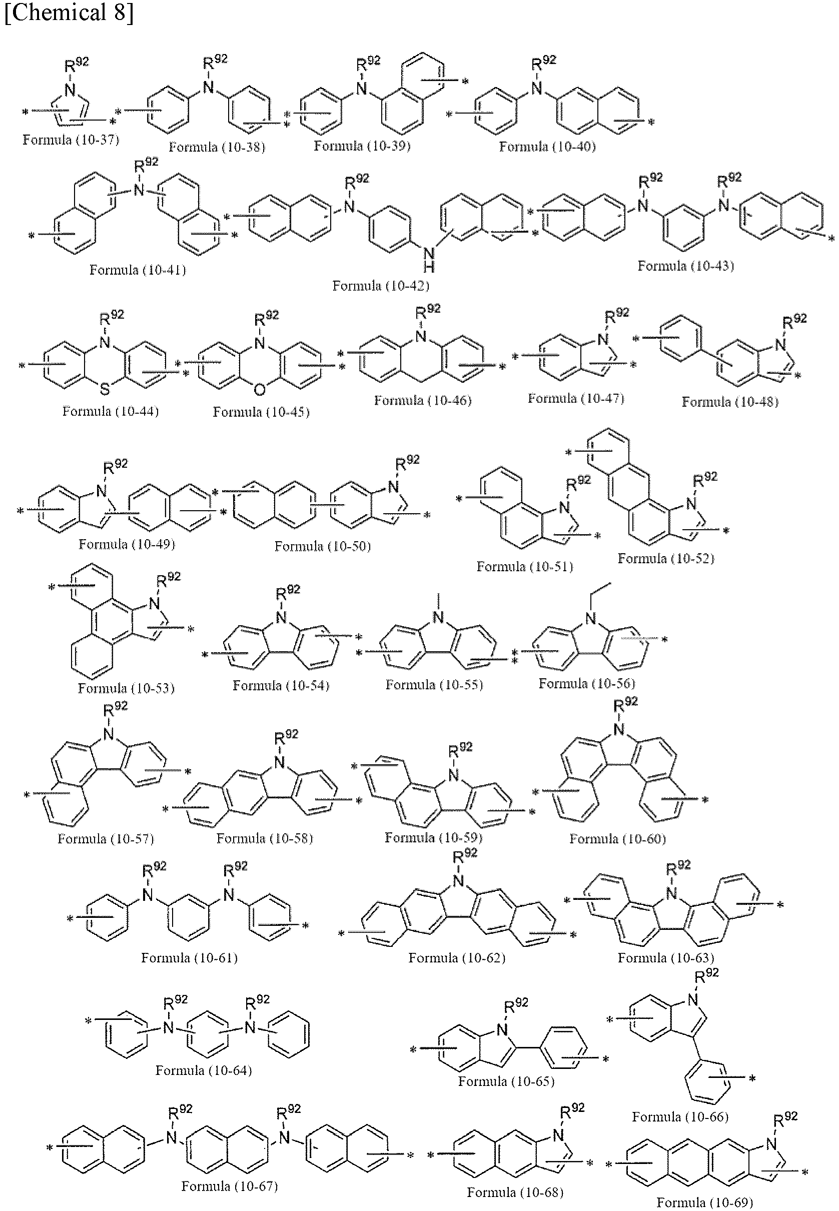 (in Formula (10-37) to Formula (10-69), * indicates a bond, and R⁹² is a hydrogen atom, a phenyl group, or a C₂₋₁₀ alkynyl group).

11. The resist underlayer film-forming composition according to claim 1,
wherein the solvent is a solvent having a boiling point of 160°C or higher.

12. The resist underlayer film-forming composition according to claim 1, further comprising a crosslinking agent.

13. The resist underlayer film-forming composition according to claim 12,
wherein the crosslinking agent is an aminoplast crosslinking agent or a phenoplast crosslinking agent.

14. The resist underlayer film-forming composition according to claim 1, further comprising a surfactant.

15. The resist underlayer film-forming composition according to claim 1, further comprising an acid and/or salts of the acid and/or an acid generator.

16. A resist underlayer film which is a baked product of a coating film formed of the composition according to any one of claims 1 to 15.

17. A method of forming a resist pattern used in production of semiconductors, the method comprising a step of applying the resist underlayer film-forming composition according to any one of claims 1 to 15 onto a semiconductor substrate and performing baking to form a resist underlayer film.

18. A method of producing a semiconductor device, the method comprising:
a step of forming a resist underlayer film on a semiconductor substrate using the resist underlayer film-forming composition according to any one of claims 1 to 15;
a step of forming a resist film on the resist underlayer film;
a step of forming a resist pattern on the resist film;
a step of etching the resist underlayer film using the resist pattern; and
a step of processing the semiconductor substrate using the patterned resist underlayer film.

19. The method of producing a semiconductor device according to claim 18,
wherein the resist pattern is formed on the resist film by irradiation with light or electron beams and development.

20. The method of producing a semiconductor device according to claim 18,
wherein the resist film is patterned by a nanoimprinting method or with a self-assembled film.

21. A method of producing a semiconductor device, the method comprising:
a step of forming a resist underlayer film on a semiconductor substrate using the resist underlayer film-forming composition according to any one of claims 1 to 15;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask; and
a step of processing the semiconductor substrate using the patterned resist underlayer film.

22. The method of producing a semiconductor device according to claim 21,
wherein the hard mask is formed by applying a composition containing an inorganic substance or depositing a composition containing an inorganic substance.

23. The method of producing a semiconductor device according to claim 21,
wherein the resist pattern is formed on the resist film by irradiation with light or electron beams and development.

24. The method of producing a semiconductor device according to claim 21,
wherein the resist film is patterned by a nanoimprinting method or with a self-assembled film.

25. A method of producing a semiconductor device, the method comprising:
a step of forming a resist underlayer film on a semiconductor substrate using the resist underlayer film-forming composition according to any one of claims 1 to 15;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask;
a step of removing the hard mask; and
a step of processing the semiconductor substrate using the patterned resist underlayer film.

26. The method of producing a semiconductor device according to claim 25,
wherein the hard mask is formed by applying a composition containing an inorganic substance or depositing a composition containing an inorganic substance.

27. The method of producing a semiconductor device according to claim 25,
wherein the resist pattern is formed on the resist film by irradiation with light or electron beams and development.

28. The method of producing a semiconductor device according to claim 25,
wherein the resist film is patterned by a nanoimprinting method or with a self-assembled film.

29. The method of producing a semiconductor device according to claim 25,
wherein the hard mask is removed by etching or using an alkaline chemical solution.

30. A method of producing a semiconductor device, the method comprising:
a step of forming a resist underlayer film on a semiconductor substrate using the resist underlayer film-forming composition according to any one of claims 1 to 15;
a step of forming a hard mask on the resist underlayer film;
a step of additionally forming a resist film on the hard mask;
a step of forming a resist pattern on the resist film;
a step of etching the hard mask using the resist pattern;
a step of etching the resist underlayer film using the patterned hard mask;
a step of removing the hard mask;
a step of forming a vapor-deposited film (spacer) on the resist underlayer film after the hard mask is removed;
a step of processing the vapor-deposited film (spacer) by etching;
a step of removing the patterned resist underlayer film such that the patterned vapor-deposited film (spacer) remains; and
a step of processing the semiconductor substrate using the patterned vapor-deposited film (spacer).

31. The method of producing a semiconductor device according to claim 30,
wherein the hard mask is formed by applying a composition containing an inorganic substance or depositing a composition containing an inorganic substance.

32. The method of producing a semiconductor device according to claim 30,
wherein the resist pattern is formed on the resist film by irradiation with light or electron beams and development.

33. The method of producing a semiconductor device according to claim 30,
wherein the resist film is patterned by a nanoimprinting method or with a self-assembled film.

34. The method of producing a semiconductor device according to claim 30,
wherein the hard mask is removed by etching or using an alkaline chemical solution.
